(19) Europäisches Patentamt / European Patent Office / Office européen des brevets

(11) **EP 4 418 330 A1**

(12) **EUROPEAN PATENT APPLICATION**
published in accordance with Art. 153(4) EPC

(43) Date of publication:
**21.08.2024 Bulletin 2024/34**

(21) Application number: **22881043.8**

(22) Date of filing: **12.10.2022**

(51) International Patent Classification (IPC):
*H01L 29/786* (2006.01)     *G02F 1/1368* (2006.01)
*H01L 21/28* (2006.01)     *H01L 21/336* (2006.01)
*H01L 21/363* (2006.01)     *H01L 21/66* (2006.01)
*H01L 29/417* (2006.01)

(52) Cooperative Patent Classification (CPC):
**G02F 1/1368; H01L 21/02107; H01L 21/28;
H01L 22/00; H01L 29/417; H01L 29/66477;
H01L 29/786**

(86) International application number:
**PCT/JP2022/038036**

(87) International publication number:
**WO 2023/063348 (20.04.2023 Gazette 2023/16)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.10.2021   JP 2021169082
29.03.2022   JP 2022053470**

(71) Applicant: **Idemitsu Kosan Co.,Ltd.
Chiyoda-ku
Tokyo 100-8321 (JP)**

(72) Inventors:
• **KAWASHIMA, Emi**
  **Tokyo 1008321 (JP)**
• **TSURUMA, Yuki**
  **Tokyo 1008321 (JP)**
• **SASAKI, Daichi**
  **Tokyo 1008321 (JP)**
• **YAMAGUCHI, Koji**
  **Tokyo 1008321 (JP)**
• **IWASE, Nobuhiro**
  **Tokyo 1008321 (JP)**

(74) Representative: **Gille Hrabal
Partnerschaftsgesellschaft mbB
Patentanwälte
Brucknerstraße 20
40593 Düsseldorf (DE)**

(54) **CRYSTALLINE OXIDE THIN FILM, LAMINATE, AND THIN-FILM TRANSISTOR**

(57)     A crystalline oxide thin film including In as a main component, wherein the crystalline oxide thin film includes a low-resistance region A and a high-resistance region B that have different spread resistance values measured with a scanning spread resistance microscope (SSRM) in a plane direction thereof, and the spread resistance value of the high-resistance region B is 8 times or more as large as the spread resistance value of the low-resistance region A.

Fig. 1

**Description**

Technical Field

The present invention relates to a crystalline oxide thin film, a laminate and a thin film transistor.

Background Art

It is known that a thin film transistor (TFT) using a crystalline oxide thin film as a channel layer obtains a high mobility characteristic (see, for example, Patent Literatures 1 to 7).

In recent years, a TFT tends to be reduced in size, and characteristics in a small TFT have become important. The small TFT here is a TFT having a channel length L of 50 μm or less. In addition, in drive of a high-definition display, there is a demand for a TFT that has a high mobility and is reduced in parasitic capacitance.

Related Art Documents

Patent Documents

[Patent Document 1] JP 5373212 B2
[Patent Document 2] JP 2018-107316 A
[Patent Document 3] JP 6097458 B1
[Patent Document 4] JP 6334598 B2
[Patent Document 5] JP 6289693 B2
[Patent Document 6] WO 2018/043323 A1
Patent Document 7] WO 2020/196716 A1

Summary of the Invention

In order to obtain a TFT that uses an oxide thin film as a channel layer and is reduced in parasitic capacitance, it is conceived that a self-aligned TFT structure is used. Further, in order to obtain a TFT exhibiting a high mobility, it is required that a crystalline oxide material be used for the channel layer instead of an amorphous material. However, when the crystalline oxide thin films of Patent Literatures 1 to 7 are each applied to the self-aligned TFT structure, there has been a problem in that a sufficient energy barrier is not formed owing to the absence of a difference in resistivity between a region (region B) on which a gate electrode is laminated and the other region (region A), and a drain-induced barrier lowering (DIBL) phenomenon in which a Vth is liable to be shifted to a negative value when a high drain voltage Vd is applied to drive the TFT occurs, resulting in unstable TFT characteristics.

In addition, an average spacing (D) between crystal grain boundaries in the region A is not controlled, and hence there has been a problem in that the stability of the mobility and threshold voltage (Vth) of the TFT with respect to a device shape deteriorates. When such TFT is incorporated into a circuit to drive a display, problems, such as brightness unevenness and burn-in, may occur.

One object of the present invention is to provide a crystalline oxide thin film and a laminate in which regions having a sufficiently large difference in resistivity can be formed.

In addition, another object of the present invention is to provide a crystalline oxide thin film and a laminate in which an average spacing between crystal grain boundaries is controlled.

According to the present invention, the following crystalline oxide thin film and the like are provided.

1. A crystalline oxide thin film, comprising In as a main component,

wherein the crystalline oxide thin film comprises a low-resistance region A and a high-resistance region B that have different spread resistance values measured with a scanning spread resistance microscope (SSRM) in a plane direction thereof, and
the spread resistance value of the high-resistance region B is 8 times or more as large as the spread resistance value of the low-resistance region A.

2. The crystalline oxide thin film according to 1, wherein the spread resistance value of the high-resistance region B is 10 times or more as large as the spread resistance value of the low-resistance region A.

3. The crystalline oxide thin film according to 1, wherein the spread resistance value of the high-resistance region B is 15 times or more as large as the spread resistance value of the low-resistance region A.

4. The crystalline oxide thin film according to any one of 1 to 3, wherein the crystalline oxide thin film has a thickness of 80 nm or less.

5. The crystalline oxide thin film according to any one of 1 to 4, wherein in a dC/dV value measured with a scanning capacitance microscope (SCM), a dC/dV value at a boundary between the low-resistance region A and the high-resistance region B is larger than a dC/dV value in the high-resistance region B.

6. The crystalline oxide thin film according to any one of 1 to 5, wherein the crystalline oxide thin film has an average grain boundary angle $\theta$ formed by a lower surface of the thin film and a crystal grain boundary in the thin film of 70° or more and 110° or less, and

an average spacing D between the crystal grain boundaries is 0.01 $\mu$m or more and 2.0 $\mu$m or less.

7. The crystalline oxide thin film according to any one of 1 to 6, wherein the crystalline oxide thin film comprises a crystal grain having a bixbyite structure in electron beam diffraction thereof.

8. The crystalline oxide thin film according to any one of 1 to 7, wherein the crystalline oxide thin film further comprises one or more elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb and Bi.

9. A laminate, comprising the crystalline oxide thin film according to any one of 1 to 8.

10. The laminate according to 9, wherein an average grain boundary angle $\theta_{sub}$ formed by a plane on which the crystalline oxide thin film and a lower layer are in contact with each other, and a crystal grain boundary in the crystalline oxide thin film is 70° or more and 110° or less.

11. The laminate according to 9 or 10, wherein the lower layer is a substrate of a thin film transistor or a constituent layer of the thin film transistor.

12. A thin film transistor, comprising the crystalline oxide thin film according to any one of 1 to 8 or the laminate according to any one of 9 to 11.

13. The thin film transistor according to 12, wherein the thin film transistor comprises

a channel layer,
a source electrode and a drain electrode that are each connected to both end sides of the channel layer, and
a gate electrode laminated on the channel layer via a gate insulating film,
wherein the channel layer is the crystalline oxide thin film, the gate insulating film is formed on the high-resistance region B, and the source electrode and the drain electrode are formed on the low-resistance region A,
a distance $L_{off}$ from an end portion of the source electrode and an end portion of the drain electrode to an intersection between a perpendicular line drawn from an end portion of the gate electrode in a thickness direction and the crystalline oxide thin film is 4 $\mu$m or more and 20 $\mu$m or less, and
an average spacing D between crystal grain boundaries of the crystalline oxide thin film and the distance $L_{off}$ satisfy the following formula (1).

$$2 \leq L_{off}/D \leq 100 \cdots (1)$$

14. The thin film transistor according to 12 or 13, wherein a contact region length Ls of the channel layer with respect to the source electrode and the drain electrode is 4 $\mu$m or more and 20 $\mu$m or less, and

an average spacing D between crystal grain boundaries of the crystalline oxide thin film and the contact region length Ls satisfy the following formula (2).

$$1 \leq Ls/D \leq 100 \cdots (2)$$

15. The thin film transistor according to any one of 12 to 14, wherein a gap $\Delta L$ in a horizontal direction between the low-resistance region A and the gate electrode is less than 1 $\mu$m.

16. A crystalline oxide thin film, comprising In as a main component,

wherein the crystalline oxide thin film has a thickness of 80 nm or less,
the crystalline oxide thin film comprises a high-carrier concentration region A and a low-carrier concentration region B that have different carrier concentrations in a plane direction thereof,
the carrier concentration of the high-carrier concentration region A is $10^{19}$ cm$^{-3}$ or more and $10^{22}$ cm$^{-3}$ or less, and
the carrier concentration of the high-carrier concentration region A is 8 times or more as high as the carrier concentration of the low-carrier concentration region B.

17. The crystalline oxide thin film according to 16, wherein the carrier concentration of the high-carrier concentration region A is 10 times or more as high as the carrier concentration of the low-carrier concentration region B.

18. The crystalline oxide thin film according to 16, wherein the carrier concentration of the high-carrier concentration region A is 15 times or more as high as the carrier concentration of the low-carrier concentration region B.

19. The crystalline oxide thin film according to any one of 16 to 18, wherein the carrier concentration of the low-carrier concentration region B is $10^{15}$ cm$^{-3}$ or more and less than $10^{19}$ cm$^{-3}$.

20. The crystalline oxide thin film according to any one of 16 to 19, wherein the crystalline oxide thin film has an average grain boundary angle $\theta$ formed by a lower surface of the thin film and a crystal grain boundary in the thin film of 70° or more and 110° or less, and

an average spacing D between the crystal grain boundaries is 0.01 $\mu$m or more and 2.0 $\mu$m or less.

21. The crystalline oxide thin film according to any one of 16 to 20, wherein the crystalline oxide thin film comprises a crystal grain having a bixbyite structure in electron beam diffraction thereof.

22. The crystalline oxide thin film according to any one of 16 to 21, wherein the crystalline oxide thin film further comprises one or more elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb and Bi.

23. A laminate, comprising the crystalline oxide thin film according to any one of 16 to 22.

24. The laminate according to 23, wherein an average grain boundary angle $\theta_{sub}$ formed by a plane on which the crystalline oxide thin film and a lower layer are in contact with each other, and the crystal grain boundary in the crystalline oxide thin film is 70° or more and 110° or less.

25. The laminate according to 23 or 24, wherein the lower layer is a substrate of a thin film transistor or a constituent layer of the thin film transistor.

26. A thin film transistor, comprising the crystalline oxide thin film according to any one of 16 to 22 or the laminate according to 23 to 25.

27. The thin film transistor according to 26, wherein the thin film transistor comprises a channel layer,

a source electrode and a drain electrode that are each connected to both end sides of the channel layer, and a gate electrode laminated on the channel layer via a gate insulating film,

the channel layer is the crystalline oxide thin film, the gate insulating film is formed on the low-carrier concentration region B, and the source electrode and the drain electrode are formed on the high-carrier concentration region A, a distance $L_{off}$ from an end portion of the source electrode and an end portion of the drain electrode to an intersection between a perpendicular line drawn from an end portion of the gate electrode in a thickness direction and the crystalline oxide thin film is 4 $\mu$m or more and 20 $\mu$m or less, and

an average spacing D between crystal grain boundaries of the crystalline oxide thin film and the distance $L_{off}$ satisfy the following formula (1).

$$2 \leq L_{off}/D \leq 100 \ \cdots \ (1)$$

28. The thin film transistor according to 26 or 27, wherein a contact region length Ls of the channel layer with respect to the source electrode and the drain electrode is 4 $\mu$m or more and 20 $\mu$m or less, and

an average spacing D between crystal grain boundaries of the crystalline oxide thin film and the contact region length Ls satisfy the following formula (2).

$$1 \leq Ls/D \leq 100 \ \cdots \ (2)$$

29. The thin film transistor according to any one of 26 to 28, wherein a gap $\Delta L$ in a horizontal direction between the high-carrier concentration region A and the gate electrode is less than 1 $\mu$m.

30. A crystalline oxide thin film, comprising In as a main component,

wherein the crystalline oxide thin film has a thickness of 80 nm or less,

an average spacing D between crystal grain boundaries of the crystalline oxide thin film is 2 $\mu$m or less, and

the crystalline oxide thin film has a carrier concentration of $10^{19}$ cm$^{-3}$ or more and $10^{22}$ cm$^{-3}$ or less.

31. A thin film transistor, comprising the crystalline oxide thin film according to 30.

32. An electronic circuit, comprising the thin film transistor according to any one of 12 to 15, 26 to 29, and 31.

33. An electric device, an electronic device, a vehicle, or a power engine, comprising the electronic circuit according to 32.

According to the present invention, the crystalline oxide thin film and the laminate in which regions having a sufficiently large difference in resistivity can be formed can be provided. In addition, according to the present invention, the crystalline oxide thin film and the laminate in which an average spacing between crystal grain boundaries is controlled can be provided.

Thus, there can be provided a self-aligned TFT, which does not cause the DIBL phenomenon, holds a high mobility, and has high stability of the mobility and Vth thereof with respect to the device shape.

Brief Description of the Drawings

Fig. 1 is a schematic sectional view of an example of a laminate of an embodiment of the present invention.
Fig. 2 is a schematic sectional view of another example of the laminate of this embodiment.
Fig. 3A is a schematic sectional view of an example of a TFT of an embodiment of the present invention.
Fig. 3B is an enlarged view of the vicinity of a source electrode of Fig. 3A.
Fig. 4 is a schematic sectional view of another example of the TFT of this embodiment.
Fig. 5 is a schematic sectional view of another example of the TFT of this embodiment.
Fig. 6 is a schematic sectional view of another example of the TFT of this embodiment.
Fig. 7 is a schematic sectional view of another example of the TFT of this embodiment.
Fig. 8A is an example of a circuit diagram of a pixel portion when a liquid crystal device is applied.
Fig. 8B is an example of a circuit diagram of the pixel portion when an organic EL device is applied.
Fig. 8C is a top view of a display apparatus according to an embodiment of the present invention.
Fig. 9 is a schematic sectional view of a TFT produced in Example.
Fig. 10 shows CL spectra measured in Example 217 and Comparative Example 20.

Mode for Carrying out the Invention

The ordinal numbers "first", "second", and "third" as used herein are attached for avoiding confusion between constituents. Constituents without descriptions for numerical specification are not numerically limited.

As used herein, the term "film" or "thin film" and the term "layer" are sometimes interchangeable with each other.

In a sintered body and an oxide thin film as used herein, the term "compound" and the term "crystal phase" are sometimes interchangeable with each other.

As used herein, the term "oxide sintered body" is sometimes simply referred to as "sintered body".

As used herein, the term "sputtering target" is sometimes simply referred to as "target".

As used herein, the term "electrically connected" encompasses connection via an "object of some electric action". The "object of some electric action" is not particularly limited as long as the object allows communication of electric signals between connected components. Examples of the "object of some electric action" include an electrode, a line, a switching device (e.g., a transistor), a resistor, an inductor, a capacitor, and other devices having various functions.

As used herein, the functions of the source and drain of a transistor may be interchanged when, for example, a transistor of different polarity is adopted or the direction of a current is changed during the operation of a circuit. Accordingly, the terms "source" and "drain" as used herein may be interchangeably used.

As used herein, the term "x to y" refers to a numerical range of "x or more and y or less". An upper limit value and a lower limit value described regarding the numerical range may be arbitrarily combined.

In addition, the present invention also encompasses modes obtained by combining two or more individual modes of the present invention described below.

1. Crystalline Oxide Thin Film

(1) First Embodiment of Crystalline Oxide Thin Film

A crystalline oxide thin film according to this embodiment is a crystalline oxide thin film including In as a main component. In addition, the crystalline oxide thin film includes a low-resistance region A and a high-resistance region B that have different spread resistance values measured with a scanning spread resistance microscope (SSRM) in a plane direction of the crystalline oxide thin film, and the spread resistance value of the high-resistance region B is 8 times or more as large as the spread resistance value of the low-resistance region A.

The crystalline oxide thin film according to this embodiment includes an In element as a main component. The phrase "include an In element as a main component" means that the composition ratio (atomic%: at%) of In is 50 at% or more with respect to all metal elements in the crystalline oxide thin film. The composition ratio of In is preferably 70 at% or more, more preferably 80 at% or more, still more preferably 85 at% or more. When the In element accounts for 50 at% or more of the total number of atoms of metal elements for forming the crystalline oxide thin film, a sufficiently high mobility can be exhibited when the crystalline oxide thin film according to this embodiment is adopted in a TFT.

The crystalline oxide thin film may include, in addition to In, one or more elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb and Bi.

In this embodiment, the crystalline oxide thin film may consist essentially of elements selected from In, Mg, Al, Si, Zn, Ga, Mo, Sn, lanthanoid elements (Ln elements), and O. As used herein, the term "essentially" means that the crystalline oxide thin film according to this embodiment may include any other component to the extent that the effects of the present invention attributed to the combination of In, Mg, Al, Si, Zn, Ga, Mo, Sn, Ln, and O described above are exhibited.

In the crystalline oxide thin film according to a more preferred first mode of this embodiment, the metal elements consist of In and Ga, and the atomic ratios satisfy the following formula (11).

$$[Ga]/([In]+[Ga]) < 22 \text{ at\%} \qquad (11)$$

The crystalline oxide thin film may include inevitable impurities as the metal elements, and further F or H in addition to O. When the above-mentioned composition range is satisfied, the In ratio is increased, and crystallization to a bixbyite structure in which an In site is substituted by Ga can be achieved even by annealing at a low temperature such as 300°C. Further, when Ga having a strong bonding force with oxygen is added, oxygen deficiency after annealing is suppressed, and a film that is stable as a semiconductor can be formed.

The crystalline oxide thin film according to a more preferred second mode of this embodiment consists of In and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb, and Lu as the metal elements, and when a metal element except In is represented by X, the atomic ratios satisfy the following formula (12).

$$[X]/([In]+[X]) < 15 \text{ at\%} \qquad (12)$$

The crystalline oxide thin film may include inevitable impurities as the metal elements, and further F or H in addition to O. When the above-mentioned composition range is satisfied, the In ratio is increased, and crystallization to a bixbyite structure in which an In site is substituted by X can be achieved even by annealing at a low temperature such as 300°C. Further, when the element X having a strong bonding force with oxygen is added, oxygen deficiency after annealing is suppressed, and a film that is stable as a semiconductor can be formed.

The crystalline oxide thin film according to a more preferred third mode of this embodiment consists of In, Ga, and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb, and Lu as the metal elements, and when the metal element except In and Ga is defined as an additive element X, the atomic ratios satisfy the following formulas (13) and (14).

$$[Ga]/([In]+[Ga]+[X]) < 22.5 \text{ at\%} \qquad (13)$$

$$[X]/([In]+[Ga]+[X]) < 8.0 \text{ at\%} \qquad (14)$$

The crystalline oxide thin film may include inevitable impurities as the metal elements, and further F or H in addition to O.

When the above-mentioned composition range is satisfied, the In ratio is increased, and crystallization to a bixbyite structure in which an In site is substituted by Ga can be achieved even by annealing at a low temperature such as 300°C. In addition, when the additive element X having a strong bonding force with oxygen is added, oxygen deficiency after annealing is further suppressed, and a film that is stable as a semiconductor can be formed.

The crystalline oxide thin film according to a more preferred fourth mode of this embodiment consists of In, Sn, and one or more elements X selected from B, Al, Sc, Mg, Zn, Ti, Y, Zr, Mo, Hf, W, Nb, Ta, Ge, Si, La, Ce, Pr, Nd, Sm, Dy, Ho, Er, Tm, Yb, and Lu as the metal elements, and when the metal element except In and Sn is defined as an element X, the atomic ratios satisfy the following formulas (15) and (16).

$$[Sn]/([In]+[Sn]+[X]) < 20 \text{ at%} \quad (15)$$

$$[X]/([In]+[Sn]+[X]) < 8.0 \text{ at%} \quad (16)$$

The crystalline oxide thin film may include inevitable impurities as the metal elements, and further F or H in addition to O.

When the composition range as described above is satisfied, the In ratio is increased, and crystallization to a bixbyite structure in which an In site is substituted by Sn can be achieved even by annealing at a low temperature such as 300°C. Sn has a large ion radius and a large orbital overlap with In, and hence a high mobility can be held. In addition, when the additive element X having a strong bonding force with oxygen is added, oxygen deficiency after annealing is further suppressed, and a film that is stable as a semiconductor can be formed.

The crystalline oxide thin film according to a more preferred fifth mode of this embodiment consists of In, Zn, and one or more elements X selected from B, Al, Sc, Mg, Ti, Y, Zr, Mo, Hf, W, Nb, Ta, Ge, Si, La, Ce, Pr, Nd, Sm, Dy, Ho, Er, Tm, Yb, and Lu as the metal elements, and when the metal element except In and Zn is defined as an element X, the atomic ratios satisfy the following formulas (17) and (18).

$$[Zn]/([In]+[Zn]+[X]) < 12 \text{ at%} \quad (17)$$

$$[X]/([In]+[Zn]+[X]) < 8.0 \text{ at%} \quad (18)$$

The crystalline oxide thin film may include inevitable impurities as the metal elements, and further F or H in addition to O.

When the above-mentioned composition range is satisfied, the In ratio is increased, and crystallization to a bixbyite structure in which an In site is substituted by Zn can be achieved even by annealing at a low temperature such as 300°C. When Zn is added, the film immediately after film formation can be brought into an amorphous state, and the film can be processed without any residue at the time of semiconductor patterning with an acid during the production of a TFT. Further, when the additive element X having a strong bonding force with oxygen is added, oxygen deficiency after annealing is suppressed, and a film that is stable as a semiconductor can be formed.

The amount (atomic ratio) of each metal element in the crystalline oxide thin film may be determined by measuring the abundance of each element by inductively coupled plasma (ICP) measurement or X-ray fluorescence (XRF) measurement. An inductively coupled plasma optical emission spectrometer (ICP-OES manufactured by Agilent) may be used for the ICP measurement. A thin film X-ray fluorescence analyzer (AZX400 manufactured by Rigaku Corporation) may be used for the XRF measurement.

In addition, the amount (atomic ratio) of each metal element in the crystalline oxide thin film may be analyzed with an error accuracy of 2 atomic% or less by TEM-EDS measurement using an electron microscope, ICP measurement using an inductively coupled plasma optical emission spectrometer, and SIMS analysis using a sector-type dynamic secondary ion mass spectrometer. First, the cross-sectional TEM-EDS is used to identify the metal elements in the crystalline oxide thin film, and semi-quantitative analysis is used to identify composition ratios within an error range of about 10 atomic%. Next, standard oxide thin films having 10 kinds of composition ratios known for atomic ratios of metal elements in the range of 20 atomic% from the semi-quantitative analysis results are produced. For the standard oxide thin films, a value measured with an inductively coupled plasma optical emission spectrometer or a thin film X-ray fluorescence analyzer is used as an absolute value of the composition ratio. Further, source and drain electrodes formed by using the same material and the same channel length as those of the TFT device are produced on the upper surface of the standard oxide thin film, and are used as a standard material for analysis of an oxide semiconductor layer with a sector-type dynamic secondary ion mass spectrometer SIMS (IMS 7f-Auto manufactured by AMETEK). Thus, the mass spectral intensity of each element is obtained, and a calibration curve of a known element concentration and the mass spectral intensity is created. Next, the atomic ratios of the oxide thin film portion of an actual TFT device removed from a panel are calculated from the spectral intensity by the SIMS analysis with the sector-type dynamic secondary ion mass spectrometer through use of the above-mentioned calibration curve. The calculated atomic ratios may be separately confirmed with an accuracy of 2 atomic% or less of the atomic ratios of the oxide thin film measured with the thin film X-ray fluorescence analyzer or the inductively coupled plasma optical emission spectrometer.

The crystalline oxide thin film according to this embodiment includes the low-resistance region A and the high-resistance region B that have different spread resistance values measured with the scanning spread resistance microscope (SSRM) in the plane direction of the crystalline oxide thin film, and a ratio ($R_B/R_A$) of the spread resistance value $R_B$ of the high-resistance region B to the spread resistance value $R_A$ of the low-resistance region A is 8 times or more. The $R_B/R_A$ is preferably 10 times or more, more preferably 15 times or more. When the $R_B/R_A$ is increased, a sufficient energy barrier is formed between the low-resistance region A and the high-resistance region B. Thus, when the crystalline oxide thin film is used as the channel layer of the TFT, the DIBL phenomenon can be suppressed, resulting in stable TFT characteristics. Although the upper limit of the $R_B/R_A$ is not particularly limited, the upper limit is, for example, 100,000 times or less, and may be 10,000 times or less. When the $R_B/R_A$ is too large, the energy barrier between the low-resistance region A and the high-resistance region B is too large, and thus becomes an electron injection barrier when a voltage Vd is applied between a source electrode and a drain electrode, with the result that the mobility of the TFT is reduced.

The terms "high" and "low" of "resistance" mean the relative levels of the spread resistance values of the region A and the region B.

The spread resistance value $R_A$ of the low-resistance region A is preferably 1 $\Omega$ or more and $1 \times 10^6$ $\Omega$ or less.

The low-resistance region A may be formed, for example, by causing a target portion of the crystalline oxide thin film to have low resistance by a method involving heat treatment (annealing), plasma treatment, or ion implantation in the presence of indium tin oxide (ITO), indium zinc oxide (IZO), aluminum, or the like. A region that is not subjected to the low-resistance treatment becomes the high-resistance region B.

In one embodiment, the thickness of the crystalline oxide thin film is preferably 80 nm or less. When the thickness is 80 nm or less, there are tendencies that: the effect of the low-resistance treatment is easily expressed; and the crystal of the crystalline oxide thin film easily becomes a columnar single-layer crystal. The thickness of the crystalline oxide thin film is preferably 60 nm or less, more preferably 50 nm or less, particularly preferably 40 nm or less. Meanwhile, the thickness of the crystalline oxide thin film is, for example, 3 nm or more, and may be 5 nm or more, or may be 10 nm or more. When the thickness of the crystalline oxide thin film is set to 3 nm or more, a high-quality crystal can be grown without being influenced by an underlying portion at the time of the crystallization by the annealing.

As used herein, the thickness is measured based on a cross-sectional TEM observation image (sometimes referred to as "cross-sectional TEM image").

In one embodiment, in a dC/dV value measured with a scanning capacitance microscope (SCM), a dC/dV value at a boundary between the low-resistance region A and the high-resistance region B is larger than a dC/dV value in the high-resistance region B. With this configuration, the carrier concentration is continuously changed at the boundary between the low-resistance region A and the high-resistance region B. Thus, there is no electrical potential barrier between the source and the drain at the time of the drive of the TFT (here, Vg>0 is set so that a state in which electrons are accumulated at the interface between the gate insulating film and the channel layer is established), and a high mobility characteristic can be obtained.

SCM measurement conditions are described in detail in Examples.

In one embodiment, the crystalline oxide thin film preferably has an average grain boundary angle $\theta$ formed by a lower surface of the thin film and a crystal grain boundary in the thin film of 70° or more and 110° or less. With this configuration, even in a small TFT having a short contact region length with respect to an electrode, the crystal grain boundaries are not excessively inclined with respect to an electrode surface, and the crystal grain boundaries are allowed to be densely present in the length direction of the contact region length. As a result, the TFT including the crystalline oxide thin film according to this embodiment exhibits a more satisfactory mobility.

The average grain boundary angle $\theta$ formed by the surface of the thin film and the crystal grain boundary in the thin film is measured based on a cross-sectional TEM observation image (sometimes referred to as "cross-sectional TEM image"). That is, the average grain boundary angle $\theta$ is calculated by analyzing the angle formed by the crystal grain boundary and the surface of the thin film observed in cross-sectional TEM observed under magnification through use of a transmission electron microscope.

In one embodiment, an average spacing D between crystal grain boundaries in the crystalline oxide thin film is preferably 0.01 $\mu$m or more and 2.0 $\mu$m or less. With this configuration, a small TFT including the crystalline oxide thin film according to this embodiment exhibits a high mobility, and provides uniform characteristics of the mobility and threshold voltage (Vth) thereof with respect to a device shape. As a result, when a display in which the TFT is incorporated into a circuit is driven, a high-definition display without brightness unevenness and an afterimage can be achieved.

The average spacing D between the crystal grain boundaries in the thin film is measured based on a cross-sectional TEM observation image. Measurement conditions are described in detail in Examples.

In one embodiment, the crystalline oxide thin film contains a crystal grain having a bixbyite structure in its electron beam diffraction. The crystal grain having a bixbyite structure has a cubic crystal shape with satisfactory symmetry, and hence a reduction in TFT characteristic (mobility) can be suppressed even across the crystal grain boundaries.

(2) Second Embodiment of Crystalline Oxide Thin Film

A crystalline oxide thin film of this embodiment is a crystalline oxide thin film including In as a main component, and has a thickness of 80 nm or less. In addition, the crystalline oxide thin film includes a high-carrier concentration region A and a low-carrier concentration region B that have different carrier concentrations in a plane direction of the crystalline oxide thin film. The carrier concentration of the high-carrier concentration region A is $10^{19}$ cm$^{-3}$ or more and $10^{22}$ cm$^{-3}$ or less, and the carrier concentration of the high-carrier concentration region A is 8 times or more, preferably 10 times or more, more preferably 15 times or more, still more preferably 100 times or more as high as the carrier concentration of the low-carrier concentration region B. An energy barrier between the low-resistance region and the high-resistance region is formed by increasing the difference in carrier concentration. Thus, when a TFT in which the crystalline oxide thin film is applied to the channel of the TFT is driven, the DIBL phenomenon is less liable to occur, and stable TFT characteristics are obtained.

In this embodiment, the crystalline oxide thin film is defined by the high-carrier concentration region A and the low-carrier concentration region B instead of the low-resistance region A and high-resistance region B of the crystalline oxide thin film of the first embodiment. The high-carrier concentration region A corresponds to the low-resistance region A, and the low-carrier concentration region B corresponds to the high-resistance region B.

In this embodiment, the crystalline oxide thin film has a thickness of 80 nm or less. When the thickness is 80 nm or less, there are tendencies that: the effect of the low-resistance treatment is easily expressed; and the crystal of the crystalline oxide thin film easily becomes a columnar single-layer crystal. As in the first embodiment, the thickness of the crystalline oxide thin film is preferably 60 nm or less, more preferably 50 nm or less, particularly preferably 40 nm or less. Meanwhile, the thickness of the crystalline oxide thin film is, for example, 3 nm or more, and may be 5 nm or more, or may be 10 nm or more.

In addition, the carrier concentration of the high-carrier concentration region A is $10^{19}$ cm$^{-3}$ or more and $10^{22}$ cm$^{-3}$ or less, preferably $10^{19}$ cm$^{-3}$ or more and $10^{21}$ cm$^{-3}$ or less. With this configuration, the conductivity of the low-resistance region is sufficiently high. When the high-carrier concentration region A is used in the crystalline oxide thin film below the source and drain electrodes of a self-aligned TFT and in the crystalline oxide thin film positioned from the end portions of the source and drain electrodes to an intersection between a perpendicular line drawn from the end portion of a gate electrode in a thickness direction and the crystalline oxide thin film, the high-carrier concentration region A does not become a resistance component at the time of the drive of the TFT. As a result, a TFT having a high mobility can be achieved.

In one embodiment, the carrier concentration of the low-carrier concentration region B is preferably $10^{15}$ cm$^{-3}$ or more and less than $10^{19}$ cm$^{-3}$. With this configuration, when the low-carrier concentration region B is used as a crystalline oxide thin film region below the gate electrode and gate insulating film of a self-aligned TFT, the Vth approaches 0 V in an Id-Vg curve when a Vd of 0.1 V is applied to drive the TFT, and satisfactory performance of normally-off characteristics is exhibited.

The carrier concentration may be determined by Hall effect measurement as described in Examples.

The constituent elements, production method, preferred ranges, and the like of the crystalline oxide thin film according to this embodiment are the same as those of the first embodiment. In addition, a laminate, a TFT, an electronic circuit, an electric device, an electronic device, a vehicle, and a power engine described later are described regarding the crystalline oxide thin film of the first embodiment, but the same can also apply to the second embodiment. Specifically, the application example of the second embodiment is obtained by replacing the low-resistance region A by the high-carrier concentration region A and replacing the high-resistance region B by the low-carrier concentration region B.

(3) Third Embodiment of Crystalline Oxide Thin Film

A crystalline oxide thin film of this embodiment is a crystalline oxide thin film including In as a main component, and has a thickness of 80 nm or less. An average spacing D between crystal grain boundaries of the crystalline oxide thin film is 2 $\mu$m or less, and the carrier concentration thereof is $10^{19}$ cm$^{-3}$ or more and $10^{22}$ cm$^{-3}$ or less.

The crystalline oxide thin film of this embodiment includes the high-carrier concentration region A of the crystalline oxide thin film of the second embodiment. The constituent elements, production method, preferred ranges, and the like of the crystalline oxide thin film according to this embodiment are the same as those of the first embodiment and the second embodiment.

2. Laminate

A laminate according to an embodiment of the present invention includes the crystalline oxide thin film according to one embodiment described above and a lower layer that supports the crystalline oxide thin film.

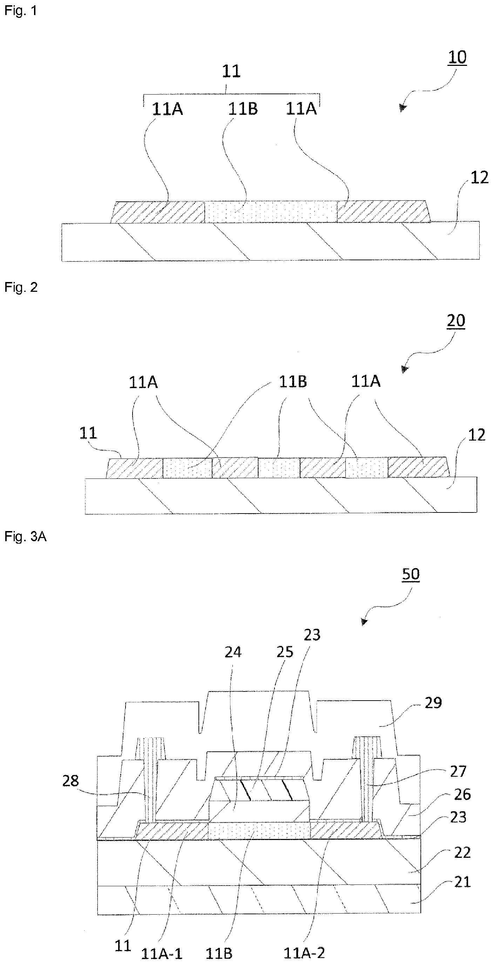

Fig. 1 is a schematic sectional view of an example of the laminate of this embodiment. A laminate 10 includes a crystalline oxide thin film 11 and a lower layer 12 that supports the crystalline oxide thin film 11. The crystalline oxide thin film 11 includes one high-resistance region B (11B) and two low-resistance regions A (11A) arranged so as to interpose the high-resistance region B (11B) therebetween in a plane direction.

In the crystalline oxide thin film and the laminate according to this embodiment, it is only required that the crystalline oxide thin film include the high-resistance region B and the low-resistance region A, and the other configurations are not limited.

Fig. 2 is a schematic sectional view of another example of the laminate of this embodiment.

A laminate 20 includes the crystalline oxide thin film 11 and the lower layer 12 that supports the crystalline oxide thin film 11. In the laminate 20, the crystalline oxide thin film 11 includes the high-resistance regions B (11B) and the low-resistance regions A (11A) alternately formed in the plane direction.

In each of the laminates 10 and 20, the lower layer 12 is a single layer. However, it is not limited thereto and may be a laminate of two or more layers. Examples of the lower layer 12 include a substrate, a buffer layer, an insulating layer, an electrode, a light shield layer, and the like. Each of those layers may be formed of two or more layers.

In the laminate according to this embodiment, an average grain boundary angle $\theta_{sub}$ formed by the surface of the lower layer and the crystal grain boundary in the crystalline oxide thin film is preferably 70° or more and 110° or less. When the average grain boundary angle $\theta_{sub}$ formed by the surface of the lower layer and the crystal grain boundary in the crystalline oxide thin film satisfies the above-mentioned range, the crystal grain boundaries are allowed to be densely present with respect to the surface of the lower layer with which the crystalline oxide thin film is in contact. As a result, when the crystalline oxide thin film is in contact with an electrode (e.g., a source electrode) serving as the lower layer, the crystal grain boundaries are densely present with respect to the electrode surface. As a result, even when the contact region with respect to the electrode is narrow (e.g., a small TFT), electron injection into the crystalline oxide thin film can be ensured, and a reduction in mobility can be suppressed.

(Method of producing Crystalline Oxide Thin Film and Laminate)

The crystalline oxide thin film of this embodiment and the laminate including the crystalline oxide thin film may be produced, for example, by forming a thin film including an In oxide as a main component, for example, on a lower layer for forming a TFT, such as a substrate, a buffer layer, or an insulating layer, and then subjecting a desired portion to the above-mentioned low-resistance treatment. A method for the film formation is not particularly limited, but examples thereof include DC sputtering, AC sputtering, RF sputtering, ICP sputtering, reactive sputtering, ion plating, ALD, PLD, MO-CVD, ICP-CVD, a sol-gel method, a coating method, and mist CVD. When the film formation is performed by sputtering, the film formation may be performed by a device with a planar sputtering cathode or may be performed by a device with a rotary sputtering cathode.

As an example of the film formation method, the film may be produced by performing film formation by DC sputtering through use of a sputtering target including an oxide sintered body including an In oxide as a main component, and then subjecting a desired portion to the above-mentioned low-resistance treatment.

The atomic composition ratio of the crystalline oxide thin film obtained by the sputtering method reflects the atomic composition ratio of the oxide sintered body in the sputtering target. Accordingly, the film formation is preferably performed by using a sputtering target including an oxide sintered body having the same atomic composition ratio as the atomic composition ratio of a desired oxide thin film.

In addition, heat treatment may be performed after the formation of the thin film and before the low-resistance treatment. The step of the heat treatment is not particularly limited, but a hot air furnace, an IR furnace, a lamp annealing device, a laser annealing device, a thermal plasma device, or the like may be used.

Further, plasma oxidation treatment with $N_2O$ or plasma oxidation treatment with $O_2$ may be performed after the annealing and before the low-resistance treatment. A device for the plasma oxidation treatment is not particularly limited, but is, for example, PE-CVD.

The amount of an impurity metal in the target used in the sputtering method is 500 ppm or less, more preferably 100 ppm or less. The amount of the impurity metal in the target may be measured by ICP or SIMS as in the crystalline oxide thin film. The "impurity" contained in the target means a trace element that is mixed in a raw material or during a manufacturing process and is not intentionally added, the element having substantially no influence on the performance of each of the target and the semiconductor. The "impurity metal" means a metal element among the elements as "impurities".

In this embodiment, the sputtering target may consist essentially of In and an element selected from Mg, Al, Si, Zn, Ga, Mo, Sn, lanthanoid elements (Ln elements), and O. Herein, the term "essentially" means that the sputtering target may include any other component in addition to In described above to the extent that the effects of the present invention attributed to the combination of Mg, Al, Si, Zn, Ga, Mo, Sn, Ln, and O are exhibited.

As in the crystalline oxide thin film of the present invention described above, the sputtering target according to a more preferred first mode of this embodiment is an oxide consisting of In and Ga as metal elements, and the atomic ratios satisfy the following formula (11).

$$[Ga]/([In]+[Ga]) < 22 \text{ at\%} \qquad (11)$$

The sputtering target according to a more preferred second mode is an oxide consisting of In and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb, and Lu as metal elements, and when the metal element except In is represented by X, the atomic ratios satisfy the following formula (12).

$$[X]/([In]+[X]) < 15 \text{ at\%} \qquad (12)$$

The sputtering target according to a more preferred third mode is an oxide consisting of In, Ga, and one or more elements X selected from B, Al, Sc, Mg, Zn, Ti, Y, Zr, Mo, Sn, Hf, W, Nb, Ta, Ge, Si, La, Ce, Pr, Nd, Sm, Dy, Ho, Er, Tm, Yb, and Lu as metal elements, and when the metal element except In and Ga is defined as an additive element X, the atomic ratios satisfy the following formulas (13) and (14).

$$[Ga]/([In]+[Ga]+[X]) < 22.5 \text{ at\%} \qquad (13)$$

$$[X]/([In]+[Ga]+[X]) < 8.0 \text{ at\%} \qquad (14)$$

The sputtering target according to a more preferred fourth mode is an oxide consisting of In, Sn, and one or more elements X selected from B, Al, Sc, Mg, Zn, Ti, Y, Zr, Mo, Hf, W, Nb, Ta, Ge, Si, La, Ce, Pr, Nd, Sm, Dy, Ho, Er, Tm, Yb, and Lu as metal elements, and when the metal element except In and Sn is defined as an element X, the atomic ratios satisfy the following formulas (15) and (16).

$$[Sn]/([In]+[Sn]+[X]) < 20 \text{ at\%} \qquad (15)$$

$$[X]/([In]+[Sn]+[X]) < 8.0 \text{ at\%} \qquad (16)$$

The sputtering target according to a more preferred fifth mode is an oxide consisting of In, Zn, and one or more elements X selected from B, Al, Sc, Mg, Ti, Y, Zr, Mo, Hf, W, Nb, Ta, Ge, Si, La, Ce, Pr, Nd, Sm, Dy, Ho, Er, Tm, Yb, and Lu as metal elements, and when the metal element except In and Zn is defined as an element X, the atomic ratios satisfy the following formulas (17) and (18).

$$[Zn]/([In]+[Zn]+[X]) < 12 \text{ at\%} \qquad (17)$$

$$[X]/([In]+[Zn]+[X]) < 8.0 \text{ at\%} \qquad (18)$$

The oxide thin film obtained by film formation by sputtering through use of the sputtering target including indium oxide as a main component is an amorphous oxide thin film. The oxide thin film is patterned into an island shape by photolithography, and is heated to be crystallized before the formation of a protective film. Thus, a crystalline oxide thin film in which a surface crystal has a single crystal orientation can be obtained.
Respective steps are described below.

(Oxide Thin Film Formation Step)

In an oxide thin film formation step, an oxide thin film is formed by sputtering through use of the above-mentioned sputtering target and through use of, as a sputtering gas, one or more kinds of gases selected from the group consisting of argon and oxygen substantially free of impurity gases. In this step, it is preferred that the sputtering be performed by mounting the sputtering target on a RF magnetron sputtering device or a DC magnetron sputtering device.

The sputtering gas being "substantially free of impurity gases" means that impurity gases except the sputtering gas are not actively introduced, except for gases that are brought in by adsorbed water in association with the insertion of gases, and gases that cannot be eliminated (inevitable impurity gases), such as leakage from a chamber and adsorbed gases. Impurities are preferably eliminated from the gas (sputtering gas) to be introduced at the time of the film formation by sputtering, if possible.

The ratio of the impurity gases in the sputtering gas is preferably 0.1 vol% or less, more preferably 0.05 vol% or less. When the ratio of the impurity gases is 0.1 vol% or less, the crystallization of the oxide thin film progresses without any problem.

The purity of each of high-purity argon and high-purity oxygen, which are examples of the sputtering gas, is preferably 99 vol% or more, more preferably 99.9 vol% or more, still more preferably 99.99 vol% or more.

The gas (sputtering gas) to be introduced at the time of the film formation by sputtering is not particularly limited, but examples thereof include argon, nitrogen, oxygen, water, hydrogen, and a mixed gas containing two or more kinds of those gases.

An oxygen partial pressure in a mixed gas in the case of using argon and oxygen as an example is preferably more than 0 vol% and 50 vol% or less, more preferably more than 0 vol% and 20 vol% or less. When the oxygen partial pressure is more than 0 vol% and 50 vol% or less, the oxide thin film is easily crystallized to become a semiconductor at the time of heating. When the oxygen partial pressure is changed, the oxidation degree of the oxide thin film, that is, the crystallization degree thereof can be regulated. The oxygen partial pressure only needs to be appropriately selected as required.

A water partial pressure in a mixed gas in the case of using argon and water as an example is preferably more than 0.03 vol% and 10 vol% or less, more preferably more than 0.03 vol% and 5 vol% or less. When the water partial pressure is more than 0.03 vol% and 5 vol% or less, the oxide thin film is easily crystallized to become a semiconductor at the time of heating. In addition, a mixed gas of hydrogen and oxygen may be used instead of water.

The crystalline oxide thin film according to this embodiment preferably includes an In element as a main component. When the oxide thin film is heated through a heat treatment step described later, columnar crystals can be grown on the lower layer. When the oxide thin film formed as described above is applied to a small TFT, the injection property of an electron carrier at the time of the drive of the TFT is excellent. As a result, the TFT exhibits a high mobility, and provides uniform characteristics of the mobility and threshold voltage (Vth) thereof with respect to a device shape.

(Step of forming Constituent Layer of TFT)

When the constituent layer of the TFT, such as an insulating layer, is formed on the crystalline oxide thin film, it is preferred that the resultant oxide thin film be subjected to heat treatment, followed by the formation of the constituent layer on the oxide thin film. When the annealing is performed before the formation of the constituent layer of the TFT, oxygen and hydrogen are diffused at the time of the annealing, and thus a high-quality columnar crystal is obtained. As a result, a small TFT with a low interfacial electron trap level and a high mobility is obtained after the formation of the constituent layer.

(Heat Treatment Step)

After the formation of the oxide thin film, the heat treatment is performed. The heat treatment is sometimes referred to as "annealing".

The temperature of the heat treatment is preferably 250°C or more and 500°C or less, more preferably 280°C or more and 470°C or less, still more preferably 300°C or more and 450°C or less.

When the heat treatment temperature after the formation of the oxide thin film is 250°C or more, the oxide thin film is easily crystallized. When the heat treatment temperature after the formation of the oxide thin film is 500°C or less, a crystal can be prevented from abnormally growing to form a large crystal grain, and the crystal grain diameter can be controlled to be small.

A heating time in the heat treatment step is preferably 0.1 hour or more and 5 hours or less, more preferably 0.3 hour or more and 3 hours or less, still more preferably 0.5 hour or more and 2 hours or less.

When the heating time in the heat treatment step is 0.1 hour or more, such a situation that the oxide thin film is not crystallized does not occur, and the oxide thin film is easily crystallized.

When the heating time in the heat treatment step is 5 hours or less, the heat treatment step is excellent in economic efficiency.

The "heating time" means a time (retention time) for which a predetermined highest temperature is maintained during the heat treatment.

A rate of temperature increase in the heat treatment step is preferably 2°C/min or more and 40°C/min or less, more preferably 3°C/min or more and 20°C/min or less.

When the rate of temperature increase in the heat treatment step is 2°C/min or more, the production efficiency of the oxide thin film is improved as compared to a case where the rate of temperature increase is less than 1°C/min.

When the rate of temperature increase in the heat treatment step is 40°C/min or less, at the time of the crystallization, the metal elements are uniformly diffused, and crystals in which no metal is segregated at the grain boundaries can be formed.

In addition, the rate of temperature increase in the heat treatment step is different from a value calculated from the set temperature and set time of a furnace, and is a value obtained by dividing the actual temperature of the oxide thin film by a time. The actual temperature of the oxide thin film may be determined, for example, by measuring an area within 1 cm from the oxide thin film in the furnace with a thermocouple.

The heat treatment step is preferably performed under an atmospheric atmosphere having a humidity of 10% or more at 25°C. When the heat treatment step is performed in the atmosphere having a humidity of 10% or more, hydrogen and oxygen are diffused into the film at the time of the annealing, and thus the crystallization can be accelerated.

The heat treatment step is preferably performed after the patterning of the oxide thin film. When the heat treatment is performed after the patterning, the crystallization of the oxide thin film can be accelerated while excess oxygen existing in the film during the film formation and organic substances adhering during the patterning are desorbed. As a result, a film having no organic substances or excess oxygen and having few crystal defects in the crystal grains can be formed, and an oxide thin film having few electron traps and a satisfactory conduction characteristic can be formed.

Crystal defects in the film after the heat treatment step may be evaluated, for example, by defect analysis such as cathodoluminescence (CL). When there are a large number of defects derived from oxygen, a light emission of 680 nm is strongly detected. In order to obtain an oxide thin film having few electron traps and a satisfactory conduction characteristic, it is required to adjust the film formation method and the annealing conditions so as to provide a film in which the light emission based on the CL is prevented from being detected to the extent possible.

The heat treatment step may be performed a plurality of times. For example, the heat treatment step described above (first heat treatment step) may be performed after the patterning of the oxide thin film, and further a heat treatment step (second heat treatment step) may be performed as a final step after the production of a TFT device. The second heat treatment step is preferably performed at an annealing temperature higher than that in the first heat treatment step.

(Low-resistance Treatment Step)

The low-resistance region A and the high-resistance region B are formed in the crystalline oxide thin film obtained in the heat treatment step. The low-resistance region A is not particularly limited, but may be formed, for example, by causing a target portion of the crystalline oxide thin film to have low resistance by a dry process such as a method involving heat treatment (annealing), plasma treatment, or ion implantation in the presence of indium tin oxide (ITO), aluminum, or the like. A region that is not subjected to the low-resistance treatment serves as the high-resistance region B.

When the low-resistance region A is formed by annealing in the presence of ITO, it is only required that an ITO layer be formed by sputtering or the like on the crystalline oxide thin film in a region whose resistance is to be reduced and then annealed at a temperature of 250°C or more and 500°C or less (preferably 280°C or more and 470°C or less, more preferably 300°C or more and 450°C or less) for a period of time of 0.1 hour or more and 5 hours or less.

After the annealing, the ITO layer may be removed by etching or may be left.

When the low-resistance region A is formed by annealing in the presence of aluminum, it is only required that an aluminum layer be formed by sputtering or the like on the crystalline oxide thin film in a region whose resistance is to be reduced and then annealed at a temperature of 250°C or more and 500°C or less (preferably 280°C or more and 470°C or less, more preferably 300°C or more and 450°C or less) for a period of time of 0.1 hour or more and 5 hours or less.

After the annealing, aluminum may remain as it is or may become aluminum oxide. In any case, aluminum or an aluminum oxide layer may be removed by etching or may be left as it is.

When the low-resistance region A is formed by plasma treatment, the crystalline oxide thin film obtained in the heat treatment step is subjected to the treatment. A gas to be used in the plasma treatment is not particularly limited, but examples thereof include $H_2$, He, Ar, $N_2$, a F-based gas, and the like. In general, elements to be used in the plasma treatment are preferably elements each having a small ion radius. When the plasma treatment using those elements is performed, oxygen vacancies are generated in the crystalline oxide thin film to increase the carrier concentration, and thus the crystalline oxide thin film is reduced in resistance.

When the low-resistance region A is formed by ion implantation, there are a case in which ions are directly implanted into the crystalline oxide thin film obtained in the heat treatment step, and a case in which ions are implanted via the gate insulating film or the interlayer insulating film after the formation of such insulating film on the oxide thin film.

Ions to be used for the implantation are not particularly limited, but examples thereof include $H^+$, $He^+$, $B^+$, $N^+$, $F^+$, $PHx^+$, $Ar^+$, and the like. Any element that causes oxygen deficiency by the ion implantation or any element that emits electrons and acts as a donor when left in the film may be used. In addition, the element may or may not remain in the film.

In one embodiment, the low-resistance treatment step is preferably performed after the formation of the gate insulating film and/or the gate electrode. Specifically, the low-resistance region A and the high-resistance region B may be formed through use of the gate insulating film and/or the gate electrode instead of a mask (self-alignment).

For example, when the ITO layer described above is used, the region of the crystalline oxide thin film in which the ITO layer is directly laminated serves as the low-resistance region A, and the region below the gate insulating film and/or the gate electrode serves as the high-resistance region B.

3. Thin Film Transistor (TFT)

A TFT according to an embodiment of the present invention includes the crystalline oxide thin film or laminate of the present invention described above. The crystalline oxide thin film of the present invention is preferably used as a channel layer of the TFT. It is more preferred that both end sides of the channel layer, that is, the vicinities of the regions to which the source electrode and the drain electrode are connected be the low-resistance regions A of the crystalline oxide thin film, and the region in contact with the lower surface of the gate insulating film be the high-resistance region B.

In one embodiment, the TFT has a structure which includes a channel layer, a source electrode and a drain electrode each connected to both end sides of the channel layer, and a gate electrode laminated on the channel layer via a gate insulating film, and in which the channel layer is the crystalline oxide thin film, the gate insulating film is formed on the high-resistance region B, and the source electrode and the drain electrode are formed on the low-resistance region A. In addition, a distance $L_{off}$ from an end portion of the source electrode and an end portion of the drain electrode to an intersection between a perpendicular line drawn from an end portion of the gate electrode in a thickness direction and the crystalline oxide thin film is 4 $\mu$m or more and 20 $\mu$m or less.

In addition, the average spacing D between crystal grain boundaries of the crystalline oxide thin film and the distance $L_{off}$ satisfy the following formula (1).

$$2 \leq L_{off}/D \leq 100 \cdots (1)$$

In one embodiment, in the TFT, a contact region length Ls of the channel layer with respect to each of the source electrode and the drain electrode is 4 $\mu$m or more and 20 $\mu$m or less. In addition, the average spacing D between crystal grain boundaries of the crystalline oxide thin film and the contact region length Ls satisfy the following formula (2).

$$1 \leq Ls/D \leq 100 \cdots (2)$$

Thus, an excellent mobility is exhibited even when the contact region of the channel layer with respect to each of the source electrode and the drain electrode is small.

The TFT produced in the related art uses a crystalline oxide thin film in order to obtain a high mobility. A source electrode and a drain electrode are formed on an oxide thin film through use of a metal mask, and for example, the contact region length between the source electrode and the oxide thin film is about 100 $\mu$m. Thus, even when the crystal grain diameter in the oxide thin film is 1 $\mu$m or more, about 100 crystal grain boundaries are present in the contact region with respect to the source electrode, and a sufficient number of crystal grain boundaries that are conductive regions are in contact with the source electrode. Accordingly, there have been no major problems in terms of the mobility.

In addition, the TFT of the related art has a structure in which parasitic capacitance is generated in a region in which the gate electrode and the source and drain electrodes overlap each other. However, high resolution, high-speed drive, and an increase in area have not been required in a display, and hence there have been no major problems.

However, in recent years, high resolution, high-speed drive, and an increase in area have been required in a display such as an OLED. In the trend toward an increase in definition, the size of a TFT is becoming smaller in order to increase the aperture ratio of a pixel circuit. Thus, it is required to control the characteristics of a small TFT patterned by photolithography instead of the film formation using a metal mask as in the related art. Further, in the trend toward an increase in definition, high-speed drive, and an increase in area of a display, it is required to reduce parasitic capacitance in order to eliminate the RC delay in which the time from input to drive is delayed owing to the influences of parasitic resistance and parasitic capacitance in a backplane drive circuit. In addition, it is required to reduce variation in parasitic capacitance as much as possible in order to eliminate brightness unevenness in each pixel of the OLED.

In order to solve those problems at the same time, it is effective to adopt a self-aligned TFT structure in which regions obtained by selectively reducing the resistance of a semiconductor through use of the gate electrode as a mask are used as the source region and the drain region. When the oxide thin film is applied to a self-aligned and small TFT structure (self-aligned small TFT structure), the contact region length between the source electrode and the crystalline oxide thin film is shortened. In addition, the distance from the end portion of the source electrode and the end portion of the drain electrode to the intersection between the perpendicular line drawn from the end portion of the gate electrode in the thickness direction and the crystalline oxide thin film is shortened.

In orderto apply a crystalline oxide thin film having a high mobility to a self-aligned small TFT structure to achieve a sufficient mobility and stably control the threshold voltage (Vth), it is required that: a sufficient number of crystal grain boundaries be allowed to be present in the region from the end portion of the source electrode and the end portion of the drain electrode to the intersection between the perpendicular line drawn from the end portion of the gate electrode in the thickness direction and the crystalline oxide thin film; or a sufficient number of crystal grain boundaries be allowed to be present in the contact region with respect to the source electrode. In the TFT according to this embodiment, the distance $L_{off}$ and the contact region length Ls satisfy the formula (1) and the formula (2). Thus, the mobility is excellent, and the Vth can be stably controlled.

In one embodiment, a gap $\Delta L$ in a horizontal direction between the low-resistance region A and the gate electrode is less than 1 $\mu$m. The crystalline oxide thin film of the present invention is suitable for a self-aligned TFT, and hence the gap $\Delta L$ can be made extremely small.

As the configuration of the TFT according to this embodiment, for example, a configuration known in the related art may be adopted.

The TFT according to this embodiment may be produced by adopting the method for producing a crystalline oxide thin film and a laminate described above. That is, the method is a production method including the steps of forming an oxide thin film by sputtering through use of a sputtering target by using, as a sputtering gas, one or more kinds of gases selected from the group consisting of argon, nitrogen, hydrogen, water and oxygen substantially free of impurity gases (sometimes referred to as "film formation step"); and subjecting the oxide thin film to heat treatment (sometimes referred to as "heat treatment step"). The conditions and the like of the film formation step and the heat treatment step are the same as described above. The source electrode, the drain electrode, the gate electrode, and the gate insulating film may be formed by using known materials and known formation methods.

The crystalline oxide thin film according to one embodiment has a high mobility in a direction parallel to the film surface. Through use of such crystalline oxide thin film for an oxide semiconductor layer (channel layer) or a conductive region of a self-aligned small TFT, a high mobility and stable Vth control can be achieved. Here, the mobility at the time of the application of a Vd of 0.1 V is determined as a linear mobility, and the mobility at the time of the application of a Vd of 20 V is defined by using a saturation mobility as an indicator.

Specifically, a transmission characteristic Id-Vg graph at the time of the application of each Vd is created, and a transconductance (Gm) at each Vg is calculated. The calculation may be performed by determining the mobility through use of the formula of a linear region or a saturation region. The current Id is a current between the source electrode and the drain electrode. The voltage Vd is a voltage (drain voltage) applied between the source electrode and the drain electrode. The voltage Vg is a voltage (gate voltage) applied between the source electrode and the gate electrode. The mobility is 20 cm$^2$/(V·s) or more, and is preferably as high as possible.

In addition, in the crystalline oxide thin film according to one embodiment, a Schottky barrier diode, a MES-FET, or the like may be formed by arranging an ohmic electrode made of a metal, ITO, IZO, or the like on one surface of the high-resistance region B and arranging a Schottky electrode made of a metal, an oxide, or the like having a work function of 4.8 eV or more on the other surface.

The shape of the thin film transistor according to this embodiment is not particularly limited as long as the thin film transistor is self-aligned, but the thin film transistor is preferably a top-gate type transistor, a back channel etch type transistor, an etch stopper type transistor, or the like.

Embodiments of the present invention are described below with reference to the drawings. It should be easily understood by a person skilled in the art that the embodiments may be carried out in various manners, and their forms and details may be variously modified without departing from the gist and scope of the present invention. Accordingly, the present invention is not interpreted to be limited to the descriptions in the embodiments below.

In the drawings, a size, a layer thickness, a region, and the like are sometimes exaggerated for clarification. Accordingly, the present invention is not limited to the size, the layer thickness, the region, and the like shown in the drawings. The drawings include schematic illustrations of an ideal example, and the present invention is not limited to shapes, values, and the like shown in the drawings.

Fig. 3A is a schematic sectional view of an example of the TFT of this embodiment.

A TFT 50 is a top-gate type TFT, and includes a substrate 21, a buffer layer 22, a channel layer (crystalline oxide thin film) 11, an ITO layer 23, a gate insulating film 24, a gate electrode 25, an interlayer insulating film 26, a source electrode 27, a drain electrode 28, and a protective film 29.

The TFT 50 has a structure in which the substrate 21, the buffer layer 22, and the channel layer (crystalline oxide thin film) 11 are laminated in this order. A high-resistance region 11B is present in the center portion of the channel layer 11, and the gate insulating film 24 and the gate electrode 25 are laminated on the high-resistance region 11B in this order. The gate insulating film 24 is an insulating film that interrupts conduction between the gate electrode 25 and the crystalline oxide thin film 11.

Low-resistance regions 11A-1 and 11A-2 of the channel layer 11 are present on both sides of the high-resistance region 11B. The low-resistance regions 11A-1 and 11A-2 and the gate electrode 25 are covered with the ITO layer 23 and the interlayer insulating film 26. The ITO layer 23 is used at the time of the formation of the low-resistance regions of the channel layer 11.

The source electrode 27 and the drain electrode 28 are each connected to the low-resistance regions 11A-1 and 11A-2 via contact holes formed in the ITO layer 23 and the interlayer insulating film 26. The source electrode 27 and the drain electrode 28 are conductive terminals for allowing a source current and a drain current to flow to the channel layer 11.

The protective film 29 is arranged so as to cover the TFT constituent layers, such as the interlayer insulating film 26, the source electrode 27, and the drain electrode 28.

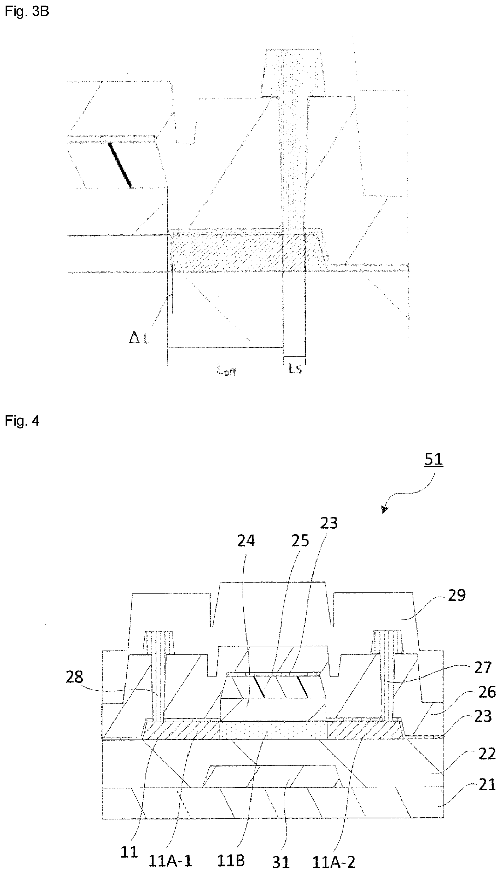

Fig. 3B is an enlarged view of the vicinity of the source electrode in Fig. 3A. Fig. 3B is a view for illustrating the distance $L_{off}$ from the end portion of the source electrode and the end portion of the drain electrode to the intersection between the perpendicular line drawn from the end portion of the gate electrode in the thickness direction and the crystalline oxide thin film, the contact region length Ls of the channel layer with respect to the source electrode (drain electrode) in the TFT 50, and the gap $\Delta L$ in the horizontal direction between the low-resistance region A and the gate electrode.

Fig. 4 is a schematic sectional view of another example of the TFT of this embodiment.

A TFT 51 has the same configuration as that of the TFT 50 except that a light shield layer 31 is arranged between the substrate 21 and the buffer layer 22. The light shield layer 31 is formed in order to suppress the malfunction of the TFT caused by light.

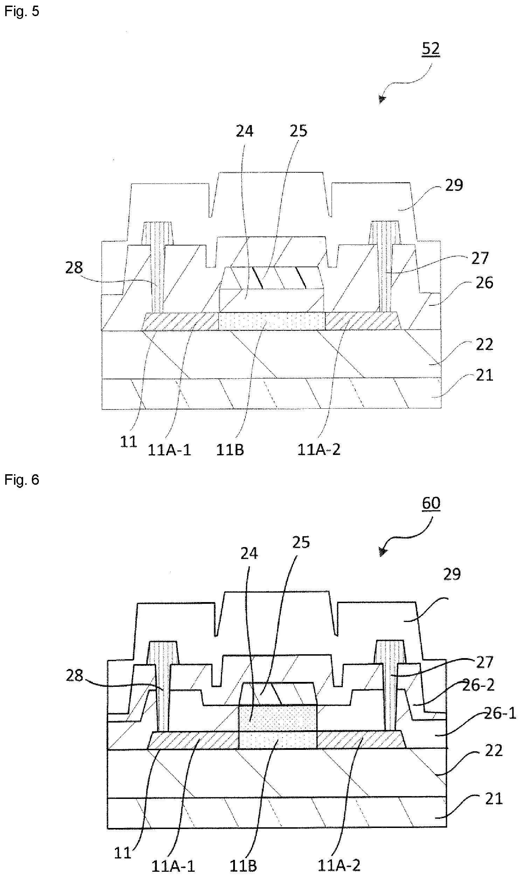

Fig. 5 is a schematic sectional view of another example of the TFT of this embodiment.

A TFT 52 has the same configuration as that of the TFT 50 except that the ITO layer 23 is not formed. In this example, the low-resistance regions 11A-1 and 11A-2 are formed, for example, by a dry process, such as an ion implantation method or plasma treatment.

Fig. 6 is a schematic sectional view of another example of the TFT of this embodiment.

A TFT 60 has the same configuration as that of the TFT 50 except that the ITO layer 23 is not formed and the interlayer insulating film 26 has a two-layer structure (interlayer insulating films 26-1 and 26-2). In this example, a region of the interlayer insulating film 26-1 below the gate electrode 25 corresponds to the gate insulating film 24. In this example, the low-resistance regions 11A-1 and 11A-2 are formed, for example, by an ion implantation method.

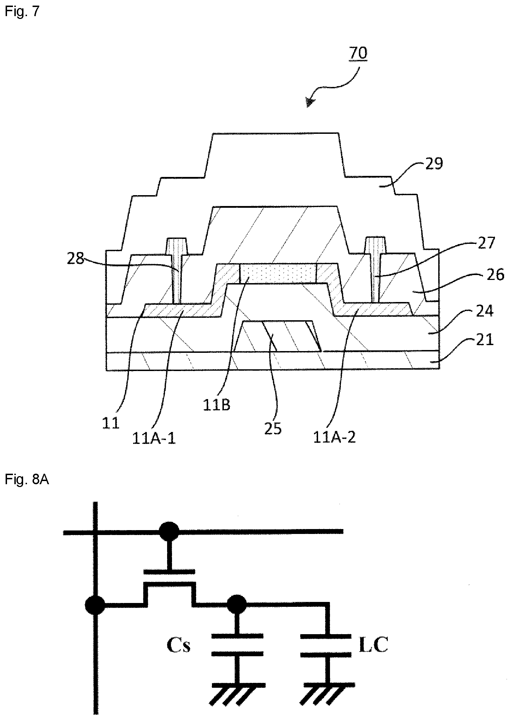

Fig. 7 is a schematic sectional view of another example of the TFT of this embodiment.

A TFT 70 is a bottom-gate type TFT, and includes the substrate 21, the gate electrode 25, the gate insulating film 24, the channel layer (crystalline oxide thin film) 11, the interlayer insulating film 26, the source electrode 27, the drain electrode 28, and the protective film 29.

In the TFT 70, the gate electrode 25 is formed on the substrate 21, and the gate insulating film 24 is laminated on the substrate 21 and the gate electrode 25.

The channel layer (crystalline oxide thin film) 11 is laminated on the gate insulating film 24, a region corresponding to a portion above the gate electrode 25 is the high-resistance region 11B, and the low-resistance regions 11A-1 and 11A-2 of the channel layer 11 are present on both sides of the high-resistance region 11B.

The channel layer (crystalline oxide thin film) 11 is covered with the interlayer insulating film 26. The source electrode 27 and the drain electrode 28 are each connected to the low-resistance regions 11A-1 and 11A-2 via contact holes formed in the interlayer insulating film 26.

The protective film 29 is arranged so as to cover the TFT constituent layers, such as the interlayer insulating film 26, the source electrode 27, and the drain electrode 28.

The TFT of this embodiment may be modified with a known configuration.

A material for forming the substrate is not particularly limited, and any material that is generally used may be selected. There may be used, for example, a glass substrate, a ceramic substrate, a quartz substrate, or a sapphire substrate. In addition, for example, a single crystal semiconductor substrate, such as silicon or silicon carbide, a polycrystal semiconductor substrate, a compound semiconductor substrate such as silicon germanium, or a silicon in insulator (SIO) substrate may be applied, or those substrates each having a semiconductor device arranged thereon may be used as the substrate.

In addition, a flexible substrate may be used as the substrate. As a method for arranging the TFT on the flexible substrate, there is given a method for directly producing the TFT on the flexible substrate, and there is also given a method involving producing the TFT on a non-flexible substrate, then peeling the TFT, and setting the TFT on the flexible substrate. In this case, a release layer may be arranged between the non-flexible substrate and the TFT.

A material for forming the buffer layer 22 is also not particularly limited, and any material that is generally used may be selected. In addition, a laminated film may be used. There may be used, for example, $SiO_2$, SiNx, silicon oxynitride, $Al_2O_3$, $Ta_2O_5$, $TiO_2$, MgO, $ZrO_2$, $Ga_2O_3$, $GeO_2$, $Nd_2O_3$, $La_2O_3$, $CeO_2$, $K_2O$, $Li_2O$, $Na_2O$, $Rb_2O$, $Sc_2O_3$, $Y_2O_3$, $HfO_2$, $CaHfO_3$, $PbTiO_3$, $BaTa_2O_6$, $SrTiO_3$, $Sm_2O_3$, or AlN. The oxidation number of each of the materials may be varied. The buffer layer 22 may be appropriately designed in accordance with the kind of the substrate.

The light shield layer 31 may be connected to the source electrode 27 or may be connected to the gate electrode 25.

A material for forming the light shield layer is not particularly limited, and any material that is generally used may be selected. Specific examples thereof include metal electrodes made of Al, Ag, Cu, Cr, Ni, Co, Mo, Au, Ti, Zr, Ru, Y, Nb, Ta and W, metal electrodes made of alloys containing two or more kinds of those metals, and the like. In addition, a laminated electrode of two or more layers may be used.

A second buffer layer may be arranged between the light shield layer 31 and the substrate 21. A material for forming the second buffer layer is also not particularly limited, and any material that is generally used may be selected. In addition, a laminated film may be used. For example, $SiO_2$, SiNx, silicon oxynitride, $Al_2O_3$, $Ta_2O_5$, $TiO_2$, MgO, $ZrO_2$, $Ga_2O_3$, $GeO_2$, $Nd_2O_3$, $La_2O_3$, $CeO_2$, $K_2O$, $Li_2O$, $Na_2O$, $Rb_2O$, $Sc_2O_3$, $Y_2O_3$, $HfO_2$, $CaHfO_3$, $PbTiO_3$, $BaTa_2O_6$, $SrTiO_3$, $Sm_2O_3$, or AlN may be used. The oxidation number of each of the materials may be varied.

A material for forming the gate insulating film is also not particularly limited, and any material that is generally used may be selected. In addition, a laminated film may be used. For example, $SiO_2$, SiNx, silicon oxynitride, $Al_2O_3$, $Ta_2O_5$, $TiO_2$, MgO, $ZrO_2$, $Ga_2O_3$, $GeO_2$, $Nd_2O_3$, $La_2O_3$, $CeO_2$, $K_2O$, $Li_2O$, $Na_2O$, $Rb_2O$, $Sc_2O_3$, $Y_2O_3$, $HfO_2$, $CaHfO_3$, $PbTiO_3$, $BaTa_2O_6$, $SrTiO_3$, $Sm_2O_3$, or AlN may be used. The oxidation number of each of the materials may be varied.

In this embodiment, when the TFT is a small TFT, the crystalline oxide thin film serving as the channel layer with respect to each of the source electrode and the drain electrode has a channel length (L length) of 1 $\mu$m or more and 50 $\mu$m or less. A channel width is not particularly limited, but the channel width (W length) is, for example, 1 $\mu$m or more and 1,000 $\mu$m or less.

Materials for forming the drain electrode, the source electrode, and the gate electrode are not particularly limited, and any materials that are generally used may be selected. Specifically, for example, there are given transparent electrodes made of ITO, IZO, ZnO, and $SnO_2$, metal electrodes made of Al, Ag, Cu, Cr, Ni, Co, Mo, Au, Ti, Zr, Ru, Y, Nb, Ta, and W, and metal electrodes made of alloys containing two or more kinds of those metals. In addition, a laminated electrode of two or more layers may be used.

A material for each interlayer insulating film is also not particularly limited, and any material that is generally used may be selected. In addition, a laminated film may be used. For example, $SiO_2$, $SiN_x$, silicon oxynitride, $Al_2O_3$, $Ta_2O_5$, $TiO_2$, MgO, $ZrO_2$, $Ga_2O_3$, $GeO_2$, $Nd_2O_3$, $La_2O_3$, $CeO_2$, $K_2O$, $Li_2O$, $Na_2O$, $Rb_2O$, $Sc_2O_3$, $Y_2O_3$, $HfO_2$, $CaHfO_3$, $PbTiO_3$, $BaTa_2O_6$, $SrTiO_3$, $Sm_2O_3$, and AlN may be used. The oxidation number of each of the materials may be varied.

Irrespective of the structure of the TFT, the interlayer insulating film is preferably arranged on the drain electrode, the source electrode, and the conductive region. Further, in the case of the bottom-gate type TFT, the protective film is arranged on the channel layer. When the protective film is arranged, the TFT is easily improved in durability even when driven for a long period of time.

A method for producing an insulating film such as the buffer layer, the gate insulating film, the interlayer insulating film and the protective film is not particularly limited. Examples of the production method include PE-CVD, ALD, PLD, MO-CVD, RF sputtering, ICP sputtering, reactive sputtering, ICP-CVD, ion plating, a sol-gel method, a coating method, mist CVD, and the like. Tetraethoxysilane (TEOS) may be used as the kind of gas in the PE-CVD in addition to silane ($SiH_4$).

For example, when the protective film or the insulating film is formed by the PE-CVD, the process may become a high-temperature process. In addition, the protective film or the insulating film often contains an impurity gas immediately after the film formation, and is hence preferably subjected to the heat treatment (annealing treatment). When the impurity gas is removed by the heat treatment, a stable protective film or insulating film is obtained, which makes it easy to form a highly durable TFT. In addition, when the annealing is performed after the formation of the gate insulating film, hydrogen contained in the gate insulating film diffuses to the oxide thin film, and crystal defects existing on the surface of the oxide thin film are terminated by a hydroxy group. As a result, an oxide thin film having few electron traps and a satisfactory conduction characteristic can be formed.

Through use of the crystalline oxide thin film of the present invention, the influence of the temperature in the PE-CVD process and the influence of the subsequent heat treatment are less liable to be received, and hence the stability of the TFT characteristics can be improved even when the protective film or the insulating film is formed.

The threshold voltage (Vth) is preferably -3.0 V or more and 3.0 V or less, more preferably -2.0 V or more and 2.0 V or less, still more preferably -1.0 V or more and 1.0 V or less. When the threshold voltage (Vth) is -3.0 V or more and 3.0 V or less, the threshold voltage (Vth) can be corrected to Vth=0 V by installing a Vth correction circuit on the TFT. When the TFT thus obtained is installed into a panel, a display can be driven without uneven brightness and burn-in.

The threshold voltage (Vth) may be defined as a Vg when $Id=10^{-9}$ A based on the graph of transmission characteristics. An on-off ratio is preferably $10^6$ or more and $10^{12}$ or less, more preferably $10^7$ or more and $10^{11}$ or less, still more preferably $10^8$ or more and $10^{10}$ or less. When the on-off ratio is $10^6$ or more, a liquid crystal display can be driven. When the on-off ratio is $10^{12}$ or less, an organic EL device having a large contrast can be driven. In addition, when the on-off ratio is $10^{12}$ or less, an off current can be reduced to $10^{-12}$ A or less. Thus, when the TFT is used as a transfer transistor or a reset transistor for a CMOS image sensor, the retention time of an image can be lengthened, and sensitivity can be improved.

The on-off ratio is determined by setting an off-current value to a value of Id when Vg=-10 V and setting an on-current value to a value of Id when Vg=20 V to determine a ratio [on-current value/off-current value].

The off-current value is preferably $10^{-10}$ A or less, more preferably $10^{-11}$ A or less, still more preferably $10^{-12}$ A or less. When the off-current value is $10^{-10}$ A or less, an organic EL having a large contrast can be driven. In addition, when the TFT is used as a transfer transistor or a reset transistor for a CMOS image sensor, the retention time of an image can be lengthened, and sensitivity can be improved.

The TFT according to this embodiment may be suitably used for solar cells, liquid crystal devices, organic electroluminescence devices, inorganic electroluminescence devices, and other display devices, and power semiconductor devices, touch panels, and other electronic devices.

The thin film transistor according to this embodiment may be applied to various integrated circuits including a field effect transistor, a logic circuit, a memory circuit, and a differential amplification circuit, and the various integrated circuits may be applied to electronic devices and the like. Further, the thin film transistor according to this embodiment may be applied not only to the field effect transistor but also to an electrostatic induction transistor and a Schottky barrier transistor.

The thin film transistor according to this embodiment may be suitably used for a display device such as a portable or in-vehicle display device, a solid-state image sensor, and the like. Further, the thin film transistor according to this embodiment may also be suitably used as a transistor for a flat panel detector for an X-ray image sensor for medical use.

In addition, the crystalline oxide thin film according to this embodiment may be applied to a Schottky diode, a resistance change type memory, and a resistor.

The case of using the thin film transistor according to this embodiment in a display apparatus is described below.

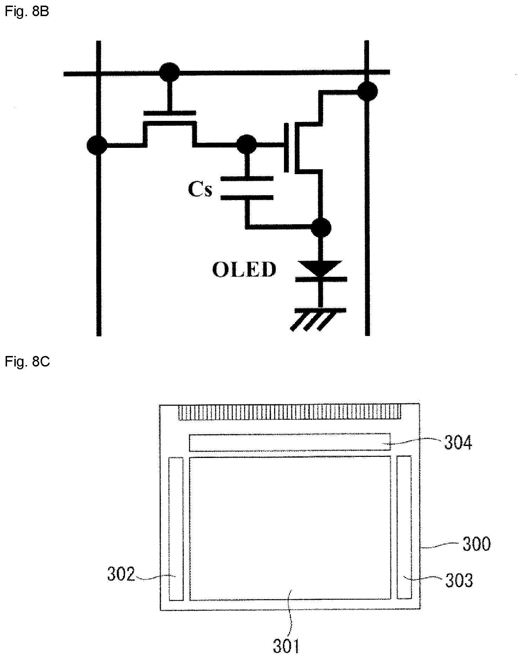

Fig. 8A is an example of a circuit diagram of a pixel portion when a liquid crystal device is applied. When the pixel portion is used for a Mini LED display, Fig. 8A may be used for a circuit for control of an LED chip in addition to a circuit for control of a liquid crystal. In addition, Fig. 8B is an example of a circuit diagram of a pixel portion when an organic EL device is applied.

The circuit of the pixel portion may be applied to a configuration in which one pixel has a plurality of pixel electrodes. The pixel electrodes are each connected to different transistors, and the transistors are each configured to be driven with different gate signals. With this configuration, the signals applied to the individual pixel electrodes of the pixels designed for multi-domains can be independently controlled.

It is only required that the TFT according to this embodiment be used as at least one of the transistors in the circuit diagram. With this configuration, a highly reliable display apparatus can be provided.

The circuit diagram is not limited to the configurations illustrated in Fig. 8A and Fig. 8B. For example, a switch, a resistive element, a capacitive element, a transistor, a sensor, or a logic circuit may be added.

In addition, in a display apparatus using the TFT according to this embodiment, both a Si-based transistor and the TFT of this embodiment may be mounted.

Fig. 8C is a top view of a display apparatus according to this embodiment.

The thin film transistor according to this embodiment may be used as a transistor to be arranged in a pixel portion. The thin film transistor according to this embodiment is easily formed into an n-channel type, and hence part of a drive circuit that can be formed of an n-channel type transistor is formed on the same substrate as that of the transistor in the pixel portion. Through use of the thin film transistor described in this embodiment for the pixel portion and the drive circuit, a highly reliable display apparatus can be provided.

An example of a top view of an active matrix type display apparatus is illustrated in Fig. 8C. A pixel portion 301, a first scanning line drive circuit 302, a second scanning line drive circuit 303, and a signal line drive circuit 304 are formed on a substrate 300 of the display apparatus. In the pixel portion 301, a plurality of signal lines is arranged so as to extend from the signal line drive circuit 304, and a plurality of scanning lines is arranged so as to extend from the first scanning line drive circuit 302 and the second scanning line drive circuit 303. Pixels each having a display device are formed in matrix in intersection regions between the scanning lines and the signal lines. The substrate 300 of the display apparatus is connected to a timing control circuit (sometimes referred to as "controller" or "control IC") via a connecting portion such as a flexible printed circuit (FPC).

In Fig. 8C, the first scanning line drive circuit 302, the second scanning line drive circuit 303, and the signal line drive circuit 304 are formed on the same substrate 300 as that of the pixel portion 301. Thus, the number of components such as a drive circuit to be provided outside is reduced, and hence the cost can be reduced. In addition, when the drive circuit is arranged outside the substrate 300, it becomes necessary to extend wiring, with the result that the number of connections of the wiring is increased. When a drive circuit is arranged on the same substrate 300, the number of connections of the wiring can be reduced, and the improvement of reliability or the improvement of yield can be achieved.

Examples

The present invention is specifically described by way of Examples. The present invention is not limited to Examples.

[Production of Self-Aligned Top-Gate Structure Small TFT]

Example 1

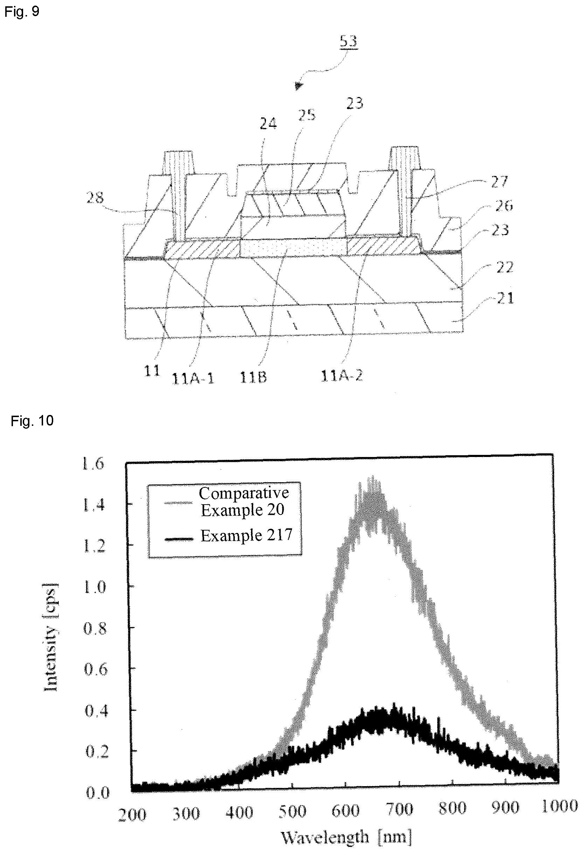

A thin film transistor (TFT) 53 illustrated in Fig. 9 was produced through the following steps. The TFT 53 has the same configuration as that of the TFT 50 illustrated in Fig. 3A except that the protective layer 29 is absent.

(1) Formation of Buffer Layer 22

A SiOx layer (buffer layer 22) having a thickness of 300 nm was formed on an alkali-free glass substrate 21 (EAGLE XG manufactured by Corning Incorporated) having a diameter of 4 inches by sputtering through use of a sputtering target of $SiO_2$. Sputtering conditions are as described below.

Substrate temperature: 25°C
Ultimate pressure: $8.5 \times 10^{-5}$ Pa
Atmospheric gas: Ar
Sputtering pressure (total pressure): 0.4 Pa
Input voltage: RF 300 W
Distance between substrate (S) and target (T): 70 mm

(2) Formation of Oxide Thin Film

Next, a channel layer was formed by sputtering through use of an oxide sputtering target obtained from a raw material mixture having a loaded composition ratio shown in Table 1. A metal composition ratio (unit: at%) in the oxide sputtering target is shown in Table 1.
Film formation conditions in the sputtering and the thickness of the channel layer are shown in Table 1. Sputtering conditions except those shown in Table 1 are as described below.

Substrate temperature: 25°C
Ultimate pressure: $1.0 \times 10^{-4}$ Pa
Atmospheric gas: mixed gas of Ar and $H_2O$
Sputtering pressure (total pressure): 0.5 Pa
Input voltage: DC 300 W
Distance between substrate (S) and target (T): 70 mm

(3) Formation of Channel Layer 11

Next, the oxide thin film was patterned into an island shape by photolithography to form a channel layer 11. First, a film of a photoresist was formed on the oxide thin film. AZ1500 (manufactured by AZ Electronic Materials SA) was used as the photoresist. The film was exposed to light via a photomask in which a pattern was formed into a width of $(10+L_{off}\times2+Ls\times2+2$ (both end portions)$\times2)$ $\mu$m by a length of 20 $\mu$m. After the exposure, development was performed with tetramethylammonium hydroxide (TMAH). After the development, the oxide thin film was etched with oxalic acid (ITO-06N manufactured by Kanto Chemical Co., Inc.). After the etching, the photoresist was peeled off. Thus, a substrate 21 with a patterned oxide thin film (channel layer 11) was obtained. The dimensions of the resultant channel layer 11 were a width of $(10+L_{off}\times2+Ls\times2+2$ (both end portions)$\times2)$ $\mu$m by a length of 20 $\mu$m.

(4) Annealing

Next, the substrate 21 having the channel layer 11 formed thereon was placed in a furnace. The temperature inside the furnace was increased to 350°C at 10°C/min in the atmosphere, and was then held for 1 hour. After the temperature inside the furnace was held at 350°C for 1 hour, the furnace was allowed to cool naturally. After the temperature inside the furnace returned to room temperature, the substrate 21 was removed from the furnace.

(5) Film Formation of Gate Insulating Film 24

Next, a SiOx layer (gate insulating film 24) having a thickness of 10 nm was formed by sputtering through use of a sputtering target of SiOz. Sputtering conditions are as described below.

Substrate temperature: 25°C
Ultimate pressure: $8.5 \times 10^{-5}$ Pa
Atmospheric gas: mixed gas of Ar+Oz (Oz flow rate: 30%)
Sputtering pressure (total pressure): 0.4 Pa
Input voltage: RF 100 W
Distance between substrate (S) and target (T): 70 mm

(6) Annealing of Gate Insulating Film 24

Next, the substrate 21 was placed in a furnace. The temperature inside the furnace was increased to 400°C at 10°C/min in the atmosphere, and was then held for 1 hour. After the temperature inside the furnace was held at 400°C for 1 hour, the furnace was allowed to cool naturally. After the temperature inside the furnace returned to room temperature, the substrate 21 was removed from the furnace.

(7) Film Formation of Gate Insulating Film 24

Next, a SiOx layer (gate insulating film 24) having a thickness of 100 nm was formed by sputtering through use of a sputtering target of SiOz. Sputtering conditions are as described below.

Substrate temperature: 25°C
Ultimate pressure: $8.5 \times 10^{-5}$ Pa
Atmospheric gas: mixed gas of Ar+Oz (Oz flow rate: 30%)
Sputtering pressure (total pressure): 0.4 Pa
Input voltage: RF 100 W
Distance between substrate (S) and target (T): 70 mm
Thus, the total thickness of the gate insulating film 24 became 110 nm.

(8) Formation of Gate Electrode 25

Next, a Mo film having a thickness of 150 nm was formed through use of a sputtering target of Mo. Sputtering conditions are as described below.

Substrate temperature: 25°C
Ultimate pressure: $8.5 \times 10^{-5}$ Pa
Atmospheric gas: Ar
Sputtering pressure (total pressure): 0.4 Pa
Input voltage: DC 100 W
Distance between substrate (S) and target (T): 70 mm

(9) Patterning of Gate Electrode 25 and Gate Insulating Film 24

Next, the Mo film and the gate insulating film 24 were patterned into an island shape by photolithography. First, a film of a photoresist was formed on the channel layer. AZ1500 (manufactured by AZ Electronic Materials SA) was used as the photoresist. The film was exposed to light via a photomask in which a pattern was formed into a size of a width of 10 μm by a length of 28 μm. After the exposure, development was performed with tetramethylammonium hydroxide (TMAH). After the development, a gate electrode 25 was formed by etching the Mo film with a mixed acid of phosphoric acid, nitric acid, and acetic acid (phosphoric-acetic-nitric acid (PAN)).
Then, the gate insulating film 24 was etched with buffered hydrofluoric acid (BHF) and patterned into an island shape.
Next, after the photoresist was peeled off, a region in which the channel layer 11 was exposed was etched by a thickness of 10 nm through use of oxalic acid (ITO-06N manufactured by Kanto Chemical Co., Inc.), followed by cleaning.
The dimensions of the resultant gate electrode layer 25 and gate insulating film 24 were a width of 10 μm by a length of 28 μm.

(9) Low-resistance Treatment

Low-resistance regions A (11A-1 and 11A-2) were formed in the channel layer 11 by self-alignment using the gate electrode 25. An ITO layer 23 having a thickness of 2 nm was formed through use of a sputtering target of ITO. Sputtering conditions are as described below.

Substrate temperature: 25°C
Ultimate pressure: $8.5 \times 10^{-5}$ Pa
Atmospheric gas: mixed gas of $Ar+O_2$ ($O_2$ flow rate: 2%)
Sputtering pressure (total pressure): 0.4 Pa
Input voltage: DC 100 W
Distance between substrate (S) and target (T): 70 mm

Next, the substrate 21 was placed in a furnace. The temperature inside the furnace was increased to 350°C at 10°C/min in the atmosphere, and was then held for 1 hour. Thus, it was annealed. After the temperature inside the furnace was held at 350°C for 1 hour, the furnace was allowed to cool naturally. After the temperature inside the furnace returned to room temperature, the substrate 21 was removed from the furnace.

(10) Formation of Interlayer Insulating Film 26

Next, a SiOx layer (interlayer insulating film 26) having a thickness of 150 nm was formed by sputtering through use of a sputtering target of SiOz. Sputtering conditions are as described below.

Substrate temperature: 25°C
Ultimate pressure: $8.5 \times 10^{-5}$ Pa
Atmosphere gas: mixed gas of Ar+Oz (Oz flow rate: 30%)
Sputtering pressure (total pressure): 0.4 Pa
Input voltage: RF 100 W
Distance between substrate (S) and target (T): 70 mm

(11) Formation of Contact Hole of Interlayer Insulating Film 26

The substrate having the interlayer insulating film 26 formed thereon was coated with a photoresist AZ1500 (manufactured by AZ Electronic Materials SA) and exposed to light via a photomask. After that, development was performed with tetramethylammonium hydroxide (TMAH). After the development, a contact hole having a width of Ls (contact region length of the channel layer 11 with respect to the source electrode 27 and the drain electrode 28, Fig. 3(B)) and a length of 18 μm shown in Table 1 was formed with buffered hydrofluoric acid (BHF).

(12) Formation of Source Electrode 27 and Drain Electrode 28

The source electrode 27 and the drain electrode 28 were patterned by a lift-off process through use of an image reversal resistAZ5214 and a photomask. The image reversal resistAZ5214 was exposed to light via a photomask formed such that the resist was able to be patterned into a final device shape in Table 1. The resist was subjected to a reversal baking step, and was then subjected to flood exposure and development with TMAH. A Mo layer having a thickness of 150 nm was formed on the substrate with the patterned resist under the following sputtering conditions.

Substrate temperature: 25°C
Ultimate Pressure: $8.5 \times 10^{-5}$ Pa
Atmosphere gas: Ar
Sputtering pressure (total pressure): 0.4 Pa
Input voltage: DC 100 W
Distance between substrate (S) and target (T): 70 mm

After that, the substrate having the Mo layer formed thereon was lifted off in acetone. Thus, the source electrode 27 and the drain electrode 28 were patterned.

(13) Final Annealing

Finally, the resultant was annealed at 300°C for 1 hour in a $N_2$ atmosphere to provide a self-aligned top-gate structure small TFT.

The production conditions for the TFT are summarized in Tables 1 and 2.

Comparative Example 1

A TFT was produced in the same manner as in Example 1 except that (9) Low-resistance Treatment in Example 1 was not performed.

Comparative Example 2

A TFT was produced in the same manner as in Example 1 except that the ITO layer 23 was formed and the annealing was not performed in (9) Low-resistance Treatment in Example 1.

Table 1

| | | | Example 1 | Example 2 | Comparative Example 1 | Comparative Example 2 |
|---|---|---|---|---|---|---|
| Sputtering target | Loaded composition ratio [mass%] | $In_2O_3$ | 95.0 | 100.0 | 95.0 | 95.0 |
| | | $Ga_2O_3$ | 5.0 | 0.0 | 5.0 | 5.0 |
| | Metal composition ratio [at%] | In | 92.8 | 100.0 | 92.8 | 92.8 |
| | | Ga | 7.2 | 0.0 | 7.2 | 7.2 |
| TFT production conditions | Film formation of channel layer | Pressure at time of film formation [Pa] | 0.5 | 0.5 | 0.5 | 0.5 |
| | | Oxygen partial pressure at time of film formation [Pa] | 0.00 | 0.00 | 0.00 | 0.00 |
| | | Water partial pressure at time of film formation [Pa] | 0.01 | 0.03 | 0.01 | 0.01 |
| | | Magnetic flux density [G] | 600 | 600 | 600 | 600 |
| | | Thickness [nm] | 10 | 10 | 10 | 10 |
| | Patterning of channel layer | Semiconductor etching | Oxalic acid | Oxalic acid | Oxalic acid | Oxalic acid |
| | Annealing | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |

(continued)

|  |  |  | Example 1 | Example 2 | Comparative Example 1 | Comparative Example 2 |
|---|---|---|---|---|---|---|
| | Film formation of gate insulating film | Gate insulating film | SiO$_2$ | SiO2 | SiO$_2$ | SiO$_2$ |
| | | Thickness [nm] | 10 | 10 | 10 | 10 |
| | Annealing | Temperature increase pattern [°C/min] | 10 | 10 | 10 | 10 |
| | | Highest temperature [°C] | 400 | 400 | 400 | 400 |
| | | Retention time [h] | 1 | 1 | 1 | 1 |
| | | Atmosphere | Atmospheric | Atmospheric | Atmospheric | Atmospheric |

Table 2

|  |  |  | Example 1 | Example 2 | Comparative Example 1 | Comparative Example 2 |
|---|---|---|---|---|---|---|
| | Film formation of gate insulating film | Gate insulating film | SiO$_2$ | SiO2 | SiO$_2$ | SiO$_2$ |
| | | Thickness [nm] | 100 | 100 | 100 | 100 |
| | Film formation of gate electrode | Gate electrode | Mo | Mo | Mo | Mo |
| | | Thickness [nm] | 150 | 150 | 150 | 150 |
| | Gate patterning | Etchant for gate electrode | PAN | PAN | PAN | PAN |
| | | Etchant for gate insulating film | BHF | BHF | BHF | BHF |
| | | Etchant for cleaning | ITO-06N | ITO-06N | ITO-06N | ITO-06N |
| | Film formation of ITO layer | Oxygen partial pressure at time of film formation [%] | 2.0 | 2.0 | - | 2.0 |
| | | Thickness [nm] | 2 | 2 | - | 2 |
| TFT production conditions | Low-resistance annealing | Highest temperature [°C] | 350 | 350 | - | - |
| | | Retention time [h] | 1 | 1 | - | - |
| | | Atmosphere | In atmosphere | In atmosphere | - | - |

(continued)

| | | | Example 1 | Example 2 | Comparative Example 1 | Comparative Example 2 |
|---|---|---|---|---|---|---|
| Film formation of interlayer insulating film | | Insulating film | $SiO_2$ | $SiO_2$ | $SiO_2$ | $SiO_2$ |
| | | Thickness [nm] | 150 | 150 | 150 | 150 |
| Formation of contact hole in interlayer insulating film | | Etchant | BHF | BHF | BHF | BHF |
| Formation of electrode | | Electrode | Mo | Mo | Mo | Mo |
| Final annealing | | Highest temperature [°C] | 300 | 300 | 300 | 300 |
| | | Retention time [h] | 1 | 1 | 1 | 1 |
| | | Atmosphere | $N_2$ | $N_2$ | $N_2$ | $N_2$ |
| Final shape | | L length [μm] | 10 | 10 | 10 | 10 |
| | | W length [μm] | 20 | 20 | 20 | 20 |
| | | Thickness of gate insulating film [nm] | 110 | 110 | 110 | 110 |
| | | 6 conditions for $L_{off}$ [μm] | 4, 6, 8, 10, 12, 14 | 4, 6, 8, 10, 12, 14 | 4,6,8,10,12,14 | 4, 6, 8, 10, 12, 14 |
| | | 6 conditions for Ls [μm] | 2, 4, 6, 8, 10, 12 | 2, 4, 6, 8, 10, 12 | 2, 4, 6, 8, 10, 12 | 2, 4, 6, 8, 10, 12 |

Example 2

A TFT was produced in the same manner as in Example 1 except that an oxide sputtering target obtained from a raw material mixture having a loaded composition ratio shown in Table 1 was used in (2) Formation of Oxide Thin Film in Example 1. In the following Examples and Comparative Examples, Step (7) Film Formation of Gate Insulating Film in Example 1 was not performed, and a gate insulating film having a thickness of 100 nm was formed in Step (5).

Example 3

A TFT was produced in the same manner as in Example 1 except that: an oxide sputtering target obtained from a raw material mixture having a loaded composition ratio shown in Table 3 was used and the atmosphere gas was set to a mixed gas of $Ar+O_2$ at the time of the film formation in (2) Formation of Oxide Thin Film in Example 1; and the formation conditions for each constituent layer were changed as shown in Tables 3 and 4.
The production conditions for the TFT are summarized in Tables 3 and 4.

Comparative Examples 3 to 5

TFTs were each produced in the same manner as in Example 3 except that the thickness of the oxide thin film in Example 3 was changed as shown in Table 3, and (9) Low-resistance Treatment was changed as shown in Table 4.
Table 3

| | | | Example 3 | Comparative Example 3 | Comparative Example 4 | Comparative Example 5 |
|---|---|---|---|---|---|---|
| Sputtering target | Loaded composition ratio [mass%] | $In_2O_3$ | 90.0 | 90.0 | 90.0 | 90.0 |
| | | $Ga_2O_3$ | 7.0 | 7.0 | 7.0 | 7.0 |
| | | $Sm_2O_3$ | 3.0 | 3.0 | 3.0 | 3.0 |
| | Metal composition ratio [at%] | In | 87.6 | 87.6 | 87.6 | 87.6 |
| | | Ga | 10.1 | 10.1 | 101 | 101 |
| | | Sm | 2.3 | 2.3 | 2.3 | 2.3 |
| TFT production conditions | Film formation of channel layer | Pressure at time of film formation [Pa] | 0.5 | 0.5 | 0.5 | 0.5 |
| | | Oxygen partial pressure at time of film formation [Pa] | 0.05 | 0.05 | 0.05 | 0.05 |
| | | Water partial pressure at time of film formation [Pa] | 0.00 | 0.00 | 0.00 | 0.00 |
| | | Magnetic flux density [G] | 1,000 | 1,000 | 1,000 | 1,000 |
| | | Thickness [nm] | 30 | 30 | 30 | 100 |
| | Patterning of channel layer | Semiconductor etching | Oxalic acid | Oxalic acid | Oxalic acid | Oxalic acid |
| | Annealing | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |
| | Film formation of gate insulating film | Gate insulating film | $SiO_2$ | $SiO_2$ | $SiO_2$ | $SiO_2$ |
| | | Thickness [nm] | 100 | 100 | 100 | 100 |
| | Annealing | Temperature increase pattern [°C/min] | 10 | 10 | 10 | 10 |
| | | Highest temperature [°C] | 400 | 400 | 400 | 400 |
| | | Retention time [h] | 1 | 1 | 1 | 1 |
| | | Atmosphere | Atmospheric | Atmospheric | Atmospheric | Atmospheric |

Table 4

| | | | Example 3 | Comparative Example 3 | Comparative Example 4 | Comparative Example 5 |
|---|---|---|---|---|---|---|
| TFT production conditions | Film formation of gate electrode | Gate electrode | Mo | Mo | Mo | Mo |
| | | Thickness [nm] | 150 | 150 | 150 | 150 |
| | Gate patterning | Etchant for gate electrode | PAN | PAN | PAN | PAN |
| | | Etchant for gate insulating film | BHF | BHF | BHF | BHF |
| | | Etchant for cleaning | ITO-06N | ITO-06N | ITO-06N | ITO-06N |
| | Film formation of ITO layer | Oxygen partial pressure at time of film formation [%] | 2.0 | - | 2.0 | 2.0 |
| | | Thickness [nm] | 2 | - | 2 | 2 |
| | Low-resistance annealing | Highest temperature [°C] | 350 | - | - | 350 |
| | | Retention time [h] | 1 | - | - | 1 |
| | | Atmosphere | In atmosphere | - | - | In atmosphere |
| | Film formation of interlayer insulating film | Insulating film | $SiO_2$ | SiO2 | SiO2 | SiO2 |
| | | Thickness [nm] | 150 | 150 | 150 | 150 |
| | Formation of contact hole in interlayer insulating film | Etchant | BHF | BHF | BHF | BHF |
| | Formation of electrode | Electrode | Mo | Mo | Mo | Mo |
| | | Resist | AZ5214 | AZ5214 | AZ5214 | AZ5214 |
| | Final annealing | Highest temperature [°C] | 200 | 200 | 200 | 200 |
| | | Retention time [h] | 1 | 1 | 1 | 1 |
| | | Atmosphere | N2 | N2 | N2 | N2 |

(continued)

|  |  |  | Example 3 | Comparative Example 3 | Comparative Example 4 | Comparative Example 5 |
|---|---|---|---|---|---|---|
| | Final shape | L length [$\mu$m] | 10 | 10 | 10 | 10 |
| | | W length [$\mu$m] | 20 | 20 | 20 | 20 |
| | | Thickness of gate insulating film [nm] | 100 | 100 | 100 | 100 |
| | | 6 conditions for $L_{off}$ [$\mu$m] | 4, 6, 8, 10, 12, 14 | 4, 6, 8, 10, 12, 14 | 4, 6, 8, 10, 12, 14 | 4, 6, 8, 10, 12, 14 |
| | | 6 conditions for Ls [$\mu$m] | 2, 4, 6, 8, 10, 12 | 2, 4, 6, 8, 10, 12 | 2, 4, 6, 8, 10, 12 | 2, 4, 6, 8, 10, 12 |

Example 4 and Comparative Examples 6 to 9

TFTs were each produced in the same manner as in Example 1 except that: an oxide sputtering target obtained from a raw material mixture having a loaded composition ratio shown in Table 5 was used in (2) Formation of Oxide Thin Film in Example 1; and the formation conditions for each constituent layer were changed as shown in Tables 5 and 6.
The production conditions for the TFT are summarized in Table 5 and 6.

Table 5

| | | | Example 4 | Comparative Example 6 | Comparative Example 7 | Comparative Example 8 | Comparative Example 9 |
|---|---|---|---|---|---|---|---|
| Sputtering target | Loaded composition ratio [mass%] | $In_2O_3$ | 89.0 | 89.0 | 89.0 | 89.0 | 89.0 |
| | | $Ga_2O_3$ | 9.8 | 9.8 | 9.8 | 9.8 | 9.8 |
| | | $Al_2O_3$ | 1.3 | 1.3 | 1.3 | 1.3 | 1.3 |
| | Metal composition ratio [at%] | In | 83.3 | 83.3 | 83.3 | 83.3 | 83.3 |
| | | Ga | 13.5 | 13.5 | 13.5 | 13.5 | 13.5 |
| | | Al | 3.2 | 3.2 | 3.2 | 3.2 | 3.2 |
| TFT production conditions | Film formation of channel layer | Pressure at time of film formation [Pa] | 0.5 | 0.5 | 0.5 | 0.5 | 0.5 |
| | | Oxygen partial pressure at time of film formation [Pa] | 0.05 | 0.05 | 0.05 | 0.25 | 0.05 |
| | | Water partial pressure at time of film formation [Pa] | 0.00 | 0.00 | 0.00 | 0.00 | 0.01 |
| | | Magnetic flux density [G] | 1,000 | 1,000 | 1,000 | 1,000 | 1,000 |
| | | Thickness [nm] | 30 | 30 | 30 | 100 | 30 |
| | Patterning of channel layer | Semiconductor etching | Oxalic acid | Oxalic acid | Oxalic acid | Oxalic acid | Oxalic acid |
| | Annealing | Temperature increase pattern [°C/min] | 10 | 10 | 10 | 10 | 1 |
| | | Highest temperature [°C] | 350 | 350 | 350 | 350 | 350 |
| | | Retention time [h] | 1 | 1 | 1 | 1 | 10 |
| | | Atmosphere | Atmospheric | Atmospheric | Atmospheric | Atmospheric | Atmospheric |

(continued)

| | | | Example 4 | Comparative Example 6 | Comparative Example 7 | Comparative Example 8 | Comparative Example 9 |
|---|---|---|---|---|---|---|---|
| | Film formation of gate insulating film | Gate insulating film | SiO$_2$ | SiO$_2$ | SiO$_2$ | SiO$_2$ | SiO$_2$ |
| | | Thickness [nm] | 100 | 100 | 100 | 100 | 100 |
| | Annealing | Temperature increase pattern [°C/min] | 10 | 10 | 10 | 10 | 10 |
| | | Highest temperature[°C] | 400 | 400 | 400 | 400 | 400 |
| | | Retention time [h] | 1 | 1 | 1 | 1 | 1 |
| | | Atmosphere | Atmospheric | Atmospheric | Atmospheric | Atmospheric | Atmospheric |

Table 6

| | | | Example 4 | Comparative Example 6 | Comparative Example 7 | Comparative Example 8 | Comparative Example 9 |
|---|---|---|---|---|---|---|---|
| TFT production conditions | Film formation of gate electrode | Gate electrode | Mo | Mo | Mo | Mo | Mo |
| | | Thickness [nm] | 150 | 150 | 150 | 150 | 150 |
| | Gate patterning | Etchant for gate electrode | PAN | PAN | PAN | PAN | PAN |
| | | Etchant for gate insulating film | BHF | BHF | BHF | BHF | BHF |
| | | Etchant for cleaning | ITO-06N | ITO-06N | ITO-06N | ITO-06N | ITO-06N |
| | Film formation of ITO layer | Oxygen partial pressure at time of film formation [%] | 20 | - | 20 | 2.0 | 2.0 |
| | | Thickness [nm] | 2 | - | 2 | 2 | 2 |
| | Low-resistance annealing | Highest temperature [°C] | 350 | - | - | 350 | 350 |
| | | Retention time [h] | 1 | - | - | 1 | 1 |
| | | Atmosphere | In atmosphere | - | - | In atmosphere | In atmosphere |
| | Film formation of interlayer insulating film | Insulating film | SiO$_2$ | SiO2 | SiO2 | SiO2 | SiO2 |
| | | Thickness [nm] | 150 | 150 | 150 | 150 | 150 |
| | Formation of contact hole in interlayer insulating film | Etchant | BHF | BHF | BHF | BHF | BHF |
| | Formation of electrode | Electrode | Mo | Mo | Mo | Mo | Mo |
| | | Resist | AZ5214 | AZ5214 | AZ5214 | AZ5214 | AZ5214 |
| | | Highest temperature [°C] | 200 | 200 | 200 | 200 | 200 |
| | Final annealing | Retention time [h] | 1 | 1 | 1 | 1 | 1 |
| | | Atmosphere | N2 | N2 | N2 | N2 | N2 |

| | | | Example 4 | Comparative Example 6 | Comparative Example 7 | Comparative Example 8 | Comparative Example 9 |
|---|---|---|---|---|---|---|---|
| Final shape | | L length [$\mu$m] | 10 | 10 | 10 | 10 | 10 |
| | | W length [$\mu$m] | 20 | 20 | 20 | 20 | 20 |
| | | Thickness of gate insulating film [nm] | 100 | 100 | 100 | 100 | 100 |
| | | 6 conditions for $L_{off}$ [$\mu$m] | 4, 6, 8, 10, 12, 14 | 4, 6, 8, 10, 12, 14 | 4, 6, 8, 10, 12, 14 | 4, 6, 8, 10, 12, 14 | 4, 6, 8, 10, 12, 14 |
| | | 6 conditions for Ls [$\mu$m] | 2, 4, 6, 8, 10, 12 | 2, 4, 6, 8, 10, 12 | 2, 4, 6, 8, 10, 12 | 2, 4, 6, 8, 10, 12 | 2, 4, 6, 8, 10, 12 |

The TFTs obtained in Examples and Comparative Examples were evaluated as descibed below. The results are shown in Table 7 to 9. In the tables, "E+XX" means "x10$^{XX}$".

(A) Evaluation regarding Channel Layer (Crystalline Oxide Thin Film) of TFT

(1) State of Channel Layer after Production of TFT

The crystal state of the cross-section of the channel layer in the TFT was evaluated for (a) an average grain boundary angle θ with respect to the surface of the thin film, (b) an average grain boundary angle $θ_{sub}$ with respect to a lower layer, (c) an average spacing D between crystal grain boundaries, and (d) a crystal state by pretreating the channel layer through use of a focused ion beam (FIB) device and observing the cross-section of the channel layer with a transmission electron microscope (TEM).

Specifically, first, an ion beam was applied in a direction perpendicular to the surface of the channel layer through use of a FIB ("Model FB2100" manufactured by Hitachi High-Technologies Corporation) device, and a test piece having a size of 16 μm×4 μm was sampled. After that, in the sampled test piece, two samples were extracted for a region of 3 μm from an end of a region in which the source electrode or the drain electrode, and the channel layer overlapped each other in a channel length direction (horizontal direction in the drawings) toward a region in which the source electrode or the drain electrode, and the channel layer did not overlap each other. The two extracted samples were each subjected to Ar ion milling until the thickness of a thin section reached about 100 nm in a channel width direction (depth direction in the drawings) perpendicular to the channel length direction and a thickness direction. Thus, the thickness of each of the two extracted samples was reduced. When no crystal grains were able to be observed owing to ion sputtering damage at the time of FIB processing, etching was repeatedly performed at an ion gun voltage of 4 keV in Ar ion milling ("Model 691" manufactured by Gatan, Inc.) until crystal grains were able to be observed.

An image having an observation magnification of 100,000 times (about 4 μm square area) was observed as a cross-sectional TEM image through use of a transmission electron microscope ("Model JEM-2800" manufactured by JEOL Ltd.) at an acceleration voltage of 200 kV.

(a) Average Grain Boundary Angle θ with respect to Surface of Thin Film

When the cross-section of the channel layer (crystalline oxide thin film) is observed, the average grain boundary angle θ with respect to the surface of the thin film may be calculated by analyzing angles formed by crystal grain boundaries observed by cross-sectional TEM and the surface of the thin film. In an image (channel length direction×thickness direction=4 μm square) observed at an observation magnification of 100,000 times, arbitrary three fields of view were each extracted so as to include the crystalline oxide films of areas of Ls, $L_{off}$, and L in the channel length direction in the TFT, and were observed.

In addition, when crystal grains were so large that grain boundaries could not be observed, a plurality of fields of view was extracted so that observation points did not overlap each other in the channel length direction in such a manner that the entire channel layer in the TFT was able to be observed in a range satisfying the relationship of channel length direction×thickness direction=4 μm square, and cross-sectional TEM images were observed.

The cross-sectional TEM image in each of the resultant fields of view was subjected to image analysis through use of "SPIP, Version 4.3.2.0" manufactured by Image Metrology. Thus, the angles formed by the surface of the thin film and the crystal grain boundaries were calculated. The details thereof are as described below.

In the cross-sectional TEM image, lines of color codes H0, S0, and V10 are drawn at the crystal grain boundaries in the observed image of the crystalline oxide thin film. Further, a contrast was quantified with image analysis software, and a height of (maximum density-minimum density)×¼ was set as a threshold value. Next, a region showing a contrast equal to or less than the threshold value was defined as the crystal grain boundary, and the angles each formed by the surfaces of the thin films and the crystal grain boundaries were determined. The total of the resultant angles each formed by the surfaces of the thin films and the crystal grain boundaries was divided by the number of grains, and the average of the angles determined each in all the resultant fields of view was defined as the average grain boundary angle θ with respect to the surface of the thin film.

(b) Average Grain Boundary Angle $θ_{sub}$ with respect to Lower Layer

A crystal grain boundary was extracted by the same cross-sectional TEM image and analysis method as those for the average grain boundary angle θ with respect to the surface of the thin film, and the angle formed with respect to the lower layer was determined. The total of the resultant angles each formed by the surfaces of the lower layers and the crystal grain boundaries was divided by the number of grains, and the average of the angles determined each in all the resultant fields of view was defined as the average grain boundary angle $θ_{sub}$ with respect to the surface of the lower layer.

(c) Average Spacing D Between Crystal Grain Boundaries

An average spacing D at the time of the observation of the cross-section of the oxide thin film may be calculated by analyzing spacings between crystal grains observed by the cross-sectional TEM. Arbitrary three fields of view were each extracted so as to include the crystalline oxide films of areas of Ls, $L_{off}$, and L in the channel length direction in the TFT, and were observed at an observation magnification of 100,000 times (channel length direction×thickness direction=4 $\mu$m square).

In addition, when crystal grains were so large that grain boundaries could not be observed, a plurality of fields of view was extracted so that observation points did not overlap each other in the channel length direction in such a manner that the entire channel layer in the thin film transistor was able to be observed in a range satisfying the relationship of channel length direction×thickness direction=4 $\mu$m square, and cross-sectional TEM images were observed.

The average spacing D between crystal grain boundaries was calculated by performing image analysis on the resultant cross-sectional TEM images each in the fields of view with "SPIP, Version 4.3.2.0" manufactured by Image Metrology. Details are as described below.

In the cross-sectional TEM images, lines of color codes H0, S0, and V10 are drawn at the crystal grain boundaries. Further, a contrast was quantified with image analysis software, and a height of (maximum density-minimum density)×¼ was set as a threshold value. Next, a region showing a contrast equal to or less than the threshold value was defined as the crystal grain boundary, and a spacing between each crystal grain boundary and the closest grain was determined and defined as the spacing between crystal grain boundaries. The total of the resultant spacings each between the crystal grain boundaries divided by the number of points where the spacings were measured was defined as the average spacing between crystal grain boundaries. The average of the average spacings between the crystal grain boundaries each obtained in all the fields of view was determined as D.

(d) Crystal State

A method for determining the crystal state was performed by observing an electron beam diffraction pattern on a sample obtained by observing a cross-sectional TEM image.

Specifically, through use of an electron microscope ("Model JEM-2800" manufactured by JEOL Ltd.), the oxide thin film area observed in the cross-sectional TEM image was irradiated with an electron beam at an irradiation area of about 100 nm$\varphi$ and an acceleration voltage of 200 kV by selected-area aperture, and a diffraction pattern was measured with a camera length set to 2 m. An oxide thin film in which no clear diffraction spot was obtained in arbitrary three fields of view extracted so that the observation points did not overlap each other in the channel length direction in the cross-sectional TEM image sample was determined to be "amorphous". Meanwhile, an oxide thin film in which diffraction points with symmetry were observed from the diffraction pattern was determined to be "crystal". Further, an oxide thin film observed from the same diffraction pattern in the arbitrary three fields of view extracted so that the observation points did not overlap each other in the thickness direction was determined to be "columnar crystal".

(2) Method of measuring Spread Resistance of Cross-section of Oxide Thin Film with SSRM

The spread resistance of each of the low-resistance region A and high-resistance region B of the channel layer may be determined by spread resistance microscope (scanning spread resistance microscope: SSRM) measurement. A device and measurement conditions are described below.

Device: NanoScope IVa AFM Dimension 3100 Stage AFM System+SSRM Option manufactured by BrukerAXS (former Veeco), Digital Instruments Division
SSRM scanning mode: contact mode and spread resistance simultaneous measurement
SSRM probe (Tip): p-type semiconductor diamond-coated silicon cantilever

Sample processing: After the production of a cross-section by mechanical polishing, each layer was short-circuited so that a bias voltage was able to be applied. Further, a DC bias voltage of -3.0 V was applied to a sample to perform measurement.
Measurement environment: room temperature in the atmosphere

(a) Spread Resistances $R_A$ and $R_B$

A cross-section of the channel layer measuring 1 $\mu$m in the thickness direction by 4 $\mu$m in the channel length direction was extracted so as to include the gate electrode layer, the gate insulating film layer, the low-resistance region A, and the high-resistance region B, and the cross-section was subjected to underwater mechanical polishing to provide an observation cross-section. Subsequently, the spread resistance of the cross-section was measured with the SSRM. The line profile of the spread resistance value was measured while the cantilever was moved by 7.8 nm each in parallel to the channel length direction with respect to the channel region. The minimum value of the spread resistance in the low-resistance region A was defined as the "spread resistance value $R_A$ of the low-resistance region A", and the maximum value of the spread resistance in the high-resistance region B was defined as the "spread resistance value $R_B$ of the high-resistance region B".

(b) Spread Resistances Rs(L), Rs($L_{off}$), and Rs(Ls)

A cross-section of the channel layer of the TFT was extracted so as to include an $L_{off}$ region and a region L in contact with the lower surface of the gate insulating film, and the cross-section was subjected to underwater mechanical polishing to provide an observation cross-section. Subsequently, the spread resistance of the cross-section was measured with the SSRM. The line profile of the spread resistance value was measured while the cantilever was moved by 7.8 nm each in parallel to the channel length direction in the region L. The minimum value of the spread resistance in the $L_{off}$ region was defined as "Rs($L_{off}$)1", and the maximum value of the spread resistance in L was defined as "Rs(L)".
In addition, a cross-section of the channel layer of the TFT was extracted so as to include the $L_{off}$ region and a region Ls in contact with the source electrode or the drain electrode, and the cross-section was subjected to underwater mechanical polishing to provide an observation cross-section. The line profile of the spread resistance value was measured while the cantilever was moved by 7.8 nm each with respect to the region L. The minimum value of the spread resistance in the $L_{off}$ region was defined as "Rs($L_{off}$)2", and the minimum value of the spread resistance in Ls was defined as "Rs(Ls)".
Rs($L_{off}$) was defined as an average of the Rs($L_{off}$)1 and the Rs($L_{off}$)2.

(c) Measurement of Gap $\Delta L$ in Horizontal Direction between Low-resistance Region A and Gate Electrode

A height image of an AFM mode cross-section was measured through use of the same device as that in the SSRM measurement with respect to a cross-section subjected to underwater mechanical polishing to provide an observation cross-section. The line profile of the height image was measured while the cantilever was moved by 7.8 nm each in a horizontal direction with respect to the surface of the gate electrode so as to include the interlayer insulating film layer adjacent to the gate electrode layer, and the position at which the height was steeply changed was defined as the end portion in the horizontal direction of the gate electrode. Next, the profile of the spread resistance $R_A$ evaluated with the SSRM in the channel length direction was compared to the profile thereof in the horizontal direction with respect to the surface of the gate electrode of the gate electrode, and the difference each between the end portions was defined as $\Delta L$. The case in which the $\Delta L$ is positive means that there is a gap between the low-resistance region A and the gate electrode in the horizontal direction. The case in which the $\Delta L$ is 0 means that there is no gap. Further, the case in which the $\Delta L$ is negative means that the end portion of the gate electrode and the low-resistance region A overlap each other in the horizontal direction.

(3) Scanning Capacitance Microscope (SCM) Measurement

The voltage change (dC/dV) of the capacitance of each of the low-resistance region A and high-resistance region B of the channel layer may be determined by scanning capacitance microscope (scanning capacitance microscopy: SCM) measurement. A device used and measurement conditions are described below.

Observation device: NanoScope IVa AFM Dimension 3100 Stage AFM System+SCM Option manufactured by BrukerAXS (former Veeco), Digital Instruments Division

SCM scanning mode: contact mode and X-Y mode dC/dV signal simultaneous measurement
SCM probe (Tip): Ptlr-coated silicon cantilever

Sample processing: After the production of a cross-section by mechanical polishing, each layer was short-circuited so that a bias voltage was able to be applied. Further, a modulation voltage of 4.0 V and a DC bias voltage of 0 V were applied to a sample to perform measurement.

Measurement environment: room temperature in the atmosphere

(a) Magnitude Relationship between dC/dV(A-B) and dC/dV(B)

A cross-section of the channel layer measuring 1.25 $\mu$m in the thickness direction by 10 $\mu$m in the plane direction was extracted so as to include the low-resistance region A and the high-resistance region B, and was subjected to underwater mechanical polishing to provide an observation cross-section. Subsequently, a signal of the voltage change (dC/dV) of the capacitance of the cross-section was obtained with a SCM. The line profile of the dC/dV was measured while the cantilever was moved by 19.6 nm each with respect to the channel region, and a magnitude relationship between the minimum value of dC/dV(B) in the high-resistance region B and dC/dV(A-B) at the boundary between the low-resistance region A and the high-resistance region B was evaluated.

(4) Identification of Crystal Structure by Electron Beam Diffraction

Whether or not the crystal structure of the oxide thin film was a bixbyite structure was evaluated by observing the electron beam diffraction pattern of the sample obtained by observing the cross-sectional TEM image.
Specifically, an oxide thin film area observed in the cross-sectional TEM image was irradiated with an electron beam at an irradiation area of about 100 nm$\varphi$ and an acceleration voltage of 200 kV with a selected area aperture through use of an electron microscope ("Model JEM-2800" manufactured by JEOL Ltd.), and the diffraction pattern was measured with a camera length set to 2 m.
Further, in order to identify the crystal structure, the electron beam diffraction pattern simulation of the bixbyite structure of $In_2O_3$ was performed with electron beam diffraction simulation software ReciPro (free software ver 4.641 (2019/03/04)). In the simulation, for the crystal structure data of the bixbyite structure, 14388 of Inorganic Crystal Structure Database (ICSD: Japan Association for International Chemical Information) was used, and a space group of la-3, a lattice constant of a=10.17700 Å, and the atomic coordinates of an In site (0.250, 0.250, 0.250), an In site (0.466, 0.000, 0.250), and an O site (0.391, 0.156, 0.380) were used.
Further, the simulation was performed with a camera length of 2 m and 11 kinds of reciprocal lattice vectors (1 0 0), (1 1 1), (1 1 0), (2 1 1), (3 1 1), (2 2 1), (3 3 1), (2 1 0), (3 1 0), (3 2 1), and (2 3 0) as incident electron beam directions.
The results of the diffraction points of the electron beam diffraction pattern of the oxide thin film were compared to those of the resultant simulation pattern. When the result matched any one of the 11 kinds of simulation patterns, it was judged that the oxide thin film contained crystal grains each having the bixbyite structure.

(B) Evaluation regarding Performance of TFT

The resultant TFT was measured with a semiconductor parameter analyzer ("B1500" manufactured by Agilent) at room temperature under a light-shielding environment (inside a shield box). A drain voltage (Vd) of 0.1 V or 20 V was applied. A current value Id was measured at a gate voltage (Vg) of from -5 V to 20 V in increments of 0.2 V for the application of each Vd. Thus, Id-Vg characteristics were obtained.
Various parameters calculated from the Id-Vg characteristics are shown in Tables 7, 8, and 9. A calculation method for each parameter is as described below.

(a) Maximum Value of Linear Mobility ($\mu$lin Max)

The maximum value of a linear mobility at the time of the application of a Vd of 0.1 V was determined by creating a graph of Id-Vg characteristics, calculating a transconductance (Gm) at each Vg, and deriving the linear mobility ($\mu$lin) through use of the formula of a linear region. Specifically, the Gm was calculated by $\partial(Id)/\partial(Vg)$. Further, the $\mu$lin was calculated by the formula (b) of a linear region.

$$\mu lin = (Gm{\cdot}L)/(W{\cdot}Ci{\cdot}Vd) \cdots (b)$$

Ci in the formula (b) was the capacitance of the gate insulating film, and a value of Ci [F/cm$^2$] calculated based on the thickness of the gate insulating film in the final shape shown in Tables 2, 4, and 6, a specific dielectric constant of SiOz of 3.9, and a vacuum dielectric constant of $8.85{\times}10^{-14}$ [F/cm] was used.
L in the formula (b) is the channel length (L length), and W is the channel width (W length).
The maximum value of the $\mu$lin at a Vg of from 0 V to 20 V was calculated from each Vg-$\mu$lin graph, and was defined as the maximum value of the linear mobility "$\mu$lin Max". Tables 7 to 9 show values of TFTs each having $L_{off}$ of 4 $\mu$m and an Ls of 2 $\mu$m.

(b) Variation in Linear Mobility ($\Delta\mu$lin) of TFT

In each of the 36 TFT devices different from each other in $L_{off}$ and Ls (conditions: 6 conditions for $L_{off}$ [$\mu$m]$\times$6 conditions for Ls [$\mu$m]) produced in Examples and Comparative Examples, the maximum value of the linear mobility was calculated by the method described in the above-mentioned section (a). The range of variation in maximum value of the linear mobility of the 36 devices was defined as "variation in linear mobility ($\Delta\mu$lin) of the 36 devices".

(c) Maximum Value of Saturation Mobility ($\mu$sat Max)

For the maximum value of a saturation mobility at the time of the application of a Vd of 20 V, a graph of Id-Vg characteristics was created, a transconductance (Gm) at each Vg was calculated, and the saturation mobility ($\mu$sat) was derived with the formula of a saturation region. Specifically, the Gm was calculated by the following mathematical formula (c1).

$$Gm = \partial \left( \sqrt{Id} \right) / \partial (Vg) \qquad (c1)$$

Further, the $\mu$sat was calculated by the following formula (c) of the saturation region.

$$\mu sat = (2 \cdot Gm \cdot L)/(W \cdot Ci) \cdots (c)$$

In the formula (c), L represents the channel length (L length), and W represents the channel width (W length).
Further, the maximum value of the $\mu$sat at a Vg of from 0 V to 20 V was calculated from each Vg-$\mu$sat graph and defined as "$\mu$sat Max". Tables 7 to 9 show values of TFTs each having an $L_{off}$ of 4 $\mu$m and an Ls of 2 $\mu$m.

(d) Variation in Linear Mobility $\Delta\mu$sat of TFT

In each of the 36 kinds of TFTs different from each other in $L_{off}$ and Ls produced in Examples and Comparative Examples, the maximum value of the saturation mobility was calculated by the method described in the above-mentioned section (c). The range of variation in maximum value of the linear mobility of the 36 devices was defined as "variation in saturation mobility ($\Delta\mu$sat) of the 36 devices".

(e) S Value and Vth

An S value and a threshold voltage (Vth) were evaluated from each graph of Id-Vg characteristics. Specifically, in a region at a current value Id of from $10^{-11}$ to $10^{-10}$ [A], a value determined by the following formula (d) was calculated as the S value. Further, a value of Vg at a current value Id of $10^{-8}$ [A] was calculated as the threshold voltage (Vth). Tables 7 to 9 show values of TFTs each having an $L_{off}$ of 4 $\mu$m and an Ls of 2 $\mu$m.

$$S = \frac{\Delta Vg}{\Delta(\log Id)} \qquad (d)$$

(f) Vth Variation $\Delta$Vth

In each of the 36 kinds of TFTs different from each other in $L_{off}$ and Ls produced in Examples and Comparative Examples, the Vth was calculated by the method described in the above-mentioned section (e). The range of variation in maximum value of the linear mobility of the 36 devices was defined as "variation in linear mobility ($\Delta$Vth) of the 36 devices".

Table 7

| | | | Example 1 | Example 2 | Comparative Example 1 | Comparative Example 2 |
|---|---|---|---|---|---|---|
| Evaluation of channel layer | Cross-sectional TEM image | Average orain boundary anale $\theta$ [°] | 98.6 | 92.2 | 98.6 | 98.6 |
| | | Average orain boundary anale $\theta$ sub [°] | 98.6 | 92.2 | 98.6 | 98.6 |
| | | Average spacing D between crystal grain boundaries [$\mu$m] | 2.0 | 1.9 | 2.0 | 2.0 |
| | | $L_{off}$/D | 2.0, 3.0, 4.0, 5.0, 6.0, 7.0 | 2.1, 3.2, 4.2, 5.3, 6.3, 7.4 | 2.0, 3.0, 4.0, 5.0, 6.0, 7.0 | 2.0, 3.0, 4.0, 5.0, 6.0, 7.0 |
| | | $L_s$/D | 1.0, 2.0, 3.0, 4.0, 5.0, 6.0 | 1.1, 2.1, 3.2, 4.2, 5.3, 6.3 | 1.0, 2.0, 3.0, 4.0, 5.0, 6.0 | 1.0, 2.0, 3.0, 4.0, 5.0, 6.0 |
| | | Crystal state | Columnar crystal | Columnar crystal | Columnar crystal | Columnar crystal |
| | SSRM Spread resistance value evaluation | Low-resistance region A $R_A$ [$\Omega$] | 1.4E+05 | 1.1E+05 | 2.3E+06 | 1.9E+06 |
| | | High-resistance region B $R_B$ [$\Omega$] | 2.3E+06 | 2.0E+06 | 2.3E+06 | 2.3E+06 |
| | | $R_B$/$R_A$ | 17 | 18 | 1 | 1 |
| | | Rs(L) | 2.3E+06 | 2.0E+06 | 2.3E+06 | 2.3E+06 |
| | | Rs($L_{off}$) | 1.4E+05 | 1.4E+05 | 2.3E+06 | 1.0E+07 |
| | | Rs(Ls) | 1.4E+05 | 1.2E+05 | 2.3E+06 | 1.4E+06 |
| | | Rs(L)/Rs($L_{off}$) | 16 | 15 | 1 | 0 |
| | | Rs(L)/Rs(Ls) | 16 | 17 | 1 | 2 |
| | | $\Delta$L [$\mu$m] | -0.3 | -0.4 | Unmeasurable because of no difference between $R_A$ and $R_B$ | 2.8 |
| | SCM dC/dV evaluation | Magnitudes of boundary region (A-B) and region (B) | (A-B)>(B) | (A-B)>(B) | (A-B)=(B) | (A-B)<(B) |
| | Electron beam diffraction | Crystal structure | Bixbyite | Bixbyite | Bixbyite | Bixbyite |

(continued)

| | | | Example 1 | Example 2 | Comparative Example 1 | Comparative Example 2 |
|---|---|---|---|---|---|---|
| Performance ofTFT | Vd=0.1 V | ulin Max [cm2/(V·s)] | 40.3 | 40.5 | No ON/OFF Insulating behavior | 18.9 |
| | | $\Delta$ulin [cm2/(V·s)] | 1.1 | 1.4 | | 5.1 |
| | | S value [V/decade] | 0.4 | 0.5 | | 1.1 |
| | | Vth [V] | 0.2 | 0.1 | | -2.3 |
| | | $\Delta$Vth | 0.5 | 0.6 | | 2.2 |
| | Vd=20 V | usat Max [cm2/(V·s)] | 38.6 | 39.2 | No ON/OFF Insulating behavior | 17.1 |
| | | $\Delta$usat [cm2/(V·s)] | 1 | 1.2 | | 5.8 |
| | | S value [V/decade] | 0.4 | 0.5 | | 1.23 |
| | | Vth [V] | 0.2 | 0.1 | | -6.7 |
| | | $\Delta$Vth | 0.5 | 0.6 | | 3.4 |
| | Presence or absence of DIBL phenomenon | | Absent | Absent | No ON/OFF | Present |

Table 8

| | | | Example 3 | Comparative Example 3 | Comparative Example 4 | Comparative Example 5 |
|---|---|---|---|---|---|---|
| Cross-sectional TEM image | | Average arain boundary angle $\theta$ [°] | 104 | 104 | 104 | Unmeasurable because of two-phase |
| | | Averaae arain boundary anale $\theta$sub [°] | 104 | 104 | 104 | |
| | | Average spacing D between crystal grain boundaries [$\mu$m] | 0.23 | 023 | 0.23 | |
| | | $L_{off}$/D | 19, 28, 37, 46, 56, 64 | 19, 28, 37, 46, 56, 64 | 19, 28, 37, 46, 56, 64 | |
| | | $L_s$/D | 9, 19, 28, 37, 46, 56 | 9, 19, 28, 37, 46, 56 | 9, 19, 28, 37, 46, 56 | |
| | | Crystal state | Columnar crystal | Columnar crystal | Columnar crystal | Two-layer crystallization in thickness direction |

(continued)

| | | | Example 3 | Comparative Example 3 | Comparative Example 4 | Comparative Example 5 |
|---|---|---|---|---|---|---|
| Evaluation of channel layer | SSRM Spread resistance value evaluation | Low-resistance region A $R_A$ [$\Omega$] | 1.1E+05 | 2.5E+06 | 9.1E+05 | 1.6E+05 |
| | | High-resistance region B $R_B$ [$\Omega$] | 2.5E+06 | 2.5E+06 | 2.5E+06 | 1.8E+05 |
| | | $R_B/R_A$ | 23 | 1 | 3 | 1 |
| | | Rs(L) | 2.5E+06 | 2.5E+06 | 2.5E+06 | 1.8E+05 |
| | | Rs($L_{off}$) | 1.9E+05 | 2.5E+06 | 8.4E+05 | 1.6E+05 |
| | | Rs(Ls) | 1.1E+05 | 2.4E+06 | 9.1E+05 | 1.6E+05 |
| | | Rs(L)/Rs($L_{off}$) | 13 | 1 | 3 | 1 |
| | | Rs(L)/Rs(Ls) | 21 | 1 | 3 | 1 |
| | | $\Delta L$ [$\mu$m] | -0.8 | Unmeasurable because of no difference between $R_A$ and $R_B$ | 3.0 | Unmeasurable because of no difference between $R_A$ and $R_B$ |
| | SCM dC/dV evaluation | Magnitudes of boundary region (A-B) and region (B) | (A-B)>(B) | (A-B)=(B) | (A-B)>(B) | (A-B)=(B) |
| | Electron beam diffraction | Crystal structure | Bixbyite | Bixbyite | Bixbyite | Bixbyite |
| Performance of TFT | Vd=0.1 V | ulin Max [cm2/(V·s)] | 32.2 | No ON/OFF Insulating behavior | 13.4 | No ON/OFF Leakage |
| | | $\Delta\mu$lin [cm2/(V·s)] | 1.4 | | 6.2 | |
| | | S value [V/decade] | 0.5 | | 1.28 | |
| | | Vth [V] | 0.2 | | -5.3 | |
| | | $\Delta$Vth | 0.1 | | 3.2 | |
| | Vd=20 V | usat Max [cm2/(V·s)] | 29.0 | No ON/OFF Insulating behavior | 9.2 | No ON/OFF Leakage |
| | | $\Delta\mu$sat [cm2/(V·s)] | 1.8 | | 5.8 | |
| | | S value [V/decade] | 0.6 | | 1.67 | |
| | | Vth [V] | 0.2 | | -9.2 | |
| | | $\Delta$Vth | 0.1 | | 4.8 | |
| | Presence or absence of DIBL phenomenon | | Absent | No ON/OFF | Present | No ON/OFF |

Table 9

| | | Example 4 | Comparative Example 6 | Comparative Example 7 | Comparative Example 8 | Comparative Example 9 |
|---|---|---|---|---|---|---|
| Cross-sectional TEM image | Average grain boundary angle θ [°] | 93.2 | 932 | 932 | Unmeasurable because of two-phase | 99.6 |
| | Average grain boundary angle θsub [°] | 93.2 | 93.2 | 93.2 | | 99.6 |
| | Average spacing D between crystal grain boundaries [μm] | 0.87 | 0.87 | 0.87 | | 7.9 |
| | $L_{off}/D$ | 4.6, 6.9, 9.2, 12, 14, 16 | 4.6, 6.9, 9.2, 12, 14, 16 | 4.6, 6.9, 9.2, 12, 14, 16 | | 0.5, 0.8, 1.0, 1.3, 1.5, 1.8 |
| | $L_s/D$ | 2.3, 4.6, 6.9, 9.2, 12, 14 | 2.3, 4.6, 6.9, 9.2, 12, 14 | 2.3, 4.8, 8.9, 9.2, 12, 14 | | 0.3, 0.5, 0.8, 1.0, 1.3, 1.5 |
| | Crystal state | Columnar crystal | Columnar crystal | Columnar crystal | Two-layer crystallization in thickness direction | Columnar crystal |
| SSRM Spread resistance value evaluation | Low-resistance region A $R_A$ [Ω] | 1.7E+04 | 3.9E+05 | 2.7E+05 | 1.0E+04 | 1.2E+06 |
| | High-resistance region B $R_B$ [Ω] | 3.9E+05 | 3.9E+05 | 3.9E+05 | 1.1E+04 | 4.9E+06 |
| | $R_B/R_A$ | 23 | 1 | 1 | 1 | 4 |
| | Rs(L) | 3.9E+05 | 3.9E+05 | 3.9E+05 | 1.1E+04 | 4.9E+06 |
| | Rs($L_{off}$) | 1.6E+04 | 3.9E+05 | 4.5E+05 | 1.2E+04 | 1.1E+06 |
| | Rs(Ls) | 1.7E+04 | 3.9E+05 | 2.7E+05 | 1.0E+04 | 1.6E+06 |
| | Rs(L)/Rs($L_{off}$) | 24 | 1.0 | 0.9 | 0.9 | 4 |
| | Rs(L)/Rs(Ls) | 23 | 1.0 | 1.5 | 1.1 | 3 |
| Evaluation of channel layer | ΔL [μm] | -0.2 | Unmeasurable because of no difference between $R_A$ and $R_B$ | 2.0 | Unmeasurable because of no difference between $R_A$ and $R_B$ | 2.8 |

(continued)

| | | Example 4 | Comparative Example 6 | Comparative Example 7 | Comparative Example 8 | Comparative Example 9 |
|---|---|---|---|---|---|---|
| SCM- dC/dV evaluation | Magnitudes of boundary region (A-B) and region (R) | (A-B)>(B) | (A-B)=(B) | (A-B)<(B) | (A-B)=(B) | (A-B)>(B) |
| Electron beam diffraction | Crystal structure | Bixbyite | Bixbyite | Bixbyite | Bixbyite | Bixbyite |
| Vd=0.1 V | ulin Max [cm2/(V·s)] | 34.0 | No ON/OFF Insulating behavior | 28.5 | No ON/OFF Leakage | 11.3 |
| | Δμlin [cm2/(V·s)) | 1.6 | | 9.5 | | 5.2 |
| | S value [V/decade] | 0.4 | | 1.4 | | 1.8 |
| | Vth [V] | 0.1 | | -5.2 | | 3.6 |
| | ΔVth | 0.1 | | 6.2 | | 2.8 |
| Vd=20 V | usat Max [cm2/(V·s)] | 29.5 | No ON/OFF Insulating behavior | 22.0 | No ON/OFF Leakage | 5.9 |
| | Δμsat [cm2/(V·s)] | 0.5 | | 7.9 | | 5 |
| | S value [V/decade] | 0.4 | | 1.8 | | 1.92 |
| | Vth [V] | 0.1 | | -10.1 | | 3.9 |
| | ΔVth | 0.05 | | 8.9 | | 3.5 |
| Performance of TFT | Presence or absence of DIBL phenomenon | Absent | No ON/OFF | Present | No ON/OFF | Absent |

[Formation of Cryztalline Oxide Thin Film

In each of Examples 5 to 8, a laminate in which only the crystalline oxide thin film was formed on the substrate was produced under the same conditions as those for the channel layer of the TFT prodused in each of Examples 1 to 4, and the laminate was evaluated.

Example 5

(1) Formation of Oxide Thin Film

An oxide thin film having a thickness of 10 nm was formed on an alkali-free glass substrate (EAGLE XG manufactured by Corning Incorporated) having a diameter of 4 inches by sputtering through use of a sputtering target obtained from a raw material mixture having a loaded composition ratio shown in Table 10.
The metal composition ratio (unit: at%) of the sputtering target and sputtering conditions are shown in Table 10. Sputtering conditions that are not shown in Table 10 are as described below.

> Substrate temperature: 25°C
> Ultimate pressure: $1.0 \times 10^{-4}$ Pa
> Atmospheric gas: mixed gas of Ar and $H_2O$
> Sputtering pressure (total pressure): 0.5 Pa
> Input voltage: DC 300 W
> Distance between substrate (S) and target (T): 70 mm

(2) Annealing of Oxide Thin Film

The substrate having the oxide thin film formed thereon was placed in a furnace. The temperature inside the furnace was increased to 350°C at 10°C/min in the atmosphere, and was then held for 1 hour. After the temperature inside the furnace was held at 350°C for 1 hour, the furnace was allowed to cool naturally. After the temperature inside the furnace returned to room temperature, the substrate was removed from the furnace.

(3) Low-resistance Ratio (High-carrier Concentration) Treatment

(3-1) Formation of ITO Film

An ITO layer having a thickness of 2 nm was formed through use of a sputtering target of ITO. Sputtering conditions are as described below.

> Substrate temperature: 25°C
> Ultimate pressure: $8.5 \times 10^{-5}$ Pa
> Atmospheric gas: mixed gas of Ar+$O_2$ ($O_2$ flow rate: 2%)
> Sputtering pressure (total pressure): 0.4 Pa
> Input voltage: DC 100 W
> Distance between substrate (S) and target (T): 70 mm

(3-2) Patterning of ITO Layer

The ITO layer was patterned into an island shape of 1 cm square by photolithography. First, a photoresist film was formed on the ITO layer. AZ1500 (manufactured by AZ Electronic Materials SA) was used as a photoresist. The photoresist film was exposed to light via a photomask having a large number of patterns of 1 cm square. After the exposure, development was performed with tetramethylammonium hydroxide (TMAH). After the development, the ITO layer was etched with oxalic acid (ITO-06N manufactured by Kanto Chemical Co., Inc.). After the etching, the photoresist was peeled off. Thus, a substrate having the ITO layers of 1 cm square formed at equal intervals on the oxide thin film was obtained.

(3-3) Annealing

The substrate having the ITO layer patterned thereon was placed in a furnace. The temperature inside the furnace was increased to 350°C at 10°C/min in the atmosphere, and was then held for 1 hour. After the temperature inside the furnace was held at 350°C for 1 hour, the furnace was allowed to cool naturally. After the temperature inside the furnace returned to room temperature, the substrate was removed from the furnace.

Here, the oxide thin film in the region annealed under a state of not being covered with the ITO layer becomes the high-resistance region B. Meanwhile, the oxide thin film in the region annealed under a state of being covered with the ITO layer becomes the low-resistance region A.

(3-4) Removal of ITO Layer

The ITO layers of the substrate subjected to the annealing were removed by etching with oxalic acid (ITO-06N manufactured by Kanto Chemical Co., Inc.). Thus, a crystalline oxide thin film alternately including the high-resistance regions B of 1 cm square and the low-resistance regions A of 1 cm square on the substrate was obtained.

Comparative Example 10

A crystalline oxide thin film was formed in the same manner as in Example 5 except that (3) Low-resistance Treatment in Example 5 was not performed.

Comparative Example 11

A crystalline oxide thin film was formed in the same manner as in Example 5 except that the ITO layer was formed and the annealing was not performed in (3) Low-resistance Treatment in Example 5.

Example 6

A crystalline oxide thin film was formed in the same manner as in Example 5 except that an oxide sputtering target obtained from a raw material mixture having a loaded composition ratio shown in Table 10 was used in (1) Formation of Oxide Thin Film in Example 5.

Example 7

A crystalline oxide thin film was formed in the same manner as in Example 5 except that: an oxide sputtering target obtained from a raw material mixture having a loaded composition ratio shown in Table 11 was used in (1) Formation of Oxide Thin Film in Example 5; and the formation conditions for each constituent layer were changed as shown in Table 11.

Comparative Examples 12 to 14

A crystalline oxide thin film was formed in the same manner as in Example 5 except that (3) Low-resistance Treatment in Example 5 or the thickness of the oxide thin film was changed as shown in Table 11.

Example 8 and Comparative Examples 15 to 18

A crystalline oxide thin film was formed in the same manner as in Example 5 except that: an oxide sputtering target obtained from a raw material mixture having a loaded composition ratio shown in Table 12 was used in (1) Formation of Oxide Thin Film in Example 5; and the formation conditions for each constituent layer were changed as shown in Table 12.

The crystalline oxide thin films obtained in Examples and Comparative Examples were evaluated in the same manner as in the channel layer of Example 1. In addition, the carrier concentration of each of the crystalline oxide thin films was measured. The results are shown in Tables 10 to 12.

(1) Carrier Concentration

The low-resistance region A and high-resistance region B of the crystalline oxide thin film were each cut out into a size of 1 cm square, and an electrode was connected to each of its four corners through use of In solder to provide an element for Hall effect measurement. Then, the carrier concentration was measured. The carrier concentration was determined by performing AC Hall effect measurement through use of Model ResiTest 8400 (manufactured by TOYO Corporation) at room temperature.

Measurement conditions were as described below. The value of the carrier concentration of electrons when an F value as measurement accuracy was 0.9 or more and the absolute value of a Hall voltage phase was from 170° to 180° was adopted.

Current value: $1 \times 10^{-12}$ A to $1 \times 10^{-3}$ A
Magnetic field intensity: 0.36 T

(2) SSRM and SCM Measurement

A region including the low-resistance region A and high-resistance region B of the crystalline oxide thin film was cut out into a size of 1 cm square to provide a cross-section. The cross-section was evaluated in the same manner as in the channel layer of the TFT.

(3) Cross-Sectional TEM and Electron Beam Diffraction Measurement

An arbitrary region of the crystalline oxide thin film was cut out into a size of 1 cm square to provide a cross-section. A target position of the cross-section was evaluated in the same manner as in the channel layer of the TFT.

Table 10

| | | | Example 5 | Example 6 | Comparative Example 10 | Comparative Example 11 |
|---|---|---|---|---|---|---|
| Sputtering target | Loaded composition ratio [mass%] | $In_2O_3$ | 95.0 | 100.0 | 95.0 | 95.0 |
| | | $Ga_2O_3$ | 5.0 | 0.0 | 5.0 | 5.0 |
| | Metal composition ratio [at%] | In | 92.8 | 100.0 | 92.8 | 92.8 |
| | | Ga | 7.2 | 0.0 | 7.2 | 7.2 |

(continued)

| | | | Example 5 | Example 6 | Comparative Example 10 | Comparative Example 11 |
|---|---|---|---|---|---|---|
| Production conditions | Production of oxide thin film | Pressure at time of film formation [Pal | 0.5 | 0.5 | 0.5 | 0.5 |
| | | Oxygen partial pressure at time of film formation [Pa] | 0.00 | 0.00 | 0.00 | 0.00 |
| | | Water partial pressure at time of film formation [Pa] | 0.01 | 0.03 | 0.01 | 0.01 |
| | | Magnetic flux density [G] | 600 | 600 | 600 | 600 |
| | | Thickness [nm] | 10 | 10 | 10 | 10 |
| | Annealing | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |
| | Film formation of ITO layer | Oxygen partial pressure at time of film formation [%] | 2.0 | 2.0 | - | 2.0 |
| | | Thickness of electrode [nm] | 2 | 2 | - | 2 |
| | Patterning of ITO layer | Semiconductor etching | Oxalic acid | Oxalic acid | Oxalic acid | Oxalic acid |
| | | ITO etching thickness [nm] | 2.0 | 2.0 | 2.0 | 2.0 |
| | Low-resistance annealing | Highest temperature [°C] | 350 | 350 | - | - |
| | | Retention time [h] | 1 | 1 | - | - |
| | | Atmosphere | In atmosphere | In atmosphere | - | - |

(continued)

| | | | Example 5 | Example 6 | Comparative Example 10 | Comparative Example 11 |
|---|---|---|---|---|---|---|
| Evaluation results | Cross-sectional TEM | Average grain boundary angle $\theta$ [°] | 98.6 | 92.2 | 98.6 | 98.6 |
| | | Average grain boundary angle $\theta$ sub [°] | 98.6 | 92.2 | 98.6 | 98.6 |
| | | Average spacing D between crystal grain boundaries [$\mu$m] | 2.0 | 1.9 | 2.0 | 2.0 |
| | | Crystal state | Columnar crystal | Columnar crystal | Columnar crystal | Columnar crystal |
| | Hall effect measurement | High carrier concentration region A $n_A$ [cm-3] | 9.0E+19 | 2.0 E+20 | 5.0E+16 | 5.0E+17 |
| | | Low carrier concentration region B $n_B$ [cm-3] | 5.0E+16 | 8.0E+16 | 5.0E+16 | 5.0E+16 |
| | | $n_A/n_B$ | 1800 | 2500 | 1 | 10 |
| | SSRM Spread resistance value evaluation | Low-resistance region A $R_A$ [$\Omega$] | 1.5E+05 | 1.8E+05 | 1.1E+06 | 2.3E+06 |
| | | High-resistance region B $R_B$ [$\Omega$] | 2.5E+06 | 3.0E+06 | 2.5E+06 | 2.5E+06 |
| | | $R_B/R_A$ | 17 | 17 | 2 | 1 |
| | SCM dC/dV value evaluation | Magnitudes of boundary region (A-B) and region (B) | (A-B)>(B) | (A-B)>(B) | (A-B)=(B) | (A-B)<(B) |
| | Crystal phase analysis by electron beam diffraction | | Bixbyite | Bixbyite | Bixbyite | Bixbyite |

Table 11

| | | | Example 7 | Comparative Example 12 | Comparative Example 13 | Comparative Example 14 |
|---|---|---|---|---|---|---|
| Sputtering target | Loaded composition ratio [mass%] | $In_2O_3$ | 90.0 | 90.0 | 90.0 | 90.0 |
| | | $Ga_2O_3$ | 7.0 | 7.0 | 7.0 | 7.0 |
| | | $Sm_2O_3$ | 3.0 | 3.0 | 3.0 | 3.0 |
| | Metal composition ratio [at%] | In | 87.6 | 87.6 | 87.6 | 87.6 |
| | | Ga | 10.1 | 10.1 | 10.1 | 10.1 |
| | | Sm | 2.3 | 2.3 | 2.3 | 2.3 |

(continued)

| Production condition | | | Example 7 | Comparative Example 12 | Comparative Example 13 | Comparative Example 14 |
|---|---|---|---|---|---|---|
| | Production of oxide thin film | Pressure at time of film formation [Pa] | 0.5 | 0.5 | 0.5 | 0.5 |
| | | Oxygen partial pressure at time of film formation [Pa] | 0.05 | 0.05 | 0.05 | 0.05 |
| | | Water partial pressure at time of film formation [Pa] | 0.00 | 0.00 | 0.00 | 0.00 |
| | | Magnetic flux density [G] | 1.000 | 1.000 | 1.000 | 1.000 |
| | | Thickness [nm] | 30 | 30 | 30 | 100 |
| | Annealing | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |
| | Film formation of ITO layer | Oxygen partial pressure at time of film formation [%] | 2.0 | - | 2.0 | 2.0 |
| | | Thickness of electrode [nm] | 2 | - | 2 | 2 |
| | Patterning of ITO layer | Semiconductor etchina | Oxalic acid | Oxalic acid | Oxalic acid | Oxalic acid |
| | | ITO etchina thickness [nm] | 2.0 | 2.0 | 2.0 | 2.0 |
| | Low-resistance annealing | Highest temperature [°C] | 350 | - | - | 350 |
| | | Retention time [h] | 1 | - | - | 1 |
| | | Atmosphere | In atmosphere | - | - | In atmosphere |

(continued)

| | | | Example 7 | Comparative Example 12 | Comparative Example 13 | Comparative Example 14 |
|---|---|---|---|---|---|---|
| Evaluation results | Cross-sectional TEM | Average grain boundary angle $\theta$ [°] | 104 | 104 | 104 | Unmeasurable because oftwophase |
| | | Average grain boundary angle $\theta$ sub [°] | 104 | 104 | 104 | |
| | | Average spacing D between crystal arain boundaries [$\mu$m] | 0.23 | 0.23 | 0.23 | |
| | | Crystal state | Columnar crystal | Columnar crystal | Columnar crystal | Two-layer crystallization in thickness direction |
| | Hall effect measurement | High carrier concentration region A $n_A$ [cm-3] | 8.0E+19 | 3.0E+16 | 6.0E+16 | 5.0E+19 |
| | | Low carrier concentration region B $n_B$ [cm-3] | 3.0E+16 | 3.0E+16 | 3.0E+16 | 3.0E+19 |
| | | $n_A/n_B$ | 2,667 | 1 | 2 | 2 |
| | SSRM Spread resistance value evaluation | Low-resistance region A $R_A$ [$\Omega$] | 1.6E+05 | 2.7E+06 | 9.7E+05 | 2.0E+05 |
| | | High-resistance region B $R_B$ [$\Omega$] | 2.7E+06 | 2.7E+06 | 2.7E+06 | 2.3E+05 |
| | | $R_B/R_A$ | 17 | 1 | 3 | 1 |
| | SCM‑ dC/dV value evaluation | Magnitudes of boundary region (A-B) and region (B) | (A-B)>(B) | (A-B)=(B) | (A-B)>(B) | (A-B)=(B) |
| | Crystal phase analysis by electron beam diffraction | | Bixbyite | Bixbyite | Bixbyite | Bixbyite |

Table 12

| | | | Example 8 | Comparative Example 15 | Comparative Example 16 | Comparative Example 17 | Comparative Example 18 |
|---|---|---|---|---|---|---|---|
| Sputtering target | Loaded composition ratio [mass%] | $In_2O_3$ | 89.0 | 89.0 | 89.0 | 89.0 | 89.0 |
| | | $Ga_2O_3$ | 9.75 | 9.8 | 9.8 | 9.8 | 9.8 |
| | | $Al_2O_3$ | 1.25 | 1.3 | 1.3 | 1.3 | 1.3 |
| | Metal composition ratio [at%] | In | 83.3 | 83.3 | 83.3 | 83.3 | 83.3 |
| | | Ga | 13.5 | 13.5 | 13.5 | 13.5 | 13.5 |
| | | Al | 3.2 | 3.2 | 3.2 | 3.2 | 3.2 |

(continued)

| | | | Example 8 | Comparative Example 15 | Comparative Example 16 | Comparative Example 17 | Comparative Example 18 |
|---|---|---|---|---|---|---|---|
| Production condition | Production of oxide thin film | Pressure at time of film formation [Pa] | 0.5 | 0.5 | 0.5 | 0.5 | 0.5 |
| | | Oxygen partial pressure at time of film formation [Pa] | 0.05 | 0.05 | 0.05 | 0.25 | 0.05 |
| | | Water partial pressure at time of film formation [Pa] | 0.00 | 0.00 | 0.00 | 0.00 | 0.01 |
| | | Magnetic fluxdensity [G] | 1,000 | 1,000 | 1,000 | 1,000 | 1,000 |
| | | Thickness [nm] | 30 | 30 | 30 | 100 | 30 |
| | Annealing | Temperature increase pattern [°C/min] | 10 | 10 | 10 | 10 | 1 |
| | | Highest temperature [°C] | 350 | 350 | 350 | 350 | 350 |
| | | Retention time [h] | 1 | 1 | 1 | 1 | 10 |
| | | Atmosphere | Atmospheric | Atmospheric | Atmospheric | Atmospheric | Atmospheric |
| | Film formation of ITO layer | Oxygen partial pressure at time of film formation [%] | 2.0 | - | 2.0 | 2.0 | 2.0 |
| | | Thickness of electrode [nm] | 2 | - | 2 | 2 | 2 |
| | Pattarning of ITO layar Patterning of ITO layer | Semiconductor etching | Oxalic acid | Oxalic acid | Oxalic acid | Oxalic acid | Oxalic acid |
| | | ITO etching thickness [nm] | 2.0 | 2.0 | 2.0 | 2.0 | 2.0 |
| | Low-resistance annealing | Highest temperature [°C] | 350 | - | - | 350 | 350 |
| | | Retention time [h] | 1 | - | - | 1 | 1 |
| | | Atmosphere | In atmosphere | - | - | In atmosphere | In atmosphere |

EP 4 418 330 A1

|  |  |  | Example 8 | Comparative Example 15 | Comparative Example 16 | Comparative Example 17 | Comparative Example 18 |
|---|---|---|---|---|---|---|---|
| Evaluation results | Cross-sectional TEM | Average grain boundary angle $\theta$ [°] | 93.2 | 93.2 | 93.2 |  | 99.6 |
|  |  | Average grain boundary angle $\theta$sub [°] | 93.2 | 93.2 | 93.2 | Unmeasurable because of | 99.6 |
|  |  | Average spacing D between crystal grain boundaries [$\mu$m] | 0.87 | 0.87 | 0.87 | two-phase | 7.9 |
|  |  | Crystal state | Columnar crystal | Columnar crystal | Columnar crystal | Two-layer crystallization in thickness direction | Columnar crystal |
|  | Hall effect measurement | High carrier concentration region A $n_A$ [cm-3] | 9.5E+19 | 3.3E+16 | 5.0E+17 | 8.3E+19 | 1.5E+16 |
|  |  | Low carrier concentration region B $n_B$ [cm-3] | 3.3E+16 | 3.3E+16 | 3.3E+16 | 8.0E+19 | 1.3E+16 |
|  |  | $n_A/n_B$ | 2879 | 1 | 15 | 1 | 1 |
|  | SSRM·Spread resistance value evaluation | Low-resistance region A $R_A$ [$\Omega$] | 1.7E+04 | 4.1E+05 | 6.3E+04 | 1.0E+04 | 6.1E+05 |
|  |  | High-resistance region B $R_B$ [$\Omega$] | 4.1E+05 | 4.1E+05 | 4.1E+05 | 1.1E-04 | 6.3E+05 |
|  |  | $R_B/R_A$ | 24 | 1 | 7 | 1 | 1 |
|  | SCM·dC/dV value evaluation | Magnitudes of boundary region (A-B) and region (B) | (A-B)>(B) | (A-B)=(B) | (A-B)<(B) | (A-B)=(B) | (A-B)>(B) |
|  | Crystal phase analysis bv electron beam diffraction | | Bixbyite | Bixbyite | Bixbyite | Bixbyite | Bixbyite |

[Production of Self-Aligned Top-Gate Structure Small TFT]

Examples 9 to 11 and Comparative Example 19

TFTs were each produced in the same manner as in Example 1 except that: an oxide sputtering target obtained from a raw material mixture having a loaded coposition ratio shown in Table 13 was used in (2) Formation of Oxide Thin Film in Example 1; and the formation conditions for each constituent layer were changed as ahown in Tables 13 and 14.
The production conditions for the TFTs are summarized in Tables 13 and 14. In addition, the evaluation results of the TFTs are shown in Table 15.

Table 13

| | | | Example 9 | Example 10 | Example 11 | Comparative Example 19 |
|---|---|---|---|---|---|---|
| Sputtering target | Loaded composition ratio [mass%] | $In_2O_3$ | 84.8 | 90.8 | 97.8 | 81.6 |
| | | $Ga_2O_3$ | 15.2 | 9.2 | 2.2 | 18.4 |
| | Metal composition ratio [at%] | In | 79.0 | 87.0 | 96.8 | 75.0 |
| | | Ga | 21.0 | 13.0 | 3.2 | 25.0 |

(continued)

| | | | Example 9 | Example 10 | Example 11 | Comparative Example 19 |
|---|---|---|---|---|---|---|
| TFT production conditions | Film formation of channel layer | Pressure at time of film formation [Pa] | 0.5 | 0.5 | 0.5 | 0.5 |
| | | Oxygen partial pressure at time of film formation [Pa] | 0.05 | 0.05 | 0.00 | 0.05 |
| | | Water partial pressure at time of film formation [Pa] | 0.00 | 0.00 | 0.01 | 0.00 |
| | | Magnetic flux density [G] | 600 | 600 | 600 | 600 |
| | | Thickness [nm] | 30 | 30 | 10 | 30 |
| | Patterning of channel layer | Semiconductor etching | Oxalic acid | Oxalic acid | Oxalic acid | Oxalic acid |
| | Annealing | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |
| | Film formation of gate insulating film | Gate insulating film | SiO$_2$ | SiO$_2$ | SiO$_2$ | SiO$_2$ |
| | | Thickness [nm] | 10 | 10 | 10 | 10 |
| | Annealing | Temperature increase pattern [°C/min] | 10 | 10 | 10 | 10 |
| | | Highest temperature [°C] | 400 | 400 | 400 | 400 |
| | | Retention time [h] | 1 | 1 | 1 | 1 |
| | | Atmosphere | Atmospheric | Atmospheric | Atmospheric | Atmospheric |

Table 14

| | | | Example 9 | Example 10 | Example 11 | Comparative Example 19 |
|---|---|---|---|---|---|---|
| | Film formation of gate insulating film | Gate insulating film | SiO$_2$ | SiO$_2$ | SiO$_2$ | SiO$_2$ |
| | | Thickness [nm] | 100 | 100 | 100 | 100 |
| | Film formation of gate electrode | Gate electrode | Mo | Mo | Mo | Mo |
| | | Thickness [nm] | 150 | 150 | 150 | 150 |

(continued)

| | | | Example 9 | Example 10 | Example 11 | Comparative Example 19 |
|---|---|---|---|---|---|---|
| TFT production conditions | Gate patterning | Etchant for gate electrode | PAN | PAN | PAN | PAN |
| | | Etchantforgate insulating film | BHF | BHF | BHF | BHF |
| | | Etchant for cleaning | ITO-06N | ITO-06N | ITO-06N | ITO-06N |
| | Film formation of ITO layer | Oxygen partial pressure at time of film formation [%] | 2.0 | 2.0 | 2.0 | 2.0 |
| | | Thickness [nm] | 2 | 2 | 2 | 2 |
| | Low-resistance annealing | Highest temperature [°C] | 350 | 350 | 350 | 350 |
| | | Retention time [h] | 1 | 1 | 1 | 1 |
| | | Atmosphere | In atmosphere | In atmosphere | In atmosphere | In atmosphere |
| | Film formation of interlayer insulating film | Insulating film | $SiO_2$ | $SiO_2$ | $SiO_2$ | $SiO_2$ |
| | | Thickness [nm] | 150 | 150 | 150 | 150 |
| | Formation of contact hole in interlayer insulating film | Etchant | BHF | BHF | BHF | BHF |
| | Formation of electrode | Electrode | Mo | Mo | Mo | Mo |
| | Final annealing | Highest temperature [°C] | 300 | 300 | 300 | 300 |
| | | Retention time [h] | 1 | 1 | 1 | 1 |
| | | Atmosphere | $N_2$ | $N_2$ | $N_2$ | $N_2$ |
| | Final shape | L length [μm] | 10 | 10 | 10 | 10 |
| | | W length [μm] | 20 | 20 | 20 | 20 |
| | | Thickness of gate insulating film [nm] | 110 | 110 | 110 | 110 |
| | | 6 conditions for $L_{off}$ [μm] | 4, 6, 8, 10, 12, 14 | 4, 6, 8, 10, 12, 14 | 4, 6, 8, 10, 12, 14 | 4, 6, 8, 10, 12, 14 |
| | | 6 conditions for Ls [μm] | 2, 4, 6, 8, 10, 12 | 2, 4, 6, 8, 10, 12 | 2, 4, 6, 8, 10, 12 | 2, 4, 6, 8, 10, 12 |

Table 15

| | | | Example 9 | Example 10 | Example 11 | Comparative Example 19 |
|---|---|---|---|---|---|---|
| Evaluation of channel layer | Cross-sectional TEM image | Average grain boundary angle $\theta$ [°] | 103.7 | 96.0 | 106.7 | Unmeasurable because of two-phase |
| | | Average grain boundary angle $\theta$ sub | 103.7 | 96 | 106.7 | |
| | | Average spacing D between crystal grain boundaries [$\mu$m] | 2.0 | 1.6 | 1.4 | |
| | | $L_{off}/D$ | 2.0, 3.0, 4.0, 5.0, 6.0, 7.0 | 2,5, 3,8, 5,0, 7,5, 8,8 | 2.9, 4.3, 5.7, 8.6, 10 | |
| | | $L_s/D$ | 1.0, 2.0, 3.0, 4.0, 5.0, 6.0 | 1.3, 2.5, 3.8, 5.0, 7.5 | 1.4, 2.9, 4.3, 5.7, 8.6 | |
| | | Crystal state | Columnar crystal | Columnar crystal | Columnar crystal | Two-layer crystallization in thickness direction |
| | SSRM Spread resistance value evaluation | Low-resistance region A $R_A$ [$\Omega$] | 9.4E+04 | 6.1E+04 | 3.8E+04 | 1.0E+04 |
| | | High-resistance region B $R_B$ [$\Omega$] | 1.6E+06 | 2.9E+06 | 1.1E+06 | 1.1E+04 |
| | | $R_B/R_A$ | 17.4 | 46.8 | 28.2 | 1.1 |
| | | Rs(L) | 1.6E+06 | 2.9E+06 | 1.1E+06 | 1.1E+04 |
| | | Rs($L_{off}$) | 1.4E+05 | 9.1E+04 | 5.7E+04 | 1.2E+04 |
| | | Rs(Ls) | 9.4E+04 | 6.1E+04 | 3.8E+04 | 1.0E+04 |
| | | Rs(L)/Rs($L_{off}$) | 11.6 | 31.2 | 18.8 | 0.9 |
| | | Rs(L)/Rs(Ls) | 17.4 | 46.8 | 28.2 | 1.1 |
| | | $\Delta L$ [$\mu$m] | -0.7 | -0.3 | -0.6 | Unmeasurable because of no difference between $R_A$ and $R_B$ |
| | SCM dC/dV evaluation | Magnitudes of boundary region (A-B) and region (B) | (A-B)>(B) | (A-B)>(B) | (A-B)>(B) | (A-B)=(B) |
| | Electron beam diffraction | Crystal structure | Bixbyite | Bixbyite | Bixbyite | Bixbyite |

(continued)

|  |  |  | Example 9 | Example 10 | Example 11 | Comparative Example 19 |
|---|---|---|---|---|---|---|
| Performance of TFT | Vd=0.1 V | μlin Max [cm2/(Vs)] | 35.8 | 35.5 | 40 | No ON/OFF Leakage |
|  |  | Δμlin [cm2/(V s)] | 1.4 | 1.6 | 1.1 |  |
|  |  | S value [V/ decade] | 0.5 | 0.4 | 0.4 |  |
|  |  | Vth [V] | -0.2 | -0.5 | -0.2 |  |
|  |  | ΔVth | 0.4 | 0.3 | 0.6 |  |
|  | Vd=20 V | μsat Max [cm2/(V·s)] | 33.0 | 32.5 | 37.2 | No ON/OFF Leakage |
|  |  | Δμsat [cm2/(V·s)] | 0.8 | 1.4 | 0.9 |  |
|  |  | S value [V/ decade] | 0.4 | 0.4 | 0.4 |  |
|  |  | Vth [V] | -0.2 | -0.5 | -0.2 |  |
|  |  | ΔVth | 0.5 | 0.2 | 0.6 |  |
|  | Presence or absence e of DIBL phenomenon |  | Absent | Absent | Absent | No ON/OFF |

Examples 12 to 20

TFTs were each produced in the same manner as in Example 1 except that: an oxide sputtering target obtained from a raw material mixture having a loaded composition ratio shown in each of Tables 16 and 17 was used in (2) Formation of Oxide Thin Film in Example 1; and the channel layer was formed under sputtering conditions shown in each of Table 6 to 19.

The production for the TFTs are summarized in Tables 16 to 19. In addition, the evaluation results of the TFTs are shown in Table 20 and 20.

Table 16

| | | | Example 12 | Example 13 | Example 14 | Example 15 | Example 16 |
|---|---|---|---|---|---|---|---|
| Sputtering target | Loaded composition ratio [mass%] | $In_2O_3$ | 89.0 | 92.0 | 91.9 | 84.8 | 82.8 |
| | | $Ga_2O_3$ | 7.0 | 6.0 | 3.2 | 13.6 | 13.2 |
| | | $Sm_2O_3$ | 4.0 | 2.0 | 5.0 | 1.6 | 4.0 |
| | Metal composition ratio [at%] | In | 86.8 | 89.8 | 91.4 | 79.8 | 78.5 |
| | | Ga | 10.1 | 8.7 | 4.7 | 19.0 | 18.5 |
| | | Sm | 3.1 | 1.6 | 3.9 | 1.2 | 30 |
| TFT production conditions | Film formation of channel layer | Pressure at time of film formation [Pa] | 0.5 | 0.5 | 0.5 | 0.5 | 0.5 |
| | | Oxygen partial pressure at time of film formation [Pa] | 0.05 | 0.05 | 0.05 | 0.05 | 0.05 |
| | | Water partial pressure at time of film formation [Pa] | 0.00 | 0.00 | 0.00 | 0.00 | 0.00 |
| | | Magnetic flux density [G] | 1,000 | 1,000 | 1,000 | 1,000 | 1,000 |
| | | Thickness [nm] | 30 | 30 | 30 | 30 | 30 |
| | Patterning of channel layer | Semiconductor etching | Oxalic acid | Oxalic acid | Oxalic acid | Oxalic acid | Oxalic acid |
| | Annealing | Temperature increase pattern [°C/min] | 10 | 10 | 10 | 10 | 10 |
| | | Highest temperature [°C] | 350 | 350 | 350 | 350 | 350 |
| | | Retention time [h] | 1 | 1 | 1 | 1 | 1 |
| | | Atmosphere | Atmospheric | Atmospheric | Atmospheric | Atmospheric | Atmospheric |
| | Film formation of gate insulating film | Gate insulating film | $SiO_2$ | $SiO_2$ | $SiO_2$ | $SiO_2$ | $SiO_2$ |
| | | Thickness [nm] | 100 | 100 | 100 | 100 | 100 |
| | Annealing | Temperature increase pattern [°C/min] | 10 | 10 | 10 | 10 | 10 |
| | | Highest temperature [°C] | 400 | 400 | 400 | 400 | 400 |
| | | Retention time [h] | 1 | 1 | 1 | 1 | 1 |
| | | Atmosphere | Atmospheric | Atmospheric | Atmospheric | Atmospheric | Atmospheric |

Table 17

| | | | Example 17 | Example 18 | Example 19 | Example 20 |
|---|---|---|---|---|---|---|
| Sputtering target | Loaded composition ratio [mass%] | $In_2O_3$ | 88.5 | 96.6 | 94.2 | 92.8 |
| | | $Ga_2O_3$ | 3.4 | 2.2 | 4.5 | 2.2 |
| | | $Sm_2O_3$ | 8.2 | 1.3 | 1.3 | 5.0 |
| | Metal composition ratio [at%] | In | 88.5 | 95.8 | 92.5 | 92.8 |
| | | Ga | 5.0 | 3.2 | 6.5 | 3.2 |
| | | Sm | 6.5 | 1.0 | 1.0 | 4.0 |
| TFT production conditions | Film formation of channel layer | Pressure at time of film formation [Pa] | 0.5 | 0.5 | 0.5 | 0.5 |
| | | Oxygen partial pressure at time of film formation [Pa] | 0.05 | 0.00 | 0.00 | 0.00 |
| | | Water partial pressure at time of film formation [Pa] | 0.00 | 0.01 | 0.01 | 0.01 |
| | | Magnetic flux density [G] | 1.000 | 1,000 | 1.000 | 1.000 |
| | | Thickness [nm] | 30 | 30 | 30 | 30 |
| | Patterning of channel layer | Semiconductor etching | Oxalic acid | Oxalic acid | Oxalic acid | Oxalic acid |
| | Annealing | Temperature increase pattern [°C/min] | 10 | 10 | 10 | 10 |
| | | Highest temperature [°C] | 350 | 350 | 350 | 350 |
| | | Retention time [h] | 1 | 1 | 1 | 1 |
| | | Atmosphere | Atmospheric | Atmospheric | Atmospheric | Atmospheric |
| | Film formation of gate insulating film | Gate insulating film | $SiO_2$ | $SiO_2$ | $SiO_2$ | $SiO_2$ |
| | | Thickness [nm] | 100 | 100 | 100 | 100 |
| | Annealing | Temperature increase pattern [°C/min] | 10 | 10 | 10 | 10 |
| | | Highest temperature [°C] | 400 | 400 | 400 | 400 |
| | | Retention time [h] | 1 | 1 | 1 | 1 |
| | | Atmosphere | Atmospheric | Atmospheric | Atmospheric | Atmospheric |

Table 18

| | | | Example 12 | Example 13 | Example 14 | Example 15 | Example 16 |
|---|---|---|---|---|---|---|---|
| TFT production conditions | Film formation of gate electrode | Gate electrode | Mo | Mo | Mo | Mo | Mo |
| | | Thickness [nm] | 150 | 150 | 150 | 150 | 150 |
| | Gate patterning | Etchant for gate electrode | PAN | PAN | PAN | PAN | PAN |
| | | Etchant for gate insulating film | BHF | BHF | BHF | BHF | BHF |
| | | Etchant for cleanina | ITO-06N | ITO-06N | ITO-06N | ITO-06N | ITO-06N |
| | Film formation of ITO layer | Oxygen partial pressure at time of film formation [%] | 2.0 | 2.0 | 2.0 | 2.0 | 2.0 |
| | | Thickness [nm] | 2 | 2 | 2 | 2 | 2 |
| | Low-resistance annealing | Highest temperature [°C] | 350 | 350 | 350 | 350 | 350 |
| | | Retention time [h] | 1 | 1 | 1 | 1 | 1 |
| | | Atmosphere | In atmosphere | In atmosphere | In atmosphere | In atmosphere | In atmosphere |
| | Film formation of interlayer insulating film | Insulating film | $SiO_2$ | $SiO_2$ | $SiO_2$ | $SiO_2$ | $SiO_2$ |
| | | Thickness [nm] | 150 | 150 | 150 | 150 | 150 |
| | Formation of contact hole in interlayer insulating film | Etchant | BHF | BHF | BHF | BHF | BHF |
| | Formation of electrode | Electrode | Mo | Mo | Mo | Mo | Mo |
| | | Resist | AZ5214 | AZ5214 | AZ5214 | AZ5214 | AZ5214 |
| | Final annealing | Highest temperature [°C] | 200 | 200 | 200 | 200 | 200 |
| | | Retention time [h] | 1 | 1 | 1 | 1 | 1 |
| | | Atmosphere | N2 | N2 | N2 | N2 | N2 |

| | | | Example 12 | Example 13 | Example 14 | Example 15 | Example 16 |
|---|---|---|---|---|---|---|---|
| Final shape | | L length [$\mu$m] | 10 | 10 | 10 | 10 | 10 |
| | | W length [$\mu$m] | 20 | 20 | 20 | 20 | 20 |
| | | Thickness of gate insulating film [nm] | 100 | 100 | 100 | 100 | 100 |
| | | 6 conditions for $L_{off}$ [$\mu$m] | 4, 6, 8, 10, 12, 14 | 4, 6, 8, 10, 12, 14 | 4, 6, 8, 10, 12, 14 | 4, 6, 8, 10, 12, 14 | 4, 6, 8, 10, 12, 14 |
| | | 6 conditions for Ls [$\mu$m] | 2, 4, 6, 8, 10, 12 | 2, 4, 6, 8, 10, 12 | 2, 4, 6, 8, 10, 12 | 2, 4, 6, 8, 10, 12 | 2, 4, 6, 8, 10, 12 |

Table 19

| | | | Example 17 | Example 18 | Example 19 | Example 20 |
|---|---|---|---|---|---|---|
| TFT production conditions | Film formation of gate electrode | Gate electrode | Mo | Mo | Mo | Mo |
| | | Thickness [nm] | 150 | 150 | 150 | 150 |
| | Gate patterning | Etchant for gate electrode | PAN | PAN | PAN | PAN |
| | | Etchant for gate insulating film | BHF | BHF | BHF | BHF |
| | | Etchant for cleaning | ITO-06N | ITO-06N | ITO-06N | ITO-06N |
| | Film formation of ITO layer | Oxygen partial pressure at time of film formation [%] | 2.0 | 2.0 | 2.0 | 2.0 |
| | | Thickness [nm] | 2 | 2 | 2 | 2 |
| | Low-resistance annealing | Highest temperature [°C] | 350 | 350 | 350 | 350 |
| | | Retention time [h] | 1 | 1 | 1 | 1 |
| | | Atmosphere | In atmosphere | In atmosphere | In atmosphere | In atmosphere |
| | Film formation of interlayer insulating film | Insulating film | $SiO_2$ | $SiO_2$ | $SiO_2$ | $SiO_2$ |
| | | Thickness [nm] | 150 | 150 | 150 | 150 |
| | Formation of contact hole in interlayer insulating film | Etchant | BHF | BHF | BHF | BHF |
| | Formation of electrode | Electrode | Mo | Mo | Mo | Mo |
| | | Resist | AZ5214 | AZ5214 | AZ5214 | AZ5214 |
| | Final annealing | Highest temperature [°C] | 200 | 200 | 200 | 200 |
| | | Retention time [h] | 1 | 1 | 1 | 1 |
| | | Atmosphere | N2 | N2 | N2 | N2 |
| | Final shape | L length [$\mu$m] | 10 | 10 | 10 | 10 |
| | | W length [$\mu$m] | 20 | 20 | 20 | 20 |
| | | Thickness of gate insulating film [nm] | 100 | 100 | 100 | 100 |
| | | 6 conditions for $L_{off}$ [$\mu$m] | 4, 6, 8, 10, 12, 14 | 4, 6, 8, 10, 12, 14 | 4, 6, 8, 10, 12, 14 | 4, 6, 8, 10, 12, 14 |
| | | 6 conditions for Ls [$\mu$m] | 2, 4, 6, 8, 10, 12 | 2, 4, 6, 8, 10, 12 | 2, 4, 6, 8, 10, 12 | 2, 4, 6, 8, 10, 12 |

Table 20

| | | | Example 12 | Example 13 | Example 14 | Example 15 | Example 16 |
|---|---|---|---|---|---|---|---|
| Cross-sectional TEM image | | Average grain boundary angle θ [°] | 99 | 78 | 101 | 83 | 104 |
| | | Average grain boundary angle θ sub [°] | 99 | 78 | 101 | 83 | 104 |
| | | Average spacing D between crystal grain boundaries [μm] | 1.10 | 0.60 | 1.90 | 0.60 | 110 |
| | | $L_{off}/D$ | 3.6, 5.5, 7.3, 10, 11, 13 | 6.7, 10, 13, 18, 20, 23 | 2.1, 3.2, 4.2, 5.3, 6.3, 7.4 | 6.7, 10, 13, 17, 20, 23 | 3.6, 5.5, 7.3, 9.1, 11, 13 |
| | | $L_s/D$ | 1.8, 3.6, 5.5, 7.3, 9.1, 11 | 3.3, 6.7, 10, 13, 17, 20 | 1.1, 2.1, 3.2, 4.2, 5.3, 6.3 | 3.3, 6.7, 10, 13, 17, 20 | 1.8, 3.6, 5.5, 7.3, 9.1, 11 |
| | | Crystal state | Columnar crystal | Columnar crystal | Columnar crystal | Columnar crystal | Columnar crystal |
| SSRM Spread resistance value evaluation | | Low-resistance region A $R_A$ [Ω] | 3.9E+04 | 4.3E+04 | 1.4E+05 | 3.4E+04 | 8.8E+04 |
| | | High-resistance region B $R_B$ [Ω] | 1.5 E+06 | 9.2E+05 | 4.6E+06 | 8.9E+05 | 2.6E+06 |
| | | $R_B/R_A$ | 38 | 21 | 34 | 26 | 29 |
| | | $R_S(L)$ | 1.5E+06 | 9.2E+05 | 4.6E+06 | 8.9E+05 | 2.6E+06 |
| | | $R_S(L_{off})$ | 5.8E+04 | 6.4E+04 | 2.0E+05 | 5.2E+04 | 1.3E+05 |
| | | $R_S(Ls)$ | 3.9E+04 | 4.3E+04 | 1.4E+05 | 3.4E+04 | 8.8E+04 |
| | | $R_S(L)/Rs(L_{off})$ | 25 | 14 | 23 | 17 | 19 |
| | | $R_S(L)/Rs(Ls)$ | 38 | 21 | 34 | 26 | 29 |
| | | $\Delta L$ [μm] | -0.4 | -0.8 | -0.6 | 0.2 | -0.4 |
| SCM dC/dV evaluation | | Magnitudes of boundary region (A-B) and region (B) | (A-B)>(B) | (A-B)>(B) | (A-B)>(B) | (A-B)>(B) | (A-B)>(B) |
| Electron beam diffraction | | Crystal structure | Bixbyite | Bixbyite | Bixbyite | Bixbyite | Bixbyite |
| Vd=0.1 V | | μlin Max [cm2/(V s)] | 38.9 | 39.2 | 38.7 | 32.1 | 30.2 |
| | | Aplin [cm2/(V s)] | 1.2 | 1.4 | 1.3 | 1.4 | 1.1 |
| | | S value [V/decade] | 0.5 | 0.5 | 0.4 | 0.5 | 0.4 |
| | | Vth [V] | -0.1 | -0.7 | -0.3 | 0.7 | 0.4 |
| | | $\Delta$Vth | 0.6 | 0.4 | 0.2 | 0.4 | 0.6 |

(continued)

| Vd=20 V | | Example 12 | Example 13 | Example 14 | Example 15 | Example 16 |
|---|---|---|---|---|---|---|
| | $\mu$sat Max [cm2/(V s)] | 33.9 | 34.5 | 31.7 | 30.1 | 28.9 |
| | $\Delta\mu$sat [cm2/(V s)] | 0.9 | 1.8 | 1.4 | 1.1 | 0.7 |
| | S value [V/decade] | 0.5 | 0.4 | 0.4 | 0.4 | 0.5 |
| | Vth [V] | -0.9 | 0.6 | 1 | -0.4 | 0.2 |
| | $\Delta$Vth | 0.5 | 0.6 | 0.6 | 0.2 | 0.6 |
| Presence or absenc ce of DIBL phenomenon | | Absent | Absent | Absent | Absent | Absent |

Table 21

| | | | Example 17 | Example 18 | Example 19 | Example 20 |
|---|---|---|---|---|---|---|
| Evaluation of channel layer | Cross-sectional TEM image | Average grain boundary angle $\theta$ [°] | 72 | 99 | 82 | 77 |
| | | Average grain boundary angle $\theta$ sub [°] | 72 | 99 | 82 | 77 |
| | | Average spacing D between crystal grain boundaries [$\mu$m] | 0.20 | 0.90 | 0.70 | 2.00 |
| | | $L_{off}$/D | 20, 30, 40, 50, 60, 70 | 4.4, 6.7, 8.9, 11, 13, 16 | 5.7, 8.6, 11, 14, 17, 20 | 2.0, 3.0, 4.0, 5.0, 6.0, 7.0 |
| | | $L_s$/D | 10, 20, 30, 40, 50, 60 | 2.2, 4.4, 6.7, 8.9, 11, 13 | 2.9, 5.7, 8.6, 11, 14, 17 | 1.0, 2.0, 3.0, 4.0, 5.0, 6.0 |
| | | Crystal state | Columnar crystal | Columnar crystal | Columnar crystal | Columnar crystal |
| | SSRMSpread resistance value evaluation | Low-resistance region A $R_A$ [$\Omega$] | 9.8E+04 | 5.5E+04 | 2.3E+04 | 3.2E+04 |
| | | High-resistance region B $R_B$ [$\Omega$] | 4.2E+06 | 1.3E+06 | 9.2E+05 | 6.4E+05 |
| | | $R_B$/$R_A$ | 43 | 24 | 39 | 20 |
| | | $R_S$(L) | 4.2E+06 | 1.3E+06 | 9.2E+05 | 6.4E+05 |
| | | $R_S$($L_{off}$) | 1.5E+05 | 8.3E+04 | 3.5E+04 | 4.7E+04 |
| | | $R_S$(Ls) | 9.8E+04 | 5.5E+04 | 2.3E+04 | 3.2E+04 |
| | | $R_S$(L)/Rs($L_{off}$) | 29 | 16 | 26 | 14 |
| | | $R_S$(L)/$R_S$($L_S$) | 43 | 24 | 39 | 20 |
| | | $\Delta$L [$\mu$m] | -0.2 | -0.5 | -0.7 | 0.0 |
| | SCM·dC/dV evaluation | Magnitudes of boundary region (A-B) and region (B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite |

(continued)

| | | | Example 17 | Example 18 | Example 19 | Example 20 |
|---|---|---|---|---|---|---|
| Performance of TFT | Vd=0.1 V | $\mu$lin Max [cm2/(V·s)] | 35.1 | 38.7 | 38.5 | 39.2 |
| | | $\Delta\mu$lin [cm2/(V·s)] | 1.2 | 1.4 | 1.4 | 1.2 |
| | | S value [V/decade] | 0.4 | 0.5 | 0.5 | 0.5 |
| | | Vth [V] | -0.7 | -0.2 | -0.2 | 1.2 |
| | | $\Delta$Vth | 0.5 | 0.5 | 0.2 | 0.5 |
| | Vd=20 V | $\mu$sat Max [cm2/(V·s)] | 33.2 | 34.9 | 34.4 | 34.5 |
| | | $\Delta\mu$sat [cm2/(V·s)] | 0.8 | 1.4 | 1.2 | 1.2 |
| | | S value [V/decade] | 0.5 | 0.4 | 0.6 | 0.4 |
| | | Vth [V] | -0.7 | 0 | 0 | -0.4 |
| | | $\Delta$Vth | 0.3 | 0.4 | 0.3 | 0.5 |
| | Presence or absence of DIBL phenomenon | | Absent | Absent | Absent | Absent |

Examples 21 to 34B

TFTs were each produced in the same manner as in Example 1 except that: an oxide sputtering target obtained from a raw material mixture having a loaded composition ratio shown in each of Tables 22 to 24 was used in (2) Formation of Oxide Thin Film in Example 1; and the formation conditions for each constituent layer were changed as shown in each of Table 22 to 27.
The production for the TFTs are summarized in Tables 22 to 27. In addition, the evaluation results of the TFTs are shown in Table 28 and 30.

Table 22

| | | | Example 21 | Example 22 | Example 23 | Example 24 | Example 25 |
|---|---|---|---|---|---|---|---|
| Sputtering target | Loaded composition ratio [mass%] | $In_2O_3$ | 94.0 | 88.0 | 87.5 | 89.6 | 83.0 |
| | | $Ga_2O_3$ | 4.0 | 11.0 | 11.0 | 10.0 | 15.0 |
| | | $Al_2O_3$ | 2.0 | 1.0 | 1.5 | 0.4 | 2.0 |
| | Metal composition ratio [at%] | In | 89.2 | 82.2 | 81.1 | 84.9 | 75.0 |
| | | Ga | 5.6 | 15.2 | 15.1 | 14.0 | 20.1 |
| | | Al | 5.2 | 2.5 | 3.8 | 1.1 | 4.9 |
| TFT production conditions | Film formation of channel layer | Pressure at time of film formation [Pa] | 0.5 | 0.5 | 0.5 | 0.5 | 0.5 |
| | | Oxygen partial pressure attime of film formation [Pa] | 0.05 | 0.05 | 0.05 | 0.25 | 0.05 |
| | | Water partial pressure at time of film formation [Pa] | 0.00 | 0.00 | 0.00 | 0.00 | 0.00 |
| | | Magnetic flux density [G] | 1.000 | 1.000 | 1.000 | 1.000 | 1.000 |
| | | Thickness [nm] | 30 | 30 | 30 | 30 | 30 |
| | Patterning of channel layer | Semiconductor etching | Oxalic acid | Oxalic acid | Oxalic acid | Oxalic acid | Oxalic acid |
| | Annealing | Temperature increase pattern [°C/min] | 10 | 10 | 10 | 10 | 10 |
| | | Highest temperature [°C] | 350 | 350 | 350 | 350 | 350 |
| | | Retention time [h] | 1 | 1 | 1 | 1 | 1 |
| | | Atmosphere | Atmospheric | Atmospheric | Atmospheric | Atmospheric | Atmospheric |
| | Film formation of gate insulating film | Gate insulating film | $SiO_2$ | $SiO_2$ | $SiO_2$ | $SiO_2$ | $SiO_2$ |
| | | Thickness [nm] | 100 | 100 | 100 | 100 | 100 |
| | Annealing | Temperature increase pattern [°C/min] | 10 | 10 | 10 | 10 | 10 |
| | | Highest temperature [°C] | 400 | 400 | 400 | 400 | 400 |
| | | Retention time [h] | 1 | 1 | 1 | 1 | 1 |
| | | Atmosphere | Atmospheric | Atmospheric | Atmospheric | Atmospheric | Atmospheric |

EP 4 418 330 A1

67

Table 23

| | | | Example 26 | Example 27 | Example 28 | Example 29 | Example 30 |
|---|---|---|---|---|---|---|---|
| Sputtering target | Loaded composition ratio [mass%] | $In_2O_3$ | 82.0 | 83.2 | 87.8 | 90.7 | 92.6 |
| | | $Ga_2O_3$ | 16.5 | 16.2 | 9.8 | 7.3 | 5.8 |
| | | $Al_2O_3$ | 1.5 | 0.6 | 2.4 | 2.0 | 1.6 |
| | Metal composition ratio [at%] | In | 74.2 | 76.5 | 80.7 | 84.8 | 87.7 |
| | | Ga | 22.1 | 22.0 | 13.3 | 10.1 | 8.1 |
| | | Al | 3.7 | 1.5 | 6.0 | 5.1 | 4.1 |
| TFT production conditions | Film formation of channel layer | Pressure attime of film formation [Pa] | 0.5 | 0.5 | 0.5 | 0.5 | 0.5 |
| | | Oxygen partial pressure at time of film formation [Pa] | 0.05 | 0.05 | 0.05 | 0.05 | 0.25 |
| | | Water partial pressure at time of film formation [Pa] | 0.00 | 0.00 | 0.00 | 0.00 | 0.00 |
| | | Magnetic flux density [G] | 1,000 | 1,000 | 1,000 | 1,000 | 1,000 |
| | | Thickness [nm] | 30 | 30 | 30 | 30 | 30 |
| | Patterning of channel layer | Semiconductor etching | Oxalic acid | Oxalic acid | Oxalic acid | Oxalic acid | Oxalic acid |
| | Annealing | Temperature increase pattern [°C/min] | 10 | 10 | 10 | 10 | 10 |
| | | Highest temperature [°C] | 350 | 350 | 350 | 350 | 350 |
| | | Retention time [h] | 1 | 1 | 1 | 1 | 1 |
| | | Atmosphere | Atmospheric | Atmospheric | Atmospheric | Atmospheric | Atmospheric |
| | Film formation of gate insulating film | Gate insulating film | $SiO_2$ | $SiO_2$ | $SiO_2$ | $SiO_2$ | $SiO_2$ |
| | | Thickness [nm] | 100 | 100 | 100 | 100 | 100 |
| | Annealing | Temperature increase pattern [°C/min] | 10 | 10 | 10 | 10 | 10 |
| | | Highest temperature [°C] | 400 | 400 | 400 | 400 | 400 |
| | | Retention time [h] | 1 | 1 | 1 | 1 | 1 |
| | | Atmosphere | Atmospheric | Atmospheric | Atmospheric | Atmospheric | Atmospheric |

Table 24

| | | | Example 31 | Example 32 | Example 33 | Example 34 | Example 34A | Example 34B |
|---|---|---|---|---|---|---|---|---|
| Sputtering target | Loaded composition ratio [mass%] | $In_2O_3$ | 92.1 | 97.4 | 95.1 | 96.2 | 91.0 | 93.5 |
| | | $Ga_2O_3$ | 5.1 | 2.2 | 4.5 | 2.2 | 8.0 | 5.0 |
| | | $Al_2O_3$ | 2.8 | 0.4 | 0.4 | 1.5 | 1.0 | 1.5 |
| | Metal composition ratio [at%] | In | 85.9 | 95.8 | 92.5 | 92.8 | 86.2 | 89.1 |
| | | Ga | 7.0 | 3.2 | 6.5 | 3.2 | 11.2 | 7.1 |
| | | Al | 7.1 | 1.0 | 1.0 | 4.0 | 2.6 | 3.9 |

(continued)

| | | | Example 31 | Example 32 | Example 33 | Example 34 | Example 34A | Example 34B |
|---|---|---|---|---|---|---|---|---|
| TFT production conditions | Film formation ofchannel layer | Pressure at time of film formation [Pa] | 0.5 | 0.5 | 0.5 | 0.5 | 0.5 | 0.5 |
| | | Oxygen partial pressure at time of film formation [Pa] | 0.05 | 0.00 | 0.00 | 0.00 | 0.15 | 0.10 |
| | | Water partial pressure at time of film formation [Pa] | 0.00 | 0.01 | 0.01 | 0.01 | 0.00 | 0.00 |
| | | Magnetic flux density [G] | 1,000 | 1,000 | 1,000 | 1,000 | 0 | 0 |
| | | Thickness [nm] | 30 | 30 | 30 | 30 | 30 | 30 |
| | Patterning ofchannel layer | Semiconductoretchina | Oxalic acid | Oxalic acid | Oxalic acid | Oxalic acid | Oxalic acid | Oxalic acid |
| | Annealing | Temperature increase pattern [°C/min] | 10 | 10 | 10 | 10 | 10 | 10 |
| | | Highest temperature [°C] | 350 | 350 | 350 | 350 | 350 | 350 |
| | | Retention time [h] | 1 | 1 | 1 | 1 | 1 | 1 |
| | | Atmosphere | Atmospheric | Atmospheric | Atmospheric | Atmospheric | Atmospheric | Atmospheric |
| | Film formation of gate insulating film | Gate insulating film | $SiO_2$ | $SiO_2$ | $SiO_2$ | $SiO_2$ | $SiO_2$ | $SiO_2$ |
| | | Thickness [nm] | 100 | 100 | 100 | 100 | 100 | 100 |
| | Annealing | Temperature increase pattern [°C/min] | 10 | 10 | 10 | 10 | 10 | 10 |
| | | Highest temperature [°C] | 400 | 400 | 400 | 400 | 400 | 400 |
| | | Retention time [h] | 1 | 1 | 1 | 1 | 1 | 1 |
| | | Atmosphere | Atmospheric | Atmospheric | Atmospheric | Atmospheric | Atmospheric | Atmospheric |

Table 25

| | | | Example 21 | Example 22 | Example 23 | Example 24 | Example 25 |
|---|---|---|---|---|---|---|---|
| TFT production conditions | Film formation of gate electrode | Gate electrode | Mo | Mo | Mo | Mo | Mo |
| | | Thickness [nm] | 150 | 150 | 150 | 150 | 150 |
| | Gate patterning | Etchant for gate electrode | PAN | PAN | PAN | PAN | PAN |
| | | Etchant for gate insulating film | BHF | BHF | BHF | BHF | BHF |
| | | Etchant for cleaning | ITO-06N | ITO-06N | ITO-06N | ITO-06N | ITO-06N |
| | Film formation of ITO layer | Oxygen partial pressure at time of film formation [%] | 2.0 | - | 2.0 | 2.0 | 2.0 |
| | | Thickness [nm] | 2 | - | 2 | 2 | 2 |
| | Low-resistance annealing | Highest temperature [°C] | 350 | - | - | 350 | 350 |
| | | Retention time [h] | 1 | - | - | 1 | 1 |
| | | Atmosphere | In atmosphere | - | - | In atmosphere | In atmosphere |
| | Film formation of interlayer insulating film | Insulating film | $SiO_2$ | SiO2 | SiO2 | SiO2 | $SiO_2$ |
| | | Thickness [nm] | 150 | 150 | 150 | 150 | 150 |
| | Formation of contact hole in interlayer insulating film | Etchant | BHF | BHF | BHF | BHF | BHF |
| | Formation of electrode | Electrode | Mo | Mo | Mo | Mo | Mo |
| | | Resist | AZ5214 | AZ5214 | AZ5214 | AZ5214 | AZ5214 |

(continued)

|  |  |  | Example 21 | Example 22 | Example 23 | Example 24 | Example 25 |
|---|---|---|---|---|---|---|---|
| | Final annealing | Highest temperature [°C] | 200 | 200 | 200 | 200 | 200 |
| | | Retention time [h] | 1 | 1 | 1 | 1 | 1 |
| | | Atmosphere | N2 | N2 | N2 | N2 | N2 |
| | Final shape | L length [μm] | 10 | 10 | 10 | 10 | 10 |
| | | W length [μm] | 20 | 20 | 20 | 20 | 20 |
| | | Thickness of gate insulating film [nm] | 100 | 100 | 100 | 100 | 100 |
| | | 6 conditions for $L_{off}$ [μm] | 4, 8, 8, 10, 12, 14 | 4, 6, 8, 10, 12, 14 | 4, 6, 8, 10, 12, 14 | 4, 8, 8, 10, 12, 14 | 4, 8, 8, 10, 12, 14 |
| | | 6 conditions for Ls [μm] | 2, 4, 6, 8, 10, 12 | 2, 4, 6, 8, 10, 12 | 2, 4, 8, 8, 10, 12 | 2, 4, 6, 8, 10, 12 | 2, 4, 6, 8, 10, 12 |

Table 26

|  |  |  | Example 26 | Example 27 | Example 28 | Example 29 | Example 30 |
|---|---|---|---|---|---|---|---|
| | Film formation of gate electrode | Gate electrode | Mo | Mo | Mo | Mo | Mo |
| | | Thickness [nm] | 150 | 150 | 150 | 150 | 150 |
| | Gate patterning | Etchant for gate electrode | PAN | PAN | PAN | PAN | PAN |
| | | Etchant for gate insulating film | BHF | BHF | BHF | BHF | BHF |
| | | Etchant for cleaning | ITO-06N | ITO-06N | ITO-06N | ITO-06N | ITO-06N |
| | Film formation of ITO layer | Oxygen partial pressure at time of film formation [%] | - | 2.0 | - | 2.0 | 2.0 |
| | | Thickness [nm] | - | 2 | - | 2 | 2 |

(continued)

|  |  |  | Example 26 | Example 27 | Example 28 | Example 29 | Example 30 |
|---|---|---|---|---|---|---|---|
| TFT production conditions | Low-resistance annealing | Highest temperature [°C] | - | 350 | - | - | 350 |
|  |  | Retention time [h] | - | 1 | - | - | 1 |
|  |  | Atmosphere | - | In atmosphere | - | - | In atmosphere |
|  | Film formation of interlayer insulating film | insulating film | SiO2 | $SiO_2$ | SiO2 | $SiO_2$ | SiO2 |
|  |  | Thickness [nm] | 150 | 150 | 150 | 150 | 150 |
|  | Formation of contact hole in interlayer insulating film | Etchant | BHF | BHF | BHF | BHF | BHF |
|  | Formation of electrode | Electrode | Mo | Mo | Mo | Mo | Mo |
|  |  | Resist | AZ5214 | AZ5214 | AZ5214 | AZ5214 | AZ5214 |
|  | Final annealing | Highest temperature [°C] | 200 | 200 | 200 | 200 | 200 |
|  |  | Retention time [h] | 1 | 1 | 1 | 1 | 1 |
|  |  | Atmosphere | N2 | N2 | N2 | N2 | N2 |
|  | Final shape | L length [μm] | 10 | 10 | 10 | 10 | 10 |
|  |  | W length [μm] | 20 | 20 | 20 | 20 | 20 |
|  |  | Thickness of gate insulating film [nm] | 100 | 100 | 100 | 100 | 100 |
|  |  | 6 conditions for $L_{off}$ [μm] | 4, 6, 8, 10, 12, 14 | 4, 6, 8, 10, 12, 14 | 4, 6, 8, 10, 12, 14 | 4, 6, 8, 10, 12, 14 | 4, 6, 8, 10, 12, 14 |
|  |  | 6 conditions for Ls [μm] | 2, 4, 6, 8, 10, 12 | 2, 4, 6, 8, 10, 12 | 2, 4, 6, 8, 10, 12 | 2, 4, 6, 8, 10, 12 | 2, 4, 6, 8, 10, 12 |

Table 27

| | | | Example 31 | Example 32 | Example 33 | Example 34 | Example 34A | Example 34B |
|---|---|---|---|---|---|---|---|---|
| TFT production conditions | Film formation of gate electrode | Gate electrode | Mo | Mo | Mo | Mo | Mo | Mo |
| | | Thickness [nm] | 150 | 150 | 150 | 150 | 150 | 150 |
| | Gate patterning | Etchant for gate electrode | PAN | PAN | PAN | PAN | PAN | PAN |
| | | Etchant for gate insulating film | BHF | BHF | BHF | BHF | BHF | BHF |
| | | Etchant for cleaning | ITO-06N | ITO-06N | ITO-06N | ITO-06N | ITO-06N | ITO-06N |
| | Film formation of ITO layer | Oxygen partial pressure at time of film formation [%] | 2.0 | - | - | - | - | - |
| | | Thickness [nm] | 2 | - | - | - | - | - |
| | Low-resistance annealing | Highest temperature [°C] | 350 | - | - | - | - | - |
| | | Retention time [h] | 1 | - | - | - | - | - |
| | | Atmosphere | In atmosphere | - | - | - | - | - |
| | Film formation of interlayer insulating film | Insulating film | $SiO_2$ | SiO2 | SiO2 | $SiO_2$ | SiO2 | SiO2 |
| | | Thickness [nm] | 150 | 150 | 150 | 150 | 150 | 150 |
| | Formation of contact hole in interlayer insulating film | Etchant | BHF | BHF | BHF | BHF | BHF | BHF |
| | Formation of electrode | Electrode | Mo | Mo | Mo | Mo | Mo | Mo |
| | | Resist | AZ5214 | AZ5214 | AZ5214 | AZ5214 | AZ5214 | AZ5214 |
| | Final annealing | Highest temperature [°C] | 200 | 200 | 200 | 200 | 200 | 200 |
| | | Retention time [h] | 1 | 1 | 1 | 1 | 1 | 1 |
| | | Atmosphere | N2 | N2 | N2 | N2 | N2 | N2 |

(continued)

| | | | Example 31 | Example 32 | Example 33 | Example 34 | Example 34A | Example 34B |
|---|---|---|---|---|---|---|---|---|
| | Final shape | L length [$\mu$m] | 10 | 10 | 10 | 10 | 10 | 10 |
| | | W length [$\mu$m] | 20 | 20 | 20 | 20 | 20 | 20 |
| | | Thickness of gate insulating film [nm] | 100 | 100 | 100 | 100 | 100 | 100 |
| | | 6 conditions for $L_{off}$ [$\mu$m] | 4, 6, 8, 10, 12, 14 | 4, 6, 8, 10, 12, 14 | 4, 6, 8, 10, 12, 14 | 4, 6, 8, 10, 12, 14 | 4, 6, 8, 10, 12, 14 | 4, 6, 8, 10, 12, 14 |
| | | 6 conditions for Ls [$\mu$m] | 2, 4, 6, 8, 10, 12 | 2, 4, 6, 8, 10, 12 | 2, 4, 6, 8, 10, 12 | 2, 4, 6, 8, 10, 12 | 2, 4, 6, 8, 10, 12 | 2, 4, 6, 8, 10, 12 |

Table 28

| | | | Example 21 | Example 22 | Example 23 | Example 24 | Example 25 |
|---|---|---|---|---|---|---|---|
| Evaluation of channel layer | Cross-sectional TEM image | Average grain boundary angle $\theta$ [°] | 91.1 | 74.9 | 84.2 | 86.7 | 81.8 |
| | | Average grain boundary angle $\theta$ sub [°] | 91.1 | 74.9 | 84.2 | 86.7 | 81.8 |
| | | Average spacing D between crystal grain boundaries [$\mu$m] | 1.1 | 0.3 | 1.0 | 0.8 | 1.6 |
| | | $L_{off}$/D | 3.6, 5.5, 7.3, 9.1, 11, 13 | 13, 20, 27, 33, 40, 47 | 4.0, 6.0, 8.0, 10, 12, 14 | 5.0, 7.5, 10, 13, 15, 18 | 2.5, 3.8, 5.0, 6.3, 7.5, 8.8 |
| | | $L_s$/D | 1.8, 3.6, 5.5, 7.3, 9.1, 11 | 6.7, 13, 20, 27, 33, 40 | 2.0, 4.0, 6.0, 8.0, 10, 12 | 2.5, 5.0, 7.5, 10, 13, 15 | 1.3, 2.5, 3.8, 5.0, 6.3, 7.5 |
| | | Crystal state | Columnar crystal | Columnar crystal | Columnar crystal | Columnar crystal | Columnar crystal |
| | SSRM· Spread resistance value evaluation | Low-resistance region A $R_A$ [$\Omega$] | 1.3E+05 | 1.3E+05 | 8.1E+04 | 1.2E+05 | 1.0E+05 |
| | | High-resistance region B $R_B$ [$\Omega$] | 5.4E+06 | 4.5E+06 | 3.1E+06 | 2.9E+06 | 3.7E+06 |
| | | $R_B$/$R_A$ | 41 | 34 | 38 | 24 | 38 |
| | | Rs(L) | 5.4E+06 | 4.5E+06 | 3.1E+06 | 2.9E+06 | 3.7E+06 |
| | | RS($L_{off}$) | 2.0E+05 | 2.0E+05 | 1.2E+05 | 1.8E+05 | 1.5E+05 |
| | | Rs(Ls) | 1.3E+05 | 1.3E+05 | 8.1E+04 | 1.2E+05 | 1.0E+05 |
| | | Rs(L)/Rs($L_{off}$) | 27 | 22.5 | 25.1 | 16.3 | 25 |
| | | Rs(L)/Rs(Ls) | 41 | 33.7 | 37.7 | 24.4 | 38 |
| | | $\Delta$L [$\mu$m] | -0.6 | 0.1 | 0.1 | -0.3 | -0.1 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite |

(continued)

| | | | Example 21 | Example 22 | Example 23 | Example 24 | Example 25 |
|---|---|---|---|---|---|---|---|
| Performance of TFT | Vd=0.1 V | ulin Max [cm2/(V·s)] | 38.7 | 38.7 | 39.9 | 33.2 | 38.5 |
| | | $\Delta\mu$lin [cm2/(V·s)] | 1.6 | 1.6 | 1.6 | 1.5 | 1.2 |
| | | S value [V/decade] | 0.5 | 0.5 | 0.5 | 0.5 | 0.4 |
| | | Vth [V] | -0.3 | -0.9 | -0.9 | 1.4 | 0.2 |
| | | $\Delta$Vth | 0.6 | 0.3 | 0.5 | 0.6 | 0.5 |
| | Vd=20 V | usat Max [cm2/(V·s)] | 35.8 | 35.2 | 36.1 | 30.5 | 35.3 |
| | | $\Delta\mu$sat [cm2/(V·s)] | 1.3 | 0.5 | 1.6 | 1 | 0.7 |
| | | S value [V/decade] | 0.6 | 0.4 | 0.4 | 0.4 | 0.5 |
| | | Vth [V] | -0.25 | -0.9 | -0.85 | 1.45 | 0.3 |
| | | $\Delta$Vth | 0.5 | 0.2 | 0.6 | 0.1 | 0.5 |
| | Presence or absence of DIBL phenomenon | | Absent | Absent | Absent | Absent | Absent |

Table 29

| | | | Example 26 | Example 27 | Example 28 | Example 29 | Example 30 |
|---|---|---|---|---|---|---|---|
| Evaluation of channel layer | Cross-sectional TEM image | Average arain boundary anale $\theta$ [°] | 84.7 | 103.1 | 92.8 | 101.2 | 89.7 |
| | | Average grain boundary angle $\theta$ sub [°] | 84.7 | 103.1 | 92.8 | 101.2 | 89.7 |
| | | Average spacing D between crystal grain boundaries [$\mu$m] | 0.7 | 0.7 | 0.4 | 0.4 | 0.6 |
| | | $L_{off}$/D | 5.7, 8.6, 11, 14, 17, 20 | 5.7, 8.6, 11, 14, 17, 20 | 10, 15, 20, 25, 30, 35 | 10, 15, 20, 25, 30, 35 | 6.7, 10, 13, 17, 20, 23 |
| | | $L_s$/D | 2.9, 5.7, 8.6, 11, 14, 17 | 2.9, 5.7, 8.6, 11, 14, 17 | 5, 10, 15, 20, 25, 30 | 5, 10, 15, 20, 25, 30 | 3.3, 6.7, 10, 13, 17, 20 |
| | | Crystal state | Columnar crystal | Columnar crystal | Columnar crystal | Columnar crystal | Columnar crystal |
| | SSRM Spread resistance value evaluation | Low-resistance region A $R_A$ [$\Omega$] | 1.2E+05 | 1.3E+05 | 1.3E+05 | 6.6E+04 | 2.4E+04 |
| | | High-resistance region B $R_B$ [$\Omega$] | 5.1E+06 | 3.9E+06 | 3.9E+06 | 3.3E+06 | 6.7E+05 |
| | | $R_B$/$R_A$ | 43 | 31 | 29 | 50 | 28 |
| | | Rs(L) | 5.1E+06 | 3.9E+06 | 3.9E+06 | 3.3E+06 | 6.7E+05 |
| | | Rs($L_{off}$) | 1.8E+05 | 1.9E+05 | 2.0E+05 | 9.8E+04 | 3.5E+04 |
| | | Rs(Ls) | 1.2E+05 | 1.3E+05 | 1.3E+05 | 6.6E+04 | 2.4E+04 |
| | | Rs(L)/Rs($L_{off}$) | 29 | 21 | 19 | 33.1 | 19 |
| | | Rs(L)/Rs(Ls) | 43 | 31 | 29 | 49.7 | 28 |
| | | $\Delta$L [$\mu$m] | -0.7 | -0.6 | 0.2 | 0.2 | -0.8 |
| | SCM dC/dV evaluation | Magnitudes of boundary region (A-B) and reoion (B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite |

(continued)

| | | | Example 26 | Example 27 | Example 28 | Example 29 | Example 30 |
|---|---|---|---|---|---|---|---|
| Performance of TFT | Vd=0.1 V | ulin Max [cm2/(V·s)) | 38.5 | 33.7 | 38.5 | 34.5 | 39.7 |
| | | △μlin [cm2/(V·s)] | 1.1 | 1.6 | 1.2 | 1.4 | 1.2 |
| | | S value IV/decadel | 0.5 | 0.4 | 0.5 | 0.4 | 0.5 |
| | | Vth [V] | 0.4 | -0.6 | 0.1 | 0.2 | -0.9 |
| | | △Vth | 0.3 | 0.6 | 0.5 | 0.1 | 0.4 |
| | Vd=20 V | usat Max [cm2/(V·s) | 35.3 | 30.9 | 35.3 | 31.2 | 36.5 |
| | | △μsat cm2/(V·s)] | 1.8 | 1.1 | 1.1 | 1.7 | 0.6 |
| | | S value [V/decade] | 0.4 | 0.5 | 0.4 | 0.6 | 0.5 |
| | | Vth [V] | 0.5 | -0.6 | 0.2 | 0.3 | -0.9 |
| | | △Vth | 0.4 | 0.6 | 0.3 | 0.2 | 0.6 |
| | Presence orabsence of | Prosence or absence DIBL phenomenon | Absent | Absent | Absent | Absent | Absent |

Table 30

| | | | Example 31 | Example 32 | Example 33 | Example 34 | Example 34A | Example 34B |
|---|---|---|---|---|---|---|---|---|
| Evaluation of channel layer | Cross-sectional TEM image | Average grain boundary angle $\theta$ [°] | 109.9 | 93.6 | 96.4 | 99.8 | 100.3 | 99.5 |
| | | Average grain boundary angle $\theta$ sub [°] | 109.9 | 93.6 | 96.4 | 99.8 | 100.3 | 99.5 |
| | | Average spacing D between crystal grain boundaries [$\mu$m] | 0.3 | 0.3 | 0.2 | 1.1 | 0.9 | 1.1 |
| | | $L_{off}$/D | 13, 20, 27, 40, 47 | 13,20,27,40,47 | 20, 30, 40, 60, 70 | 3.6, 5.5, 7.3,11,13 | 4.4,1.4, 5.9,1.7, 7.1, 2.0 | 3.6, 5.5, 7.3, 11, 13 |
| | | $L_s$/D | 6.7, 13, 20, 27, 40 | 6.7, 13, 20, 27, 40 | 10, 20, 30, 40, 60 | 1.8.3.6, 5.5, 7.3, 11 | 2.2, 1.8, 3.3, 2.4, 42, 2.9 | 1.8,3.6, 5.5, 7.3, 11 |
| | | Crvstal state | Columnar crystal | Columnar crystal | Columnar crystal | Columnar crvstal | Columnar crystal | Columnar crystal |
| | SSRM Spread resistance value evaluation | Low-resistance region A $R_A$ [$\Omega$] | 3.5E+04 | 8.1E+04 | 1.2E+05 | 72E+04 | 7.1E+04 | 7.3E+04 |
| | | High-resistance region B $R_B$ [$\Omega$] | 6.7E+05 | 1.8E+06 | 2.8E+06 | 1.1 E+06 | 8.0E+05 | 5.9E+05 |
| | | $R_B$/$R_A$ | 19 | 22 | 23 | 16 | 11 | 8 |
| | | Rs(L) | 6.7E+05 | 1.8E+06 | 2.8E+06 | 1.1 E+06 | 1.1 E+06 | 1.1E+06 |
| | | Rs($L_{off}$) | 5.3E+04 | 1.2E+05 | 1.8E+05 | 1.1 E+05 | 1.1 E+05 | 1.1E+05 |
| | | Rs(Ls) | 3.5E+04 | 8.1E+04 | 1.2E+05 | 7.2E+04 | 7.2E+04 | 7.2E+04 |
| | | Rs(L)/Rs($L_{off}$) | 13 | 14.9 | 15.6 | 10.4 | 10.4 | 10.4 |
| | | Rs(L)/Rs(Ls) | 19 | 22.3 | 23.4 | 15.6 | 15.6 | 15.6 |
| | | $\Delta$L [$\mu$m] | 0.0 | 0.0 | -0.3 | -0.1 | -0.5 | -0.6 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |

| | | | Example 31 | Example 32 | Example 33 | Example 34 | Example 34A | Example 34B |
|---|---|---|---|---|---|---|---|---|
| | Electron beam diffraction | Crystal structure | Bixbyite | Bixbyite | Bixbyite | Bixbyite | Bixbyite | Bixbyite |
| Performance of TFT | Vd=0.1 V | ulin Max [cm2/(V·s)] | 32.6 | 39.6 | 31.2 | 33.5 | 34.2 | 37.5 |
| | | $\triangle$ulin [cm2/V·s] | 1.2 | 1.5 | 1.5 | 1.6 | 2.5 | 4.8 |
| | | S value [V/decade] | 0.5 | 0.4 | 0.5 | 0.5 | 0.5 | 0.5 |
| | | Vth [V] | -0.5 | 0.1 | 0.4 | 1.3 | -1.5 | -1.8 |
| | | $\triangle$Vth | 0.1 | 0.2 | 0.5 | 0.5 | 0.8 | 1.2 |
| | Vd=20 V | usat Max [cm2/V·s] | 29.3 | 36.6 | 28.3 | 30.8 | 32.8 | 36.2 |
| | | $\triangle\mu$sat [cm2/(V·s)] | 1.7 | 1.8 | 1.8 | 1.3 | 2.1 | 3.2 |
| | | S value [V/decade] | 0.4 | 0.4 | 0.5 | 0.6 | 0.6 | 0.6 |
| | | Vth [V] | -0.5 | 0.2 | 0.5 | 1.4 | -1.8 | -2.4 |
| | | $\triangle$Vth | 0.5 | 0.3 | 0.2 | 0.4 | 0.6 | 1.2 |
| | Presence or absence of | DIBL phenomenon | Absent | Absent | Absent | Absent | Absent | Absent |

Examples 35 to 216

TFTs were each produced in the same manner as in Example 1 except that: an oxide sputtering target obtained from a raw material mixture having a loaded composition ratio shown in each of Tables 31to 55 was used in (2) Formation of Oxide Thin Film in Example 1; and the sputtering conditions for the oxide thin film were changed as shown in each of Table 31 to 55.
The evaluation results of the resultant channel layer and the performances of the TFTs are shown in Table 31 to 55.

Table 31

| | | | Example 35 | Example 36 | Example 37 | Example 38 | Example 39 | Example 40 | Example 41 | Example 42 |
|---|---|---|---|---|---|---|---|---|---|---|
| Sputtering target | Loaded composition ratio | $In_2O_3$ | 96.5 | 99.6 | 89.2 | 97.4 | 85.1 | 96.3 | 85.0 | 96.2 |
| | | $X_2O_3$[mass%] | 3.5 | 0.4 | 10.8 | 2.6 | 14.9 | 3.7 | 15.0 | 3.8 |
| | | X element | Al | Al | Y | Y | La | La | Ce | Ce |
| | Metal composition ratio | In [at%] | 91.0 | 99.0 | 87.0 | 96.8 | 87.0 | 96.8 | 87.0 | 96.8 |
| | | X [at%] | 9.0 | 1.0 | 13.0 | 3.2 | 13.0 | 3.2 | 13.0 | 3.2 |
| | | X element | Al | Al | Y | Y | La | La | Ce | Ce |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| | | | Example 35 | Example 36 | Example 37 | Example 38 | Example 39 | Example 40 | Example 41 | Example 42 |
|---|---|---|---|---|---|---|---|---|---|---|
| Evaluation of channel layer | Cross-sectional TEM image | Average grain boundary angle $\theta$ [°] | 91.2 | 74.9 | 81 | 72.1 | 89.7 | 78.7 | 86.8 | 107.8 |
| | | Average grain boundary angle $\theta$ sub [°] | 91.2 | 74.9 | 81 | 72.1 | 89.7 | 78.7 | 86.8 | 107.8 |
| | | Average spacing D between boundaries | 0.7 | 1.4 | 0.2 | 1.7 | 2 | 1.3 | 1.1 | 1.9 |
| | | crystal grain [$\mu$m] Crystal state | Columnar crystal | Columnar crystal | Columnar crystal | Columnar crystal | Columnar crystal | Columnar crystal | Columnar crystal | Columnar crystal |
| | SSRM Spread resistance value evaluation | Low-resistance region A $R_A$ [$\Omega$] | 8.5E+04 | 1.3E+05 | 9.4E+04 | 8.9E+04 | 1.3E+05 | 6.4E+04 | 8.7E+04 | 1.3E+05 |
| | | High-resistance region B $R_B$ [$\Omega$] | 3.2E+06 | 5.8E+06 | 4.1E+06 | 1.5E+06 | 6.5E+06 | 3.2E+06 | 3.3E+06 | 3.4E+06 |
| | | $R_B/R_A$ | 38 | 46 | 44 | 17 | 50 | 50 | 38 | 25 |
| | | Rs(L) | 3.2E+06 | 5.8E+06 | 4.1E+06 | 1.5E+06 | 6.5E+06 | 3.2E+06 | 3.3E+06 | 3.4E+06 |
| | | Rs($L_{off}$) | 1.3E+05 | 1.9E+05 | 1.4E+05 | 1.3E+05 | 2.0E+05 | 9.6E+04 | 1.3E+05 | 2.0E+05 |
| | | Rs(Ls) | 8.5E+04 | 1.3E+05 | 9.4E+04 | 8.9E+04 | 1.3E+05 | 6.4E+04 | 8.7E+04 | 1.3E+05 |
| | | Rs(L)/Rs($L_{off}$) | 25 | 30 | 29 | 11 | 33 | 33 | 25 | 17 |
| | | Rs(L)/Rs(Ls) | 38 | 46 | 44 | 17 | 50 | 50 | 38 | 25 |
| | | $\Delta$L [$\mu$m] | 0.1 | -0.2 | -0.1 | -0.5 | 0.2 | -0.7 | 0.2 | -0.4 |
| | SCM·dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

(continued)

| | | | Example 35 | Example 36 | Example 37 | Example 38 | Example 39 | Example 40 | Example 41 | Example 42 |
|---|---|---|---|---|---|---|---|---|---|---|
| Performance of TFT | Vd=0.1 V | μlin Max [cm2/V·s] | 40.2 | 38.7 | 34.2 | 33 | 33.3 | 40 | 38.8 | 33.8 |
| | | Δμlin [cm2/(V·s)] | 1.4 | 1.5 | 1.2 | 1.1 | 1.1 | 1.5 | 1.1 | 1.5 |
| | | S value [V/decade] | 0.5 | 0.5 | 0.5 | 0.5 | 0.4 | 0.4 | 0.5 | 0.5 |
| | | Vth [V] | 1 | 1.1 | 0.7 | 0.1 | 0.6 | -0.4 | -0.4 | 0.4 |
| | | ΔVth | 0.1 | 0.5 | 0.3 | 0.3 | 0.4 | 0.2 | 0.2 | 0.5 |
| | Vd=20 V | μsat Max [cm2/V·s] | 37.3 | 35.9 | 31.2 | 30 | 30.3 | 37.2 | 35.9 | 30.9 |
| | | Δμsat [cm2[V·s)] | 1.1 | 1.0 | 0.6 | 1.3 | 1.6 | 1.7 | 1.7 | 0.5 |
| | | S value [V/decade] | 0.4 | 0.4 | 0.4 | 0.6 | 0.4 | 0.4 | 0.5 | 0.5 |
| | | Vth [V] | 1.1 | 1.2 | 0.8 | 0.2 | 0.7 | -0.4 | -0.4 | 0.5 |
| | | ΔVth | 0.3 | 0.4 | 0.5 | 0.1 | 0.5 | 0.5 | 0.3 | 0.3 |
| | | Presence or absence of DIBL phenomenon | Absent | Absent | Absent | Absent | Absent | Absent | Absent | Absent |

Table 32

| | | | Example 43 | Example 44 | Example 45 | Example 46 | Example 47 | Example 48 | Example 49 | Example 50 |
|---|---|---|---|---|---|---|---|---|---|---|
| Sputtering target | Loaded composition ratio | $In_2O_3$ [mass%] | 84.9 | 96.2 | 84.7 | 96.1 | 84.2 | 96.0 | 83.3 | 95.7 |
| | | $X_2O_3$ [mass%] | 15.1 | 3.8 | 15.3 | 3.9 | 15.8 | 4.0 | 16.7 | 4.3 |
| | | X element | Pr | Pr | Nd | Nd | Sm | Sm | Dv | Dv |
| | Metal composition ratio | In [at%] | 87.0 | 96.8 | 87.0 | 96.8 | 87.0 | 96.8 | 87.0 | 96.8 |
| | | X [at%] | 13.0 | 3.2 | 13.0 | 3.2 | 13.0 | 3.2 | 13.0 | 32 |
| | | X element | Pr | Pr | Nd | Nd | Sm | Sm | Dv | Dv |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure attime of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic fluxdensitv [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

| | | | Example 43 | Example 44 | Example 45 | Example 46 | Example 47 | Example 48 | Example 49 | Example 50 |
|---|---|---|---|---|---|---|---|---|---|---|
| Evaluation of channel layer | Cross-sectional TEM image | Average grain boundarvanqle θ [°] | 87.8 | 104.5 | 81.1 | 100.4 | 105.2 | 73.8 | 93 | 109.8 |
| | | Average grain boundary angle θsub [°] | 87.8 | 104.5 | 81.1 | 100.4 | 105.2 | 73.8 | 93 | 109.8 |
| | | Average spacing D between crystal grain boundaries [μm] | 1.1 | 0.1 | 1.7 | 2 | 0.8 | 1.6 | 1.5 | 1 |
| | | Crystal state | Columnar crystal | Columnar crystal | Columnar crystal | Columnar crystal | Columnar crystal | Columnar crystal | Columnar crystal | Columnar crystal |
| | SSRM Spread resistance value evaluation | Low-resistance region A $R_A$ [Ω] | 8.2E+04 | 1.4E+05 | 1.1E+05 | 1.2E+05 | 9.6E+04 | 6.5E+04 | 7.8E-04 | 3.4E+04 |
| | | High-resistance region B $R_B$ [Ω] | 1.6E+06 | 2.8E+06 | 5.2E+06 | 3.1E+06 | 3.2E+06 | 3.1E+06 | 2.8E+06 | 1.7E+06 |
| | | $R_B/R_A$ | 19 | 20 | 46 | 26 | 33 | 47 | 36 | 50 |
| | | Rs(L) | 1.6E+06 | 2.8E+06 | 5.2E+06 | 3.1E+06 | 3.2E+06 | 3.1E+06 | 2.8E+06 | 1.7E+06 |
| | | Rs($L_{off}$) | 1.2E+05 | 2.1E+05 | 1.7E+05 | 1.7E+05 | 1.4E+05 | 9.8E+04 | 1.2E+05 | 5.1E+04 |
| | | Rs(Ls) | 8.2E+04 | 1.4E+05 | 1.1E+05 | 1.2E+05 | 9.6E+04 | 6.5 E+04 | 7.8E+04 | 3.4E+04 |
| | | Rs(L)/Rs($L_{off}$) | 13 | 14 | 31 | 18 | 22 | 31 | 24 | 33 |
| | | Rs(L)/Rs(Ls) | 19 | 20 | 46 | 26 | 33 | 47 | 36 | 50 |
| | | ΔL [μm] | -0.4 | -0.6 | -0.1 | -0.6 | -0.6 | 0.1 | -0.9 | -0.6 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

EP 4 418 330 A1

(continued)

| | | | Example 43 | Example 44 | Example 45 | Example 46 | Example 47 | Example 48 | Example 49 | Example 50 |
|---|---|---|---|---|---|---|---|---|---|---|
| Performance of TFT | Vd=0.1 V | ulin Max [cm2/(V·s)] | 39.7 | 37.3 | 34.2 | 39.7 | 32.7 | 34.4 | 37.3 | 37.1 |
| | | Δμlin [cm2/(V·s)] | 1.1 | 1.3 | 1.1 | 1.4 | 1.4 | 1.5 | 1.5 | 1.3 |
| | | S value [V/decade] | 0.5 | 0.4 | 0.4 | 0.5 | 0.4 | 0.5 | 0.4 | 0.4 |
| | | Vth [V] | -0.8 | -0.1 | -0.9 | 1 | 0.1 | 0.9 | -0.6 | -0.3 |
| | | ΔVth | 0.4 | 0.5 | 0.3 | 0.2 | 0.5 | 0.5 | 0.2 | 0.4 |
| | Vd=20 V | μsat Max [cm2/(V·s)] | 36.7 | 34.4 | 31.3 | 36.9 | 29.9 | 31.6 | 34.4 | 34.2 |
| | | Δμsat cm2/(V·s)] | 0.9 | 1.4 | 0.6 | 0.8 | 1.7 | 1 | 1.7 | 1.5 |
| | | S value [V/decade] | 0.6 | 0.4 | 0.5 | 0.4 | 0.6 | 0.4 | 0.5 | 0.5 |
| | | Vth [V] | -0.8 | -0.1 | -0.9 | 1.1 | 0.2 | 1.0 | -0.6 | -0.3 |
| | | ΔVth | 0.1 | 0.4 | 0.2 | 0.6 | 0.1 | 0.1 | 0.4 | 0.4 |
| Presence absence Presence of absence of DIBL phenomenon | | | Absent | Absent | Absent | Absent | Absent | Absent | Absent | Absent |

Table 33

| | | | Example 51 | Example 52 | Example 53 | Example 54 | Example 55 | Example 56 | Example 57 | Example 58 |
|---|---|---|---|---|---|---|---|---|---|---|
| Sputtering target | | $In_2O_3$ [mass%] | 83.1 | 95.7 | 82.9 | 95.6 | 82.8 | 95.6 | 82.5 | 95.5 |
| | Loaded composition ratio | $X_2O_3$ [mass%] | 16.9 | 4.3 | 17.1 | 4.4 | 17.2 | 4.4 | 17.5 | 4.5 |
| | | X element | Ho | Ho | Er | Er | Tm | Tm | Yb | Yb |
| | | In [at%] | 87.0 | 96.8 | 87.0 | 96.8 | 87.0 | 96.8 | 87.0 | 96.8 |
| | Metal composition ratio | X [at%] | 13.0 | 3.2 | 13.0 | 3.2 | 13.0 | 3.2 | 13.0 | 3.2 |
| | | X element | Ho | Ho | Er | Er | Tm | Tm | Yb | Yb |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| | | | Example 51 | Example 52 | Example 53 | Example 54 | Example 55 | Example 56 | Example 57 | Example 58 |
|---|---|---|---|---|---|---|---|---|---|---|
| Evaluation of channel layer | Cross-sectional TEM image | Average grain boundary angle θ [°] | 70.7 | 109.4 | 71 | 97 | 80.4 | 99.3 | 108.1 | 76.1 |
| | | Average grain boundary angle θsub [°] | 70.7 | 109.4 | 71 | 97 | 80.4 | 99.3 | 108.1 | 76.1 |
| | | Average spacing D between crystal grain boundaries [μm] | 0.7 | 1.3 | 0.5 | 1.3 | 1 | 0.4 | 0.1 | 0.6 |
| | | Crystal state | Columnar crystal | Columnar crystal | Columnar crystal | Columnar crystal | Columnar crystal | Columnar crystal | Columnar crystal | Columnar crystal |
| | SSRM Spread resistance value evaluation | Low-resistance region A $R_A$ [Ω] | 4.7E+04 | 7.8E+04 | 2.9E+04 | 4.3E+04 | 4.9E+04 | 1.2E+05 | 6.3E+04 | 1.2E+05 |
| | | High-resistance region B $R_B$ [Ω] | 7.1E+05 | 2.5E+06 | 1.4E+06 | 6.8E+05 | 2.2E+06 | 5.4E+06 | 1.3E+06 | 2.9E+06 |
| | | $R_B/R_A$ | 15 | 32 | 50 | 16 | 45 | 47 | 20 | 25 |
| | | Rs(L) | 7.1E+05 | 2.5E+06 | 1.4E+06 | 6.8E+05 | 2.2E+06 | 5.4E+06 | 1.3E+06 | 2.9E+06 |
| | | Rs(L_off) | 7.1E+04 | 1.2E+05 | 4.3E+04 | 6.4E+04 | 7.3E+04 | 1.7E+05 | 9.5E+04 | 1.7E+05 |
| | | Rs(Ls) | 4.7E+04 | 7.8E+04 | 2.9E+04 | 4.3E+04 | 4.9E+04 | 1.2E+05 | 6.3E+04 | 1.2E+05 |
| | | Rs(L)/Rs(L_off) | 10 | 22 | 33 | 11 | 30 | 31 | 14 | 17 |
| | | Rs(L)/Rs(Ls) | 15 | 32 | 50 | 16 | 45 | 47 | 20 | 25 |
| | | ΔL [μm] | -0.9 | -0.5 | -0.8 | -0.2 | -0.2 | 0.0 | -0.9 | -0.6 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

| | | | Example 51 | Example 52 | Example 53 | Example 54 | Example 55 | Example 56 | Example 57 | Example 58 |
|---|---|---|---|---|---|---|---|---|---|---|
| Performance of TFT | Vd=0.1 V | μlin Max[cm2/V·s)] | 36.4 | 35 | 38.8 | 34.9 | 35.0 | 35.0 | 39.3 | 38.2 |
| | | △ulin [cm2/(V·s)] | 1.1 | 1.6 | 1.6 | 1.4 | 1.1 | 1.6 | 1.3 | 1.3 |
| | | S value [V/decade] | 0.4 | 0.5 | 0.5 | 0.4 | 0.5 | 0.5 | 0.4 | 0.5 |
| | | Vth [V] | 0.6 | -0.4 | -0.2 | 0.6 | 0.2 | 0 | -0.7 | -0.6 |
| | | △Vth | 0.3 | 0.5 | 0.3 | 0.6 | 0.1 | 0.3 | 0.3 | 0.6 |
| | Vd=20 V | μsat Max [cm2/(V·s)] | 33.5 | 32.1 | 35.9 | 32.1 | 32 | 32.2 | 36.5 | 35.2 |
| | | △μsat [cm2/(V·s)] | 1.1 | 1 | 0.9 | 1.4 | 1.6 | 1.1 | 1.3 | 1.7 |
| | | S value [V/decade] | 0.4 | 0.6 | 0.4 | 0.6 | 0.5 | 0.6 | 0.6 | 0.6 |
| | | Vth[V] | 0.7 | -0.4 | -0.2 | 0.7 | 0.3 | 0.1 | -0.7 | -0.6 |
| | | △Vth | 0.3 | 0.2 | 0.1 | 0.2 | 0.1 | 0.4 | 0.5 | 0.1 |
| | Presence or absent Presence or absence of DIBL phenomenon | | Absent | Absent | Absent | Absent | Absent | Absent | Absent | Absent |

EP 4 418 330 A1

Table 34

| | | | Example 59 | Example 60 | Example 61 | Example 62 | Example 63 | Example 64 | Example 65 | Example 66 |
|---|---|---|---|---|---|---|---|---|---|---|
| Sputtering target | Loaded composition ratio [mass%] | In$_2$O$_3$ [mass%] | 82.4 | 95.5 | 91.9 | 98.1 | 92.1 | 98.1 | 88.3 | 97.1 |
| | | Metal oxide [mass%] | 17.6 | 4.5 | 8.1 | 1.9 | 7.9 | 1.9 | 11.7 | 2.9 |
| | | Kind of metal oxide | Lu2O3 | Lu2O3 | ZnO | ZnO | TiO2 | TiO2 | ZrO2 | ZrO2 |
| | Metal composition ratio [at%] | In [at %] | 87.0 | 96.8 | 87.0 | 96.8 | 87.0 | 96.8 | 87.0 | 96.8 |
| | | X [at %] | 13.0 | 3.2 | 13.0 | 3.2 | 13.0 | 3.2 | 13.0 | 3.2 |
| | | X element | Lu | Lu | Zn | Zn | Ti | Ti | Zr | Zr |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic fluxdensity [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| Evaluation of channel layer | | | | Example 59 | Example 60 | Example 61 | Example 62 | Example 63 | Example 64 | Example 65 | Example 66 |
|---|---|---|---|---|---|---|---|---|---|---|---|
| | Cross-sectional TEM image | | Average grain boundary angle θ [°] | 101.1 | 89.4 | 97.5 | 97.5 | 106.4 | 90.9 | 72.3 | 103.8 |
| | | | Average grain boundary annle θsub [°] | 101.1 | 89.4 | 97.5 | 97.5 | 106.4 | 90.9 | 72.3 | 103.8 |
| | | | Average spacing D between crystal grain boundaries [μm] | 0.4 | 0.7 | 0.1 | 1.2 | 0.1 | 0.8 | 1.3 | 1.8 |
| | | | Crystal state | Columnar crystal | Columnar crystal | Columnar crystal | Columnar crystal | Columnar crystal | Columnar crystal | Columnar crystal | Columnar crystal |
| | SSRM Spread resistance value evaluation | | Low-resistance region A $R_A$ [Ω] | 7.9E+04 | 5.2E+04 | 6.9E+04 | 6.9E+04 | 1.0E+0.5 | 4.7E+04 | 6.8E+04 | 3.4E+04 |
| | | | High-resistance region B $R_e$ [Ω] | 1.5E+06 | 2.0E+06 | 2.9E+06 | 3.1E+06 | 3.5E+06 | 2.3E+06 | 1.8E+06 | 1.4E+06 |
| | | | $R_B/R_A$ | 19 | 39 | 43 | 45 | 35 | 49 | 26 | 41 |
| | | | Rs(L) | 1.5E+06 | 2.0E+06 | 2.9E+06 | 3.1E+06 | 3.5E+06 | 2.3E+06 | 1.8E+06 | 1.4E+06 |
| | | | Rs($L_{off}$) | 1.2E+05 | 7.8E+04 | 1.0E+05 | 1.0E+05 | 1.5E+05 | 7.1E+04 | 1.0E+05 | 5.1E+04 |
| | | | Rs(Ls) | 7.9E+04 | 5.2E+04 | 6.9E+04 | 6.9E+04 | 1.0E+05 | 4.7E+04 | 6.8E+04 | 3.4E+04 |
| | | | Rs(L)/Rs($L_{off}$) | 13 | 26 | 28 | 30 | 23 | 32 | 18 | 28 |
| | | | Rs(L)Rs(Ls) | 19 | 39 | 43 | 45 | 35 | 49 | 26 | 41 |
| | | | ΔL [μm] | -0.6 | -0.6 | -0.2 | -0.5 | -0.1 | -0.9 | -0.8 | -0.4 |
| | SCM dC/dV evaluation | | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | | Crystal structure | Bixbyite | Bixbyite | Bixbyite | Bixbyite | Bixbyite | Bixbyite | Bixbyite | Bixbyite |

(continued)

| | | | Example 59 | Example 60 | Example 61 | Example 62 | Example 63 | Example 64 | Example 65 | Example 66 |
|---|---|---|---|---|---|---|---|---|---|---|
| Performance of TFT | Vd=0.1 V | $\mu$lin Max[cm2/(V·s)] | 39.1 | 38.1 | 35.5 | 39.1 | 35 | 34.5 | 36.6 | 37.7 |
| | | $\Delta\mu$lin [cm2/(Vs)] | 1.6 | 1.2 | 1.5 | 1.5 | 1.5 | 1.5 | 1.6 | 1.4 |
| | | S value [V/decade] | 0.5 | 0.5 | 0.4 | 0.5 | 0.5 | 0.4 | 0.4 | 0.4 |
| | | Vth [V] | 1.2 | 0.2 | 0.7 | 0.8 | 0.8 | 0.3 | -1 | -0.9 |
| | | $\Delta$Vth | 0.5 | 0.2 | 0.4 | 0.1 | 0.2 | 0.5 | 0.1 | 0.3 |
| | Vd=20 V | $\mu$sat Max [cm2/(V·s)] | 36.3 | 35.2 | 32.5 | 36.1 | 32 | 31.5 | 33.7 | 34.9 |
| | | $\Delta\mu$sat [cm2/(V·s)] | 0.9 | 1.6 | 0.6 | 1.7 | 0.5 | 0.9 | 1.1 | 0.7 |
| | | S value [V/decade] | 0.6 | 0.4 | 0.4 | 0.4 | 0.6 | 0.6 | 0.4 | 0.5 |
| | | Vth IV1 | 1.3 | 0.3 | 0.8 | 0.9 | 0.9 | 0.4 | -1.0 | -0.9 |
| | | $\Delta$Vth | 0.2 | 0.6 | 0.2 | 0.6 | 0.5 | 0.5 | 0.1 | 0.3 |
| | Presence or absence of DIBL phenomenon | | Absent | Absent | Absent | Absent | Absent | Absent | Absent | Absent |

Table 35

| | | | Example 67 | Example 68 | Example 69 | Example 70 | Example 71 | Example 72 | Example 73 | Example 74 |
|---|---|---|---|---|---|---|---|---|---|---|
| Sputtering target | Loaded composition ratio [mass%] | $In_2O_3$ mass%] | 86.6 | 98.7 | 85.0 | 96.5 | 81.5 | 95.2 | 80.0 | 74 |
| | | Metal oxide [mass%] | 13.4 | 3.3 | 140 | 3.5 | 18.5 | 4.8 | 20.0 | 5.2 |
| | | Kind of metal oxide | MoO3 | MoO3 | SnO2 | SnO2 | HfO2 | HfO2 | WO3 | WO3 |
| | Metal composition ratio [at%] | In [at %] | 87.0 | 96.8 | 87.0 | 96.8 | 87.0 | 96.8 | 87.0 | 96.8 |
| | | X [an %] | 130 | 32 | 13.0 | 32 | 130 | 32 | 13.0 | 32 |
| | | < element | Mo | Mo | Sn | Sn | Hf | Hf | w | w |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness tnm7 | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| | | | Example 67 | Example 68 | Example 69 | Example 70 | Example 71 | Example 72 | Example 73 | Example 74 |
|---|---|---|---|---|---|---|---|---|---|---|
| Cross-sectionalTEM image | | Average grain boundary angle θ [°] | 101.7 | 76 4 | 105.4 | 85,5 | 776 | 71.8 | 89 8 | 96.9 |
| | | Average grain boundary angle θsub P1 | 101.7 | 76.4 | 105.4 | 85.5 | 776 | 71.8 | 89.8 | 96.9 |
| | | Average spacing D between crystal rain boundaries [μm] | 0.8 | 0.5 | 2 | 13 | 0.6 | 1 | 2 | 04 |
| | | Crystal state | | Columnar crystal | Columnar crystal | Columnar crystal | Columnar nrxsfal | Columnar crystal | Columnarcnstal | Columnarcrvstal |

| | | | Example 67 | Example 68 | Example 69 | Example 70 | Example 71 | Example 72 | Example 73 | Example 74 |
|---|---|---|---|---|---|---|---|---|---|---|
| Evaluation of channel layer | SSRM Spread resistance value evaluation | Low-resistance region $A$ $R_A$ [$\Omega$] | 8.1E+04 | 1.1E+05 | 9.5E+04 | 4.6E+04 | 1.1E+05 | 6.1E+04 | 5.5E+04 | 5.2E+04 |
| | | High-resistance region B $R_B$ [$\Omega$] | 4.0E+06 | 2.9+06 | 3.3E+06 | 1.8E+06 | 3.3E+06 | 2.2E+06 | 1.2E+06 | 1.0E+06 |
| | | $R_B/R_A$ | 49 | 26 | 35 | 40 | 31 | 38 | 22 | 20 |
| | | Rs(L) | 4.0E+06 | 2.9E+05 | 3.3E+06 | 1.8E+06 | 33E+08 | 2.2E+06 | 12E.06 | 1.0E+66 |
| | | Rs($L_{off}$) | 1.2E+05 | 1.7E+05 | 1.4E+05 | 6.9E+04 | 1.6E+05 | 9.2E+04 | 3.2E+04 | 7.7E+04 |
| | | Rs(Ls) | 8.1E+04 | 1.1E+05 | 9.5E+04 | 4.6E+04 | 1.1E+05 | 6.1E+04 | 5.5E+04 | 5.2E+04 |
| | | Rs(L)/Rs($L_{off}$) | 33 | 17 | 23 | 27 | 21 | 24 | 15 | 13 |
| | | Rs(L)/Rs(Ls) | 49 | 26 | 35 | 40 | 31 | 36 | 22 | 20 |
| | | $\Delta$L [$\mu$m] | -0.4 | -0.8 | -0.1 | 0.2 | 02 | -0.4 | 0.2 | -0.7 |
| | SCM dC/dV evaluation | Magnitudes of boundary region (A-B) and region (B) | (A-B)>(B) | (A-B)>($\beta$) | (A-B)>(B) | (A-B)>(B) | (A-B)>(B) | (A-B)>(B) | (A-B)>(B) | (A-B)>(B) |
| | Electron beam diffraction | Crysta/ structure | Bixbyite | Bixbyite | Bixbyite | Bixbyite | Bixbyite | Bixbyite | Bixbyite | Bixbyte |

(continued)

| | | | Example 67 | Example 68 | Example 69 | Example 70 | Example 71 | Example 72 | Example 73 | Example 74 |
|---|---|---|---|---|---|---|---|---|---|---|
| Performance of TFT | Vd=0.1V | μlinMax[cm2/V·s)] | 35.2 | 36 3 | 38 1 | 128 | 32 5 | 32.6 | 37.6 | 36.9 |
| | | dulin [cm²/Vs)] | 1.4 | 1.1 | 1.3 | 1.6 | 1.5 | 14 | 1.5 | 1.5 |
| | | S value V/decade] | 0.5 | 0.4 | 0.5 | 0.5 | 04 | 0.4 | 04 | 05 |
| | | Vth[V] | 0.1 | 0.2 | 0.6 | 1 | 1 | 11 | 1 | 08 |
| | | ΔVth | 0.2 | 03 | 0.1 | 0.5 | 0.5 | 04 | 04 | 06 |
| | Vd=20 V | μsat Max [cm2(Vs)] | 32.4 | 33 3 | 35.3 | 29.9 | 29.6 | 29 7 | 34 7 | 31 |
| | | Δμsat [cm2/Vs)] | 0.5 | 1.7 | 0.5 | 1.1 | 1.3 | 1.1 | 1.7 | 12 |
| | | S value (V/decade] | 0.5 | 0.4 | 0.5 | 0.6 | 0.5 | 04 | 04 | 05 |
| | | Vth [V] | 0.2 | -0.2 | 07 | 1.1 | 1.1 | 1.2 | 1.1 | 09 |
| | | Δ Vth | 0.4 | 0.1 | 0.2 | 0.3 | 0.2 | 02 | 0.5 | 0.1 |
| Presence or absence of DIBL phenomenon | | | Absent | Absent | Absent | Absent | Absent | Absent | Absent | Absent |

Table 36

| | | | Example 75 | Example 78 | Example 77 | Example 78 | Example 79 | Example 80 | Example 81 | Example 82 |
|---|---|---|---|---|---|---|---|---|---|---|
| Sputtering target | Loaded composition ratio [mass%] | h$_2$O$_3$ [mass%] | 87.5 | 96.9 | 80.8 | 95.0 | 88.8 | 97.6 | 83.8 | 98.6 |
| | | Metal oxide [mass%] | 12.5 | 3.1 | 19.2 | 5.0 | 10.1 | 2.4 | 8.1 | 1.4 |
| | | Kind of metal oxide | Nb2O5 | Nb2O5 | Ta2O5 | Ta2O5 | GeO2 | GeO2 | SiO2 | SiO2 |
| | Metal composition ratio [at%] | In [at %] | 87.0 | 98.8 | 87.0 | 96.8 | 87.0 | 96.8 | 87.0 | 96.8 |
| | | X [at %] | 13.0 | 3.2 | 13.0 | 3.2 | 13.0 | 3.2 | 13.0 | 3.2 |
| | | X element | Nb | Nb | Ta | Ta | Ge | Ge | Si | Si |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation IPa1 | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

| | | | Example 75 | Example 78 | Example 77 | Example 78 | Example 79 | Example 80 | Example 81 | Example 82 |
|---|---|---|---|---|---|---|---|---|---|---|
| Evaluation of channel layer | Cross-sectional TEM image | Average grain boundary anole θ [°] | 81.3 | 73.9 | 81 | 106.3 | 107.2 | 78 | 104.2 | 98.1 |
| | | Average grain boundary angle θsub [°] | 81.3 | 73.9 | 81 | 106.3 | 107.2 | 78 | 104.2 | 98.1 |
| | | Average spacing D between crystal grain boundaries [μm] | 1.7 | 0.1 | 1.5 | 1.7 | 0.8 | 0.9 | 0.6 | 1.4 |
| | | Cnstal state | Columnar crystal | Columnar crystal | Columnar crystal | Columnar crystal | Columnar crystal | Columnarcrstal | Columnar crystal | Columnar crystal |
| | SSRM Spread resistance value evaluation | Low-resistance region A $R_A$ [Ω] | 5.8E+04 | 3.6E+04 | 1.0E+05 | 3.4E+04 | 1.1E+05 | 1.3E+05 | 6.4E+04 | 2.8E+04 |
| | | High-resistance region B $R_B$ [Ω] | 1.0E+06 | 6.6E+05 | 3.4E+06 | 1.6E+06 | 1.9E+06 | 3.2E+06 | 2.1E+06 | 1.2E+06 |
| | | $R_B/R_A$ | 18 | 18 | 34 | 47 | 18 | 24 | 32 | 41 |
| | | Rs(L) | 1.0E+06 | 6.6E+05 | 3.4E+06 | 1.6E+06 | 1.9E+06 | 3.2E+08 | 2.1E+06 | 1.2E+06 |
| | | Rs($L_{off}$) | 8.7E+04 | 5.4E+04 | 1.5E+05 | 5.0E+04 | 1.6E+05 | 2.0E+05 | 9.6E+04 | 4.2E+04 |
| | | Rs(Ls) | 5.8E+04 | 3.6E+04 | 1.0E+05 | 3.4E+04 | 1.1E+05 | 1.3E+05 | 6.4E+04 | 2.8E+04 |
| | | Rs(L)/Rs($L_{off}$) | 12 | 12 | 23 | 31 | 12 | 16 | 21 | 27 |
| | | Rs(L)/Rs(Ls) | 18 | 18 | 34 | 47 | 18 | 24 | 32 | 41 |
| | | ΔL [μm] | -0.4 | -0.4 | -0.1 | -0.1 | -0.4 | 0.2 | -0.5 | -0.7 |
| | SCM·dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

(continued)

| | | | Example 75 | Example 78 | Example 77 | Example 78 | Example 79 | Example 80 | Example 81 | Example 82 |
|---|---|---|---|---|---|---|---|---|---|---|
| Performance ofTFT | | $\mu$lin Max[cm2/(V·s)] | 38.7 | 34.5 | 36.0 | 37.3 | 34.3 | 33.8 | 38.3 | 37.0 |
| | Vd=0.1 v | $\Delta\mu$lin [cm2/V·s1] | 1.4 | 1.3 | 1.5 | 1.6 | 1.5 | 1.8 | 1.5 | 1.5 |
| | | S value V/decade] | 0.4 | 0.4 | 0.5 | 0.5 | 0.5 | 0.4 | 0.5 | 0.4 |
| | | Vth [V] | 0.2 | 0.1 | 0.7 | 0.3 | 0.5 | 0.8 | -0.5 | 0.2 |
| | | $\Delta$Vth | 0.1 | 0.1 | 0.5 | 0.8 | 0.8 | 0.6 | 0.2 | 0.3 |
| | Vd=20 v | $\mu$sat Max[cm2/V·s)] | 35.9 | 31.6 | 33 | 34.5 | 31.4 | 30.9 | 36.3 | 34.2 |
| | | $\Delta\mu$sat [cm2/(V·s)] | 1.5 | 1.7 | 1.8 | 1.1 | 1.4 | 0.5 | 0.5 | 1.7 |
| | | S value V/decade] | 0.4 | 0.5 | 0.8 | 0.5 | 0.8 | 0.4 | 0.4 | 0.4 |
| | | Vth [V] | 0.3 | 0.2 | 0.8 | 0.4 | 0.8 | 0.9 | -0.5 | 0.3 |
| | | $\Delta$Vth | 0.4 | 0.8 | 0.2 | 0.3 | 0.6 | 0.8 | 0.5 | 0.2 |
| | Presence or absence of DBL phenomenon | | Absent | Absent | Absent | Absent | Absent | Absent | Absent | Absent |

Table 37

| | | | Example 83 | Example 84 | Example 85 | Example 86 | Example 87 | Example 88 | Example 89 | Example 90 |
|---|---|---|---|---|---|---|---|---|---|---|
| Sputtering target | Loaded composition ratio [mass%] | $In_2O_3$ [mass%] | 83.0 | 96.6 | 82.6 | 96.5 | 83.1 | 96.6 | 83.0 | 96.6 |
| | | $Ga_2O_3$ [mass%] | 132 | 2.2 | 13.1 | 2.2 | 132 | 2.2 | 132 | 2.2 |
| | | X2O3 [mass%] | 3.8 | 1.2 | 4.3 | 1.4 | 3.7 | 1.2 | 3.8 | 1.2 |
| | | Kind of X2O3 | Nd2O3 | Nd2O3 | Ho2O3 | Ho2O3 | La2O3 | La2O3 | Ce2O3 | Ce2O3 |
| | Metal composition ratio [at%] | In [at %] | 78.5 | 95.8 | 78.5 | 95.8 | 78.5 | 95.8 | 78.5 | 95.8 |
| | | Ga [at %] | 18.5 | 3.2 | 18.5 | 3.2 | 18.5 | 3.2 | 18.5 | 3.2 |
| | | X [at %] | 3.0 | 1.0 | 3.0 | 1.0 | 3.0 | 1.0 | 3.0 | 1.0 |
| | | X element | Nd | Nd | Ho | Ho | La | La | Ce | Ce |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

| | | | Example 83 | Example 84 | Example 85 | Example 86 | Example 87 | Example 88 | Example 89 | Example 90 |
|---|---|---|---|---|---|---|---|---|---|---|
| Evaluation of channel layer | Cross-sectional TEM image | Average grain boundary angle θ [°] | 84.8 | 100.6 | 74.5 | 108.8 | 95.5 | 98.6 | 83.4 | 80.3 |
| | | Average grain boundary angle θ sub [°] | 84.8 | 100.6 | 74.5 | 108.8 | 95.5 | 98.6 | 83.4 | 80.3 |
| | | Average spacing D between crystal grain boundaries [μm] | 0.2 | 1 | 12 | 0.4 | 0.2 | 0.5 | 0.9 | 0.7 |
| | | Crystal state | Columnar crystal | Columnar crystal | Columnar crystal | Columnar crystal | Columnar crystal | Columnar crystal | Columnar crystal | Columnar crystal |
| | SSRM Spread resistance value evaluation | Low-resistance region A $R_A$ [Ω] | 8.6E+04 | 1.1E+05 | 6.0E+04 | 9.3E-04 | 2.8E+04 | 9.3E-04 | 6.6E+04 | 8.0E+04 |
| | | High-resistance region B $R_B$ [Ω] | 1.4E+06 | 2.2E+06 | 2.2E+06 | 2.0E+06 | 8.8E+05 | 2.5E+06 | 1.8E+06 | 2.1E+06 |
| | | $R_B/R_A$ | 16 | 20 | 37 | 22 | 31 | 27 | 27 | 27 |
| | | Rs(L) | 1.4E+06 | 2.2E+06 | 2.2E+06 | 2.0E+06 | 8.8E+05 | 2.5E+06 | 1.8E+06 | 2.1E+06 |
| | | Rs($L_{off}$) | 1.3E+05 | 1.6E+05 | 9.1E+04 | 1.4E+05 | 4.3E+04 | 1.4E+05 | 9.9E+04 | 1.2E+05 |
| | | Rs(Ls) | 8.6E+04 | 1.1E+05 | 6.0E+04 | 9.3E+04 | 2.8E+04 | 9.3E+04 | 6.6E+04 | 8.0E+04 |
| | | Rs(L)/Rs($L_{off}$) | 11 | 14 | 25 | 14 | 21 | 18 | 18 | 18 |
| | | Rs(L)/Rs(Ls) | 16 | 20 | 37 | 22 | 31 | 27 | 27 | 27 |
| | | ΔL [μm] | -0.3 | 0.2 | 0.2 | 0.2 | -0.3 | -0.1 | -0.1 | 0.2 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

EP 4 418 330 A1

| | | | Example 83 | Example 84 | Example 85 | Example 86 | Example 87 | Example 88 | Example 89 | Example 90 |
|---|---|---|---|---|---|---|---|---|---|---|
| Performance ofTFT | Vd=0.1 V | μlin Max [cm2/(V·s)] | 35.9 | 36.3 | 34.2 | 40 | 36.9 | 40.3 | 32.4 | 37.1 |
| | | $\Delta\mu$lin [cm2/(V·s)] | 1.3 | 1.3 | 1.2 | 1.4 | 1.2 | 1.2 | 1.1 | 1.6 |
| | | S value [V/decade] | 0.5 | 0.4 | 0.4 | 0.5 | 0.5 | 0.4 | 0.5 | 0.4 |
| | | Vth [V] | -0.4 | -0.6 | 1.4 | 1.2 | 1 | 0.4 | 1 | 0.1 |
| | | $\Delta$Vth | 0.2 | 0.2 | 0.6 | 0.5 | 0.1 | 0.1 | 0.5 | 0.5 |
| | Vd=20 V | μsat Max [cm2/(V·s)] | 33 | 33.4 | 31.4 | 37 | 34 | 37.3 | 29.6 | 34.2 |
| | | $\Delta\mu$sat [cm2/(V·s)] | 0.8 | 1.3 | 1.8 | 1.5 | 1 | 0.5 | 1.3 | 0.5 |
| | | S value [V/decade] | 0.6 | 0.5 | 0.6 | 0.6 | 0.5 | 0.5 | 0.5 | 0.4 |
| | | Vth [V] | -0.4 | -0.6 | 1.5 | 1.3 | 1.1 | 0.5 | 1.1 | 0.2 |
| | | $\Delta$Vth | 0.6 | 0.6 | 0.6 | 0.1 | 0.5 | 0.2 | 0.2 | 0.6 |
| | Presence orabsence of DIBL phenomenon | | Absent | Absent | Absent | Absent | Absent | Absent | Absent | Absent |

Table 38

| | | | Example 91 | Example 92 | Example 93 | Example 94 | Example 95 | Example 96 | Example 97 | Example 98 |
|---|---|---|---|---|---|---|---|---|---|---|
| Sputtering target | Loaded composition ratio [mass%] | $In_2O_3$ [mass%] | 83.0 | 96.6 | 82.5 | 96.4 | 82.4 | 96.4 | 82.5 | 96.4 |
| | | $Ga_2O_3$ [mass%] | 132 | 2.2 | 13.1 | 2.2 | 13.1 | 2.2 | 13.1 | 2.2 |
| | | X2O3 [mass%] | 3.8 | 1.2 | 4.4 | 1.4 | 4.5 | 1.4 | 4.3 | 1.4 |
| | | Kind of X2O3 | Pr2O3 | Pr2O3 | Tm2O3 | Tm2O3 | Yb2O3 | Yb2O3 | Er2O3 | Er2O3 |
| | Metal composition ratio [at%] | In [at %] | 78.5 | 95.8 | 78.5 | 95.8 | 78.5 | 95.8 | 78.5 | 95.8 |
| | | Ga [at %] | 18.5 | 3.2 | 18.5 | 3.2 | 18.5 | 3.2 | 18.5 | 3.2 |
| | | X [at %] | 3.0 | 1.0 | 3.0 | 1.0 | 3.0 | 1.0 | 3.0 | 1.0 |
| | | X element | Pr | Pr | Tm | Tm | Yb | Yb | Er | Er |
| TFT production conditions | Film formation layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure attime offilm formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| | | | Example 91 | Example 92 | Example 93 | Example 94 | Example 95 | Example 96 | Example 97 | Example 98 |
|---|---|---|---|---|---|---|---|---|---|---|
| Evaluation of channel layer | Cross-sectional TEM image | Average grain boundary angle θ [°] | 74.3 | 108.2 | 90.5 | 99.1 | 74.8 | 81 | 77 | 84.9 |
| | | Average grain boundary angle θ sub [°] | 74.3 | 108.2 | 90.5 | 99.1 | 74.8 | 81 | 77 | 84.9 |
| | | Average spacing D between crystal grain boundaries [μm] | 1.1 | 1.2 | 1.9 | 2 | 0.8 | 0.1 | 1.3 | 0.4 |
| | | Crystal state | Columnar crystal | Columnar crystal | Columnar crystal | Columnar crystal | Columnar crystal | Columnar crystal | Columnar crystal | Columnar crystal |
| | SSRM Spread resistance value evaluation | Low-resistance region A $R_A$ [Ω] | 8.9E+04 | 4.5E+04 | 1.1 E+05 | 1.0E+05 | 9.3E+04 | 1.3E+05 | 4.4E+04 | 5.3E+04 |
| | | High-resistance region B $R_B$ [Ω] | 4.3E+06 | 8.9E+05 | 3.5E+06 | 3.3E+06 | 3.5E+06 | 4.0E+06 | 2.0E+06 | 1.2E+06 |
| | | $R_B/R_A$ | 48 | 20 | 32 | 33 | 37 | 31 | 45 | 22 |
| | | Rs(L) | 4.3E+06 | 8.9E+05 | 3.5E+06 | 3.3E+06 | 3.5E+06 | 4.0E+06 | 2.0E+06 | 1.2E+06 |
| | | Rs($L_{off}$) | 1.3E+05 | 6.8E+04 | 1.6E+05 | 1.5E+05 | 1.4E+05 | 1.9E+05 | 6.6E+04 | 7.9E+04 |
| | | Rs(Ls) | 8.9E+04 | 4.5E+04 | 1.1E+05 | 1.0E+05 | 9.3E+04 | 1.3E+05 | 4.4E+04 | 5.3E+04 |
| | | Rs(L)/Rs($L_{off}$) | 32 | 13 | 22 | 22 | 25 | 21 | 30 | 15 |
| | | Rs(L)/Rs(Ls) | 48 | 20 | 32 | 33 | 37 | 31 | 45 | 22 |
| | | ΔL [μm] | -0.3 | -0.7 | -0.3 | 0.1 | -0.5 | 0.1 | -0.6 | -0.8 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

(continued)

| | | | Example 91 | Example 92 | Example 93 | Example 94 | Example 95 | Example 96 | Example 97 | Example 98 |
|---|---|---|---|---|---|---|---|---|---|---|
| Performance of TFT | Vd=0.1 V | ulin Max [cm2/(V·s)] | 33.7 | 36.3 | 34.1 | 34.1 | 37.8 | 37.8 | 34.2 | 35.9 |
| | | $\Delta\mu$lin [cm2/(V·s)] | 1.5 | 1.6 | 1.1 | 1.4 | 1.6 | 1.2 | 1.5 | 1.4 |
| | | S value [V/decade] | 0.4 | 0.5 | 0.4 | 0.5 | 0.4 | 0.4 | 0.4 | 0.5 |
| | | Vth [V] | 0.9 | -0.3 | -0.4 | 0 | 0.5 | 0.1 | 0.7 | 0.7 |
| | | $\Delta$Vth | 0.3 | 0.5 | 0.2 | 0.3 | 0.2 | 0.5 | 0.4 | 0.1 |
| | Vd=20 V | usat Max [cm2/(V·s)] | 30.9 | 33.3 | 31.2 | 31.3 | 34.9 | 34.9 | 31.2 | 33 |
| | | $\Delta$usat [cm2/(V·s)] | 0.7 | 1.4 | 1 | 0.7 | 0.6 | 0.6 | 0.8 | 1.2 |
| | | S value [V/decade] | 0.5 | 0.5 | 0.4 | 0.4 | 0.4 | 0.5 | 0.6 | 0.6 |
| | | Vth [V] | 1.0 | -0.3 | -0.4 | 0.1 | 0.6 | 0.2 | 0.8 | 0.8 |
| | | $\Delta$Vth | 0.6 | 0.4 | 0.5 | 0.5 | 0.1 | 0.6 | 0.5 | 0.3 |
| | Presence or absence of DIBL phenomenon | | Absent | Absent | Absent | Absent | Absent | Absent | Absent | Absent |

Table 39

| | | | Example 99 | Example 100 | Example 101 | Example 102 | Example 103 | Example 104 | Example 105 | Example 106 |
|---|---|---|---|---|---|---|---|---|---|---|
| Sputtering target | Loaded composition ratio [mass%] | In$_2$O$_3$ [mass%] | 82.4 | 96.4 | 84.0 | 97.0 | 85.4 | 96.7 | 85.0 | 95.7 |
| | | Ga$_2$O$_3$ [mass%] | 13.1 | 2.2 | 13.4 | 2.2 | 14.0 | 2.3 | 14.0 | 2.2 |
| | | X2O3 [mass%] | 4.5 | 1.4 | 2.6 | 0.8 | 0.5 | 1.0 | 1.1 | 2.0 |
| | | Kind of X2O3 | Lu2O3 | Lu2O3 | Y2O3 | Y2O3 | B2O3 | B2O3 | Sc2O3 | Sc2O3 |
| | Metal composition ratio [at%] | In [at %] | 78.5 | 95.8 | 78.5 | 95.8 | 78.8 | 92.8 | 78.8 | 92.8 |
| | | Ga [at %] | 18.5 | 3.2 | 18.5 | 32 | 19.2 | 3.2 | 19.2 | 3.2 |
| | | X [at %] | 3.0 | 1.0 | 3.0 | 1.0 | 2.0 | 4.0 | 2.0 | 4.0 |
| | | X element | Lu | Lu | Y | Y | B | B | Sc | Sc |
| TFT production conditions | Film formation of channel layer | Pressure attime of film formation [Pa] | 0.5 | 0.5 | 0.5 | 0.5 | 0.5 | 0.5 | 0.5 | 0.5 |
| | | Oxygen partial pressure attime of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

| | | | Example 99 | Example 100 | Example 101 | Example 102 | Example 103 | Example 104 | Example 105 | Example 106 |
|---|---|---|---|---|---|---|---|---|---|---|
| Evaluation of channel layer | Cross-sectional TEM image | Average grain boundary angle θ [°] | 104.4 | 88.1 | 79.5 | 74.3 | 70.8 | 89 | 107 | 109.1 |
| | | Average grain boundary angle θ sub [°] | 104.4 | 88.1 | 79.5 | 74.3 | 70.8 | 89 | 107 | 109.1 |
| | | Average spacing D between crystal grain boundaries [um] | 0.5 | 1.9 | 1.7 | 1.6 | 1.9 | 2 | 0.7 | 1.7 |
| | | Crystal state | Columnar crystal | Columnar crystal | Columnar crystal | Columnar crystal | Columnar crystal | Columnar crystal | Columnar crystal | Columnar crystal |
| | SSRM Spread resistance value evaluation | Low-resistance region A $R_A$ [Ω] | 9.9E+04 | 7.6E+04 | 1.2E+05 | 5.0E+04 | 5.7E+04 | 5.8E+04 | 1.3E+05 | 1.0E+05 |
| | | High-resistance region B $R_B$ [Ω] | 3.0E+06 | 2.5E+06 | 4.9E+06 | 2.3E+06 | 1.8E+06 | 2.0E+06 | 5.7E+06 | 4.1E+06 |
| | | $R_B/R_A$ | 30 | 34 | 42 | 46 | 33 | 35 | 45 | 39 |
| | | Rs(L) | 3.0E+06 | 2.5E+06 | 4.9E+06 | 2.3E+06 | 1.8E+06 | 2.0E+06 | 5.7E+06 | 4.1E+06 |
| | | Rs($L_{off}$) | 1.5E+05 | 1.1E+05 | 1.7E+05 | 7.5E+04 | 8.5E+04 | 8.7E+04 | 1.9E+05 | 1.6E+05 |
| | | Rs(Ls) | 9.9E+04 | 7.6E+04 | 1.2E+05 | 5.0E+04 | 5.7E+04 | 5.8E+04 | 1.3E+05 | 1.0E+05 |
| | | Rs(L)/Rs($L_{off}$) | 20 | 22 | 28 | 30 | 22 | 23 | 30 | 26 |
| | | Rs(L)/Rs(Ls) | 30 | 34 | 42 | 46 | 33 | 35 | 45 | 39 |
| | | $\Delta L$ [μm] | -0.8 | -0.4 | -0.6 | -0.6 | -0.7 | -0.7 | -0.9 | -0.9 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

EP 4 418 330 A1

(continued)

| Performance of TFT | | | Example 99 | Example 100 | Example 101 | Example 102 | Example 103 | Example 104 | Example 105 | Example 106 |
|---|---|---|---|---|---|---|---|---|---|---|
| | Vd=0.1 V | ulin Max [cm2/(V·s)] | 38.7 | 34.9 | 37.0 | 39.0 | 35.2 | 35.6 | 34.7 | 33 |
| | | Δulin [cm2/(V·s)] | 1.3 | 1.5 | 1.4 | 1.4 | 1.5 | 1.3 | 1.3 | 1.6 |
| | | S value [V/decade] | 0.5 | 0.5 | 0.4 | 0.5 | 0.4 | 0.4 | 0.5 | 0.4 |
| | | Vth [V] | 0.1 | 0.6 | 0.8 | 0.5 | 0.6 | 0.7 | 1.4 | 1.1 |
| | | ΔVth | 0.3 | 0.3 | 0.1 | 0.4 | 0.2 | 0.4 | 0.6 | 0.2 |
| | Vd=20 V | usat Max [cm2/(V·s)] | 35.7 | 32.1 | 34.2 | 36.1 | 32.3 | 32.7 | 31.9 | 30.0 |
| | | Δusat [cm2/(V·s)] | 1.5 | 0.8 | 0.7 | 1.6 | 0.6 | 0.5 | 1.2 | 1.3 |
| | | S value [V/decade] | 0.4 | 0.6 | 0.6 | 0.5 | 0.5 | 0.5 | 0.4 | 0.6 |
| | | Vth [V] | 0.2 | 0.7 | 0.9 | 0.6 | 0.7 | 0.8 | 1.5 | 1.2 |
| | | ΔVth | 0.4 | 0.6 | 0.4 | 0.5 | 0.1 | 0.4 | 0.6 | 0.1 |
| | Presence orabsence of DIBL phenomenon | | Absent | Absent | Absent | Absent | Absent | Absent | Absent | Absent |

Table 40

| | | | Example 107 | Example 108 | Example 109 | Example 110 | Example 111 | Example 112 | Example 113 | Example 114 |
|---|---|---|---|---|---|---|---|---|---|---|
| Sputtering target | Loaded composition ratio [mass%] | $In_2O_3$ [mass%] | 85.6 | 97.1 | 84.8 | 95.4 | 85.1 | 96.0 | 84.5 | 94.7 |
| | | $Ga_2O_3$ [mass%] | 14.1 | 2.3 | 13.9 | 22 | 14.0 | 2.2 | 13.9 | 2.2 |
| | | Metal oxide [mass%] | 0.3 | 0.6 | 1.3 | 2.4 | 0.9 | 1.8 | 1.6 | 3.1 |
| | | Kind of metal oxide | MoO | MgO | ZnO | ZnO | SiO2 | SiO2 | GeO2 | GeO2 |
| | Metal composition ratio [at%] | In [at %] | 78.8 | 92.8 | 78.8 | 92.8 | 78.8 | 92.8 | 78.8 | 92.8 |
| | | Ga [at %] | 192 | 3.2 | 192 | 32 | 192 | 3.2 | 192 | 3.2 |
| | | X [at%] | 2.0 | 4.0 | 2.0 | 4.0 | 2.0 | 4.0 | 2.0 | 4.0 |
| | | X element | Mg | Mg | Zn | Zn | Si | Si | Ge | Ge |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| | | | Example 107 | Example 108 | Example 109 | Example 110 | Example 111 | Example 112 | Example 113 | Example 114 |
|---|---|---|---|---|---|---|---|---|---|---|
| Evaluation of channel layer | Cross-sectional TEM image | Average grain boundary angle $\theta$ [°] | 105.9 | 102.8 | 79.4 | 88.3 | 103.5 | 90.5 | 101.8 | 87.3 |
| | | Average grain boundary angle $\theta$ sub [°] | 105.9 | 102.8 | 79.4 | 88.3 | 103.5 | 90.5 | 101.8 | 87.3 |
| | | Average spacing D between crystal grain boundaries [$\mu$m] | 1.6 | 0.8 | 0.6 | 02 | 0.3 | 0.7 | 2 | 0.8 |
| | | Crystal state | Columnar crystal | Columnar crystal | Columnar crystal | Columnar crystal | Columnar crystal | Columnar crystal | Columnar crystal | Columnar crystal |
| | SSRM Spread resistance value evaluation | Low-resistance region A $R_A$ [$\Omega$] | 92E+04 | 3.8E+04 | 1.9E+04 | 7.6E+04 | 1.0E+05 | 1.3E+05 | 1.2E+05 | 2.6E+04 |
| | | High-resistance region B $R_B$ [$\Omega$] | 4.4E+06 | 6.7E+05 | 4.0E+05 | 2.5E+06 | 2.3E+06 | 2.7E+06 | 3.5E+06 | 7.9E+05 |
| | | $R_B/R_A$ | 47 | 18 | 21 | 33 | 22 | 22 | 30 | 31 |
| | | Rs(L) | 4.4E+06 | 6.7E+05 | 4.0E+05 | 2.5E+06 | 2.3E+06 | 2.7E+06 | 3.5E+06 | 7.9E+05 |
| | | Rs(L$_{off}$) | 1.4E+05 | 5.6E+04 | 2.9E+04 | 1.1E+05 | 1.5E+05 | 1.9E+05 | 1.7E+05 | 3.9E+04 |
| | | Rs(Ls) | 9.2E+04 | 3.8E+04 | 1.9E+04 | 7.6E+04 | 1.0E+05 | 1.3E+05 | 1.2E+05 | 2.6E+04 |
| | | Rs(L)/Rs(L$_{off}$) | 31 | 12 | 14 | 22 | 15 | 15 | 20 | 20 |
| | | Rs(L)/Rs(Ls) | 47 | 18 | 21 | 33 | 22 | 22 | 30 | 31 |
| | | $\Delta$L [$\mu$m] | -0.6 | -0.9 | -0.8 | -0.8 | 0.0 | 0.0 | -0.3 | -0.6 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

EP 4 418 330 A1

112

| | | | Example 107 | Example 108 | Example 109 | Example 110 | Example 111 | Example 112 | Example 113 | Example 114 |
|---|---|---|---|---|---|---|---|---|---|---|
| Performance of TFT | Vd=0.1 V | ulin Max [cm2/(V·s)] | 32.3 | 38.3 | 39.7 | 32.4 | 35.1 | 34.1 | 37.9 | 35 |
| | | $\triangle$ulin [cm2/(V·s)] | 1.2 | 1.1 | 1.3 | 1.3 | 1.2 | 1.4 | 1.4 | 1.6 |
| | | S value [V/decade] | 0.5 | 0.4 | 0.4 | 0.5 | 0.4 | 0.4 | 0.5 | 0.5 |
| | | Vth [V] | -0.1 | 0.9 | 0.8 | -0.1 | 0 | 0.9 | 0.7 | 0.8 |
| | | $\triangle$Vth | 0.3 | 0.5 | 0.2 | 0.3 | 0.2 | 0.1 | 0.3 | 0.5 |
| | Vd=20 V | usat Max [cm2/(V·s)] | 29.3 | 35.4 | 36.8 | 29.5 | 32.1 | 31.2 | 34.9 | 32.0 |
| | | $\triangle$usat [cm2/(V·s)] | 0.8 | 0.5 | 0.6 | 1.3 | 1.8 | 0.5 | 1.5 | 0.5 |
| | | S value [V/decade] | 0.4 | 0.5 | 0.4 | 0.4 | 0.5 | 0.4 | 0.6 | 0.4 |
| | | Vth [V] | -0.1 | 1.0 | 0.9 | -0.1 | 0.1 | 1.0 | 0.8 | 0.9 |
| | | $\triangle$Vth | 0.5 | 0.3 | 0.2 | 0.1 | 0.6 | 0.5 | 0.5 | 0.5 |
| | Presence or absence of DIBL phenomenon | | Absent | Absent | Absent | Absent | Absent | Absent | Absent | Absent |

EP 4 418 330 A1

Table 41

| | | | Example 115 | Example 116 | Example 117 | Example 118 | Example 119 | Example 120 | Example 121 | Example 122 |
|---|---|---|---|---|---|---|---|---|---|---|---|
| Sputtering target | Loaded composition ratio [mass%] | $In_2O_3$ [mass%] | 84.8 | 95.4 | 81.8 | 962 | 83.8 | 96.9 | 822 | 96.3 |
| | | $Ga_2O_3$ [mass%] | 13.9 | 2.2 | 13.0 | 22 | 13.3 | 22 | 13.1 | 22 |
| | | Metal oxide [mass%] | 1.2 | 2.4 | 5.2 | 1.7 | 2.8 | 0.9 | 4.8 | 1.5 |
| | | Kind of metal oxide | TiO2 | TiO2 | WO3 | WO3 | ZrO2 | ZrO2 | HfO2 | HfO2 |
| | Metal composition ratio [at%] | In [at %] | 78.8 | 92.8 | 78.5 | 95.8 | 78.5 | 95.8 | 78.5 | 95.8 |
| | | Ga [at %] | 192 | 3.2 | 18.5 | 3.2 | 18.5 | 3.2 | 18.5 | 3.2 |
| | | X [at %] | 2.0 | 4.0 | 3.0 | 1.0 | 3.0 | 1.0 | 3.0 | 1.0 |
| | | X element | Ti | Ti | W | W | Zr | Zr | Hf | Hf |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | OtherTFT production conditions | | Same as in Example 1 | Same as in Example 1 | Same as in Example 1 | Same as in Example 1 | Same as in Example 1 | Same as in Example 1 | Same as in Example 1 | Same as in Example 1 |

EP 4 418 330 A1

114

| | | | Example 115 | Example 116 | Example 117 | Example 118 | Example 119 | Example 120 | Example 121 | Example 122 |
|---|---|---|---|---|---|---|---|---|---|---|
| Evaluation of channel layer | Cross-sectional TEM image | Average arain boundary angle θ [°] | 106.6 | 103.1 | 105.7 | 109.1 | 109 | 88.9 | 84.7 | 88.7 |
| | | Average grain boundary angle θ sub [°] | 106.6 | 103.1 | 105.7 | 109.1 | 109 | 88.9 | 84.7 | 88.7 |
| | | Average spacing D between crystal arain boundaries [μm] | 1.4 | 0.9 | 1.8 | 0.7 | 1.6 | 0.1 | 1.5 | 1.5 |
| | | Crystal state | Columnar crystal | Columnar crystal | Columnar crystal | Columnar crystal | Columnar crystal | Columnar crystal | Columnar crystal | Columnar crystal |
| | SSRM· Spread resistance value evaluation | Low-resistance region A $R_A$ [Ω] | 6.3E+04 | 1.0E+05 | 1.1E+05 | 9.6E+04 | 8.6E+04 | 7.6E+04 | 1.3E+05 | 1.0E+05 |
| | | High-resistance region B $R_B$ [Ω] | 1.6E+06 | 2.1E+06 | 4.2E+06 | 2.6E+06 | 3.4E+06 | 3.4E+06 | 3.8E+06 | 3.6E+06 |
| | | $R_B/R_A$ | 25 | 20 | 40 | 27 | 39 | 46 | 29 | 35 |
| | | Rs(L) | 1.6E+06 | 2.1E+06 | 4.2E+06 | 2.6E+06 | 3.4E+06 | 3.4E+06 | 3.8E+06 | 3.6E+06 |
| | | Rs($L_{off}$) | 9.5E+04 | 1.6E+05 | 1.6E+05 | 1.4E+05 | 1.3E+05 | 1.1E+05 | 2.0E+05 | 1.6E+05 |
| | | Rs(Ls) | 6.3E+04 | 1.0E+05 | 1.1E+05 | 9.6E+04 | 8.6E+04 | 7.6E+04 | 1.3E+05 | 1.0E+05 |
| | | Rs(L)/Rs($L_{off}$) | 16 | 13 | 27 | 18 | 26 | 30 | 19 | 23 |
| | | Rs(L)/Rs(Ls) | 25 | 20 | 40 | 27 | 39 | 46 | 29 | 35 |
| | | ΔL [μm] | -0.2 | -0.1 | -0.3 | -0.8 | -0.8 | -0.8 | 0.0 | -0.4 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

| | | | Example 115 | Example 116 | Example 117 | Example 118 | Example 119 | Example 120 | Example 121 | Example 122 |
|---|---|---|---|---|---|---|---|---|---|---|---|
| Performance of TFT | Vd=0.1 V | ulin Max [cm2/(V·s)] | 36.6 | 35.9 | 36.1 | 34.0 | 40.0 | 37.6 | 36.7 | 35.4 |
| | | △ulin [cm2/(V·s)] | 1.5 | 1.4 | 1.3 | 1.1 | 1.3 | 1.1 | 1.1 | 1.1 |
| | | S value [V/decade] | 0.5 | 0.5 | 0.5 | 0.5 | 0.4 | 0.4 | 0.4 | 0.5 |
| | | Vth [V] | -0.8 | 0.7 | 1 | -0.2 | 1.1 | -0.1 | 1.4 | 1.5 |
| | | △Vth | 0.3 | 0.5 | 0.6 | 0.5 | 0.4 | 0.5 | 0.1 | 0.1 |
| | Vd=20 V | usat Max [cm2/(V·s)] | 33.6 | 33.1 | 33.1 | 31 | 37.1 | 34.6 | 33.9 | 32.5 |
| | | △usat [cm2/(V·s)] | 1.8 | 1.8 | 0.6 | 1.3 | 1.7 | 0.5 | 0.7 | 0.8 |
| | | S value [V/decade] | 0.5 | 0.4 | 0.6 | 0.6 | 0.4 | 0.5 | 0.5 | 0.5 |
| | | Vth [V] | -0.8 | 0.8 | 1.1 | -0.2 | 1.2 | -0.1 | 1.5 | 1.6 |
| | | △Vth | 0.4 | 0.3 | 0.5 | 0.1 | 0.6 | 0.6 | 0.5 | 0.6 |
| | Presence or absence of DIBL phenomenon | | Absent | Absent | Absent | Absent | Absent | Absent | Absent | Absent |

EP 4 418 330 A1

116

**Table 42**

| | | | Example 123 | Example 124 | Example 125 | Example 126 |
|---|---|---|---|---|---|---|
| Sputtering target | Loaded composition ratio [mass%] | In$_2$O$_3$ [mass%] | 83.4 | 96.8 | 83.3 | 96.7 |
| | | Ga$_2$O$_3$ [mass%] | 13.3 | 2.2 | 13.3 | 2.2 |
| | | Metal oxide [mass%] | 3.3 | 1.0 | 3.5 | 1.1 |
| | | Kind of metal oxide | MoO3 | MoO3 | SnO2 | SnO2 |
| | Metal composition ratio [at%] | In [at %] | 78.5 | 95.8 | 78.5 | 95.8 |
| | | Ga [at %] | 18.5 | 3.2 | 18.5 | 3.2 |
| | | X [at %] | 3.0 | 1.0 | 3.0 | 1.0 |
| | | X element | Mo | Mo | Sn | Sn |
| TFT production conditions | Film formation of channel layer | Pressure at time of film formation [Pa] | 0.5 | 0.5 | 0.5 | 0.5 |
| | | Oxygen partial pressure at time of film formation [Pa] | 0.05 | 0.00 | 0.05 | 0.00 |
| | | Water partial pressure at time of film formation [Pa] | 0.00 | 0.01 | 0.00 | 0.01 |
| | | Magnetic flux density [G] | 600 | 600 | 600 | 600 |
| | | Thickness [nm] | 30 | 10 | 30 | 10 |
| | Other TFT production conditions | | Same as in Example 1 | Same as in Example 1 | Same as in Example 1 | Same as in Example 1 |

(continued)

| | | | | Example 123 | Example 124 | Example 125 | Example 126 |
|---|---|---|---|---|---|---|---|
| Evaluation of channel layer | Cross-sectional TEM image | | Average grain boundary angle θ [°] | 86.8 | 98.9 | 96.5 | 103.2 |
| | | | Average grain boundary angle θsub [°] | 86.8 | 98.9 | 96.5 | 103.2 |
| | | | Average spacing D between crystal grain boundaries [μm] | 1.7 | 2 | 0.7 | 0.9 |
| | | | Crystal state | Columnar crystal | Columnar crystal | Columnar crystal | Columnar crystal |
| | SSRM Spread resistance value evaluation | | Low-resistance region A $R_A$ [Ω] | 5.0E+04 | 1.2E+05 | 7.1E+04 | 9.3E+04 |
| | | | High-resistance region B $R_B$ [Ω] | 2.2E+06 | 2.1 E+06 | 2.6E+06 | 3.1 E+06 |
| | | | $R_B/R_A$ | 45 | 18 | 36 | 34 |
| | | | Rs(L) | 2.2E+06 | 2.1E+06 | 2.6E+06 | 3.1E+06 |
| | | | Rs($L_{off}$) | 7.5E+04 | 1.7E+05 | 1.1E+05 | 1.4E+05 |
| | | | Rs(Ls) | 5.0E+04 | 1.2E+05 | 7.1E+04 | 9.3E+04 |
| | | | Rs(L)/Rs($L_{off}$) | 30 | 12 | 24 | 22 |
| | | | Rs(L)/Rs(Ls) | 45 | 18 | 36 | 34 |
| | | | ΔL [μm] | -0.5 | 0.0 | 02 | -0.4 |
| | SCM· dC/dV evaluation | | Magnitudes of boundary region (A-B) and region (B) | (A-B)>(B) | (A-B)>(B) | (A-B)>(B) | (A-B)>(B) |
| | Electron beam diffraction | | Crystal structure | Bixbyite | Bixbyite | Bixbyite | Bixbyite |
| Performance of TFT | Vd=0.1 V | | ulin Max [cm2/(V·s)] | 36.5 | 39.3 | 37.5 | 35.5 |
| | | | Δulin [cm2/(V·s)] | 1.2 | 1.1 | 1.4 | 1.5 |
| | | | S value [V/decade] | 0.4 | 0.5 | 0.4 | 0.5 |
| | | | Vth [V] | -0.9 | -0.3 | 0.4 | 0.6 |
| | | | ΔVth | 0.5 | 0.6 | 0.4 | 0.4 |
| | Vd=20 V | | usat Max [cm2/(V·s)] | 33.6 | 36.5 | 34.6 | 32.7 |
| | | | Δusat [cm2/(V·s)] | 1.6 | 1.8 | 1.6 | 1.3 |
| | | | S value [V/decade] | 0.4 | 0.4 | 0.4 | 0.6 |
| | | | Vth [V] | -0.9 | -0.3 | 0.5 | 0.7 |
| | | | ΔVth | 0.5 | 0.2 | 0.5 | 0.3 |
| | Presence or absence of DIBL phenomenon | | | Absent | Absent | Absent | Absent |

Table 43

| | | | Example 127 | Example 128 | Example 129 | Example 130 | Example 131 | Example 132 | Example 133 | Example 134 |
|---|---|---|---|---|---|---|---|---|---|---|
| Sputtering target | Loaded composition ratio [mass%] | $In_2O_3$ [mass%] | 73.3 | 94.5 | 73.0 | 94.4 | 73.4 | 94.6 | 73.3 | 94.6 |
| | | $SnO_2$ [mass%] | 23.3 | 4.3 | 23.2 | 4.3 | 23.3 | 4.3 | 23.3 | 4.3 |
| | | $X_2O_3$ [mass%] | 3.4 | 1.2 | 3.8 | 1.3 | 3.3 | 1.2 | 3.3 | 1.2 |
| | | Kind of $X_2O_3$ | $Nd_2O_3$ | $Nd_2O_3$ | $Ho_2O_3$ | $Ho_2O_3$ | $La_2O_3$ | $La_2O_3$ | $Ce_2O_3$ | $Ce_2O_3$ |
| | Metal composition ratio [at%] | In [at %] | 78.5 | 95.8 | 78.5 | 95.8 | 78.5 | 95.8 | 78.5 | 95.8 |
| | | Sn [at %] | 18.5 | 3.2 | 18.5 | 3.2 | 18.5 | 3.2 | 18.5 | 3.2 |
| | | X [at %] | 3.0 | 1.0 | 3.0 | 1.0 | 3.0 | 1.0 | 3.0 | 1.0 |
| | | X element | Nd | Nd | Ho | Ho | La | La | Ce | Ce |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

| | | | Example 127 | Example 128 | Example 129 | Example 130 | Example 131 | Example 132 | Example 133 | Example 134 |
|---|---|---|---|---|---|---|---|---|---|---|
| Evaluation of channel layer | Cross-sectional TEM image | Average arain boundary angle θ [°] | 73.8 | 99.4 | 103.7 | 89.8 | 110 | 109.9 | 88.3 | 92.1 |
| | | Average grain boundary angle θ sub [°] | 73.8 | 99.4 | 103.7 | 89.8 | 110 | 109.9 | 88.3 | 92.1 |
| | | Average spacing D between crystal arain boundaries [μm] | 1.9 | 1.3 | 0.3 | 0.6 | 1.2 | 1.7 | 2 | 0.3 |
| | | Crystal state | Columnar crystal | Columnar crystal | Columnar crystal | Columnar crystal | Columnar crystal | Columnar crystal | Columnar crystal | Columnar crystal |
| | SSRM· Spread resistance value evaluation | Low-resistance region A $R_A$ [Ω] | 4.8E+04 | 1.1E+05 | 1.1E+05 | 4.0E+04 | 8.3E+04 | 3.0E+04 | 3.9E+04 | 8.8E+04 |
| | | High-resistance region B $R_B$ [Ω] | 8.8E+05 | 4.4E+06 | 3.7E+06 | 1.0E+06 | 1.6E+06 | 1.5E+06 | 1.1E+06 | 1.9E+06 |
| | | $R_B/R_A$ | 18 | 39 | 34 | 25 | 19 | 48 | 28 | 21 |
| | | Rs(L) | 8.8E+05 | 4.4E+06 | 3.7E+06 | 1.0E+06 | 1.6E+06 | 1.5E+06 | 1.1E+06 | 1.9E+06 |
| | | Rs($L_{off}$) | 7.2E+04 | 1.7E+05 | 1.6E+05 | 6.0E+04 | 1.3E+05 | 4.5E+04 | 5.8E+04 | 1.3E+05 |
| | | Rs(Ls) | 4.8E+04 | 1.1E+05 | 1.1E+05 | 4.0E+04 | 8.3E+04 | 3.0E+04 | 3.9E+04 | 8.8E+04 |
| | | Rs(L)/Rs($L_{off}$) | 12 | 26 | 23 | 17 | 13 | 32 | 19 | 14 |
| | | Rs(L)/Rs(Ls) | 18 | 39 | 34 | 25 | 19 | 48 | 28 | 21 |
| | | ΔL [μm] | -0.1 | -0.5 | 02 | 02 | 0.0 | 0.0 | -0.6 | -0.8 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

| | | | Example 127 | Example 128 | Example 129 | Example 130 | Example 131 | Example 132 | Example 133 | Example 134 |
|---|---|---|---|---|---|---|---|---|---|---|
| Performance of TFT | Vd=0.1 V | ulin Max [cm2/(V·s)] | 32.8 | 33.2 | 32.6 | 38.6 | 35.6 | 38.6 | 40.0 | 34.8 |
| | | $\Delta\mu$lin [cm2/(V·s)] | 1.2 | 1.5 | 1.4 | 1.2 | 1.4 | 1.5 | 1.2 | 1.6 |
| | | S value [V/decade] | 0.5 | 0.4 | 0.4 | 0.4 | 0.5 | 0.4 | 0.4 | 0.5 |
| | | Vth [V] | 1 | -1 | 0.5 | 1.1 | -0.4 | 0.1 | 0.4 | 0.4 |
| | | $\Delta$Vth | 0.5 | 0.5 | 0.3 | 0.1 | 0.6 | 0.1 | 0.6 | 0.4 |
| | Vd=20 V | usat Max [cm2/(V·s)] | 29.9 | 30.4 | 29.7 | 35.7 | 32.8 | 35.6 | 37.2 | 31.9 |
| | | $\Delta\mu$sat [cm2/(V·s)] | 1.5 | 0.9 | 1 | 1.6 | 1.1 | 1.8 | 0.9 | 1.1 |
| | | S value [V/decade] | 0.6 | 0.4 | 0.5 | 0.6 | 0.6 | 0.4 | 0.5 | 0.6 |
| | | Vth [V] | 1.1 | -1.0 | 0.6 | 1.2 | -0.4 | 0.2 | 0.5 | 0.5 |
| | | $\Delta$Vth | 0.4 | 0.2 | 0.4 | 0.5 | 0.4 | 0.4 | 0.3 | 0.5 |
| | Presence or absence of DIBL phenomenon | | Absent | Absent | Absent | Absent | Absent | Absent | Absent | Absent |

Table 44

| | | | Example 135 | Example 136 | Example 137 | Example 138 | Example 139 | Example 140 | Example 141 | Example 142 |
|---|---|---|---|---|---|---|---|---|---|---|
| Sputtering target | Loaded composition ratio [mass%] | $In_2O_3$ [mass%] | 73.3 | 94.6 | 72.9 | 94.4 | 72.9 | 94.3 | 72.9 | 94.4 |
| | | SnO2 [mass%] | 23.3 | 4.3 | 23.2 | 4.3 | 23.2 | 4.3 | 23.2 | 4.3 |
| | | X2O3 [mass%] | 3.3 | 1.2 | 3.9 | 1.4 | 4.0 | 1.4 | 3.8 | 1.4 |
| | | Kind of X2O3 | Pr2O3 | Pr2O3 | Tm2O3 | Tm2O3 | Yb2O3 | Yb2O3 | Er2O3 | Er2O3 |
| | Metal composition ratio [at%] | In [at %] | 78.5 | 95.8 | 78.5 | 95.8 | 78.5 | 95.8 | 78.5 | 95.8 |
| | | Sn [at %] | 18.5 | 3.2 | 18.5 | 3.2 | 18.5 | 3.2 | 18.5 | 3.2 |
| | | X [at %] | 3.0 | 1.0 | 3.0 | 1.0 | 3.0 | 1.0 | 3.0 | 1.0 |
| | | X element | Pr | Pr | Tm | Tm | Yb | Yb | Er | Er |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

|  |  |  | Example 135 | Example 136 | Example 137 | Example 138 | Example 139 | Example 140 | Example 141 | Example 142 |
|---|---|---|---|---|---|---|---|---|---|---|
| Evaluation of channel layer | Cross-sectional TEM image | Average grain boundarvanale $\theta$ [°] | 77 | 104.2 | 92.2 | 102.7 | 92.6 | 95.6 | 84 | 104.9 |
|  |  | Average grain boundary angle $\theta$sub [°] | 77 | 104.2 | 92.2 | 102.7 | 92.6 | 95.6 | 84 | 104.9 |
|  |  | Average spacing D between crystal arain boundaries [$\mu$m] | 1.2 | 1.2 | 1.7 | 1.7 | 0.6 | 1.3 | 0.4 | 0.9 |
|  |  | Crystal state | Columnar crystal | Columnarcrvstal | Columnarcrvstal | Columnar crystal | Columnarcrvstal | Columnar crystal | Columnar crystal | Columnarcrvstal |
|  | SSRM Spread resistance value evaluation | Low-resistance region A $R_A$ [$\Omega$] | 6.6E+04 | 1.0E+05 | 7.0E+04 | 1.1E+05 | 1.3E+05 | 1.1E+05 | 4.8E+04 | 1.0E+05 |
|  |  | High-resistance region B $R_B$ [$\Omega$] | 2.8E+06 | 1.6E+06 | 1.9E+06 | 3.6E+06 | 4.1E+06 | 3.0E+06 | 8.8E+05 | 4.6E+06 |
|  |  | $R_B/R_A$ | 43 | 15 | 27 | 33 | 33 | 27 | 18 | 45 |
|  |  | Rs(L) | 2.8E+06 | 1.6E+06 | 1.9E+06 | 3.6E+06 | 4.1E+06 | 3.0E+06 | 8.8E+05 | 4.6E+06 |
|  |  | Rs($L_{off}$) | 9.9E+04 | 1.5E+05 | 1.0E+05 | 1.6E+05 | 1.9E+05 | 1.6E+05 | 7.2E+04 | 1.5E+05 |
|  |  | Rs(Ls) | 6.6E+04 | 1.0E+05 | 7.0E+04 | 1.1E+05 | 1.3E+05 | 1.1E+05 | 4.8E+04 | 1.0E+05 |
|  |  | Rs(L)/Rs($L_{off}$) | 28 | 10 | 18 | 22 | 22 | 18 | 12 | 30 |
|  |  | Rs(L)/Rs(Ls) | 43 | 15 | 27 | 33 | 33 | 27 | 18 | 45 |
|  |  | $\Delta$L [$\mu$m] | 0.2 | -0.7 | -0.1 | -0.8 | 0.2 | -0.4 | -0.6 | -0.3 |
|  | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
|  | Electron beam diffraction | Crystal structure | Bixbyite | Bixbyite | Bixbyite | Bixbyite | Bixbyite | Bixbyite | Bixbyite | Bixbyite |

EP 4 418 330 A1

123

| | | | Example 135 | Example 136 | Example 137 | Example 138 | Example 139 | Example 140 | Example 141 | Example 142 |
|---|---|---|---|---|---|---|---|---|---|---|
| Performance of TFT | Vd=0.1 V | ulin Max [cm2/ (V·s)] | 33.2 | 33.2 | 36.5 | 40.5 | 40.4 | 33.6 | 38.3 | 33.2 |
| | | $\triangle\mu$lin [cm2/ (V·s)] | 1.4 | 1.1 | 1.4 | 1.5 | 1.2 | 1.6 | 1.6 | 1.5 |
| | | S value [V/ decade] | 0.4 | 0.4 | 0.5 | 0.5 | 0.4 | 0.4 | 0.5 | 0.5 |
| | | Vth [V] | 1.3 | 1 | 0.4 | -0.3 | 0.1 | 0 | -0.4 | 0.9 |
| | | $\triangle$Vth | 0.2 | 0.1 | 0.2 | 0.6 | 0.2 | 0.4 | 0.4 | 0.2 |
| | Vd=20 V | usat Max [cm2/ (V·s)] | 30.2 | 30.3 | 33.7 | 37.6 | 37.6 | 30.7 | 35.3 | 30.4 |
| | | $\triangle$usat [cm2/ (V·s)] | 1.6 | 1.7 | 1.1 | 1.4 | 0.6 | 1.5 | 0.5 | 1.3 |
| | | S value [V/ decade] | 0.6 | 0.4 | 0.4 | 0.4 | 0.5 | 0.5 | 0.5 | 0.6 |
| | | Vth [V] | 1.4 | 1.1 | 0.5 | -0.3 | 0.2 | 0.1 | -0.4 | 1.0 |
| | | $\triangle$Vth | 0.2 | 0.2 | 0.2 | 0.3 | 0.4 | 0.6 | 0.6 | 0.5 |
| | Presence or absence of DIBL phenomenon | | Absent | Absent | Absent | Absent | Absent | Absent | Absent | Absent |

Table 45

| | | | Example 143 | Example 144 | Example 145 | Example 146 | Example 147 | Example 148 |
|---|---|---|---|---|---|---|---|---|
| Sputtering target | Loaded composition ratio [mass%] | In$_2$O$_3$ [mass%] | 72.8 | 94.3 | 74.1 | 94.9 | 78.7 | 95.4 |
| | | SnO2 [mass%] | 23.2 | 4.3 | 23.6 | 4.3 | 20.8 | 3.6 |
| | | X2O3 [mass%] | 4.0 | 1.4 | 2.3 | 0.8 | 0.5 | 1.0 |
| | | Kind of X2O3 | Lu2O3 | Lu2O3 | Y2O3 | Y2O3 | B2O3 | B2O3 |
| | Metal composition ratio [at%] | In [at %] | 78.5 | 95.8 | 78.5 | 95.8 | 78.8 | 92.8 |
| | | Sn [at %] | 18.5 | 3.2 | 18.5 | 3.2 | 19.2 | 3.2 |
| | | X [at %] | 3.0 | 1.0 | 3.0 | 1.0 | 2.0 | 4.0 |
| | | X element | Lu | Lu | Y | Y | B | B |
| TFT production conditions | Film formation of channel layer | Pressure at time of film formation [Pa] | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 |
| | | Magnetic flux density [G] | 600 | 600 | 600 | 600 | 600 | 600 |
| | | Thickness [nm] | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 |

(continued)

| | | | Example 143 | Example 144 | Example 145 | Example 146 | Example 147 | Example 148 |
|---|---|---|---|---|---|---|---|---|
| Evaluation of channel layer | Cross-sectional TEM image | Average grain boundary angle $\theta$ [°] | 99.6 | 104.3 | 106.9 | 95.1 | 100.5 | 86.9 |
| | | Average grain boundary angle $\theta$sub [°] | 99.6 | 104.3 | 106.9 | 95.1 | 100.5 | 86.9 |
| | | Average spacing D between crystal grain boundaries [$\mu$m] | 0.5 | 0.6 | 1.2 | 0.7 | 1.4 | 1.3 |
| | | Crystal state | Columnar crystal | Columnar crystal | Columnar crystal | Columnar crystal | Columnar crystal | Columnar crystal |
| | SSRM· Spread resistance value evaluation | Low-resistance region A $R_A$ [$\Omega$] | 1.2E+05 | 1.2E+05 | 3.5E+04 | 8.8E+04 | 1.4E+05 | 1.3E+05 |
| | | High-resistance region B $R_B$ [$\Omega$] | 2.1E+06 | 5.0E+06 | 1.4E+06 | 2.8E+06 | 6.2E+06 | 5.7E+06 |
| | | $R_B/R_A$ | 17 | 43 | 41 | 32 | 45 | 44 |
| | | Rs(L) | 2.1E+06 | 5.0E+06 | 1.4E+06 | 2.8E+06 | 6.2E+06 | 5.7E+06 |
| | | Rs($L_{off}$) | 1.8E+05 | 1.8E+05 | 5.2E+04 | 1.3E+05 | 2.1E+05 | 1.9E+05 |
| | | Rs(Ls) | 1.2E+05 | 1.2E+05 | 3.5E+04 | 8.8E+04 | 1.4E+05 | 1.3E+05 |
| | | Rs(L)/Rs($L_{off}$) | 11 | 29 | 27 | 21 | 30 | 29 |
| | | Rs(L)/Rs(Ls) | 17 | 43 | 41 | 32 | 45 | 44 |
| | | $\Delta L$ [$\mu$m] | -0.2 | -0.9 | 0.1 | -0.8 | -0.3 | -0.6 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite |

| | | | Example 143 | Example 144 | Example 145 | Example 146 | Example 147 | Example 148 |
|---|---|---|---|---|---|---|---|---|
| Performance of TFT | Vd=0.1 V | $\mu$lin Max [cm2/(V·s)] | 37.8 | 32.5 | 37.8 | 37.7 | 35.5 | 39.6 |
| | | $\Delta\mu$lin [cm2/(V·s)] | 1.1 | 1.5 | 1.6 | 1.5 | 1.6 | 1.3 |
| | | S value [V/decade] | 0.5 | 0.4 | 0.5 | 0.4 | 0.5 | 0.4 |
| | | Vth [V] | -0.1 | -0.9 | 1.3 | -0.2 | 0 | -0.7 |
| | | $\Delta$Vth | 0.1 | 0.5 | 0.5 | 0.4 | 0.4 | 0.6 |
| | Vd=20 V | $\mu$sat Max [cm2/(V·s)] | 34.9 | 29.6 | 34.9 | 34.8 | 32.7 | 36.7 |
| | | $\Delta\mu$sat [cm2/(V·s)] | 0.6 | 1.7 | 1.1 | 1.6 | 1.8 | 1.3 |
| | | S value [V/decade] | 0.4 | 0.5 | 0.5 | 0.5 | 0.5 | 0.6 |
| | | Vth [V] | -0.1 | -0.9 | 1.4 | -0.2 | 0.1 | -0.7 |
| | | $\Delta$Vth | 0.4 | 0.3 | 0.4 | 0.2 | 0.1 | 0.6 |
| | Presence or absence of DIBL phenomenon | | Absent | Absent | Absent | Absent | Absent | Absent |

Table 46

| | | | Example 149 | Example 150 | Example 151 | Example 152 | Example 153 | Example 154 |
|---|---|---|---|---|---|---|---|---|
| Sputtering target | Loaded composition ratio [mass%] | In$_2$O$_3$ [mass%] | 78.3 | 94.4 | 78.5 | 94.9 | 73.2 | 94.5 |
| | | SnO2 [mass%] | 20.7 | 3.5 | 20.7 | 3.6 | 23.3 | 4.3 |
| | | X2O3 [mass%] | 1.0 | 2.0 | 0.7 | 1.5 | 3.5 | 1.2 |
| | | Kind of X2O3 | Sc2O3 | Sc2O3 | Al2O3 | Al2O3 | Sm2O3 | Sm2O3 |
| | Metal composition ratio [at%] | In [at %] | 78.8 | 92.8 | 78.8 | 92.8 | 78.5 | 95.8 |
| | | Sn [at %] | 192 | 3.2 | 19.2 | 3.2 | 18.5 | 3.2 |
| | | X [at %] | 2.0 | 4.0 | 2.0 | 4.0 | 3.0 | 1.0 |
| | | X element | Sc | Sc | Al | Al | Sm | Sm |
| TFT production conditions | Film formation of channel layer | Pressure at time of film formation [Pa] | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 |
| | | Magnetic flux density [G] | 600 | 600 | 600 | 600 | 600 | 600 |
| | | Thickness [nm] | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 |

(continued)

| | | | Example 149 | Example 150 | Example 151 | Example 152 | Example 153 | Example 154 |
|---|---|---|---|---|---|---|---|---|
| Evaluation of channel layer | Cross-sectional TEM image | Average grain boundary angle $\theta$ [°] | 101.2 | 103.8 | 92.1 | 105.3 | 88.9 | 91.3 |
| | | Average grain boundary angle $\theta$ sub [°] | 101.2 | 103.8 | 92.1 | 105.3 | 88.9 | 91.3 |
| | | Average spacing D between crystal grain boundaries [$\mu$m] | 1.2 | 2 | 1.6 | 1.8 | 0.9 | 1.1 |
| | | Crystal state | Columnar crystal | Columnar crystal | Columnar crystal | Columnar crystal | Columnar crystal | Columnar crystal |
| | SSRM Spread resistance value evaluation | Low-resistance region A $R_A$ [$\Omega$] | 4.6E+04 | 3.1E+04 | 9.9E-04 | 1.1E+05 | 3.5E+04 | 4.0E+04 |
| | | High-resistance region B $R_B$ [$\Omega$] | 1.3E+06 | 1.5 E+06 | 2.0E+06 | 1.7E+06 | 6.1E+05 | 1.4E+06 |
| | | $R_B/R_A$ | 28 | 48 | 20 | 16 | 18 | 35 |
| | | Rs(L) | 1.3E+06 | 1.5E+06 | 2.0E+06 | 1.7E+06 | 6.1E+05 | 1.4E+06 |
| | | Rs($L_{off}$) | 6.9E+04 | 4.6E+04 | 1.5E+05 | 1.6E+05 | 5.2E+04 | 6.0E+04 |
| | | Rs(Ls) | 4.6E+04 | 3.1E+04 | 9.9 E+04 | 1.1E+05 | 3.5E+04 | 4.0E+04 |
| | | Rs(L)/Rs($L_{off}$) | 19 | 32 | 14 | 11 | 12 | 23 |
| | | Rs(L)/Rs(Ls) | 28 | 48 | 20 | 16 | 18 | 35 |
| | | $\Delta$L [$\mu$m] | -0.4 | 0.1 | -0.3 | -0.2 | -0.3 | -0.9 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite |

| | | | Example 149 | Example 150 | Example 151 | Example 152 | Example 153 | Example 154 |
|---|---|---|---|---|---|---|---|---|
| Performance of TFT | Vd=0.1 V | μlin Max [cm2/(V·s)] | 34 | 36.6 | 34.6 | 36.5 | 34.1 | 39.6 |
| | | Δμlin [cm2/(V·s)] | 1.2 | 1.2 | 1.5 | 1.1 | 1.4 | 1.5 |
| | | S value [V/decade] | 0.4 | 0.4 | 0.4 | 0.5 | 0.5 | 0.4 |
| | | Vth [V] | -0.8 | 0.5 | -0.5 | -0.2 | 0.8 | -0.9 |
| | | ΔVth | 0.3 | 0.4 | 0.6 | 0.1 | 0.4 | 0.4 |
| | Vd=20 V | usat Max [cm2((V·s)] | 31.2 | 33.8 | 31.6 | 33.6 | 31.2 | 36.8 |
| | | Δμsat [cm2/(V·s)] | 1.1 | 1.7 | 0.8 | 0.5 | 0.9 | 0.6 |
| | | S value [V/decade] | 0.5 | 0.6 | 0.6 | 0.5 | 0.5 | 0.6 |
| | | Vth [V] | -0.8 | 0.6 | -0.5 | -0.2 | 0.9 | -0.9 |
| | | ΔVth | 0.3 | 0.1 | 0.1 | 0.6 | 0.5 | 0.6 |
| | Presence or absence of DIBL phenomenon | | Absent | Absent | Absent | Absent | Absent | Absent |

Table 47

| | | | Example 155 | Example 156 | Example 157 | Example 158 | Example 159 | Example 160 |
|---|---|---|---|---|---|---|---|---|
| Sputtering target | Loaded composition ratio [mass%] | $In_2O_3$ [mass%] | 78.6 | 952 | 782 | 94.1 | 78.4 | 94.7 |
| | | SnO2 [mass%] | 20.8 | 3.6 | 20.7 | 3.5 | 20.7 | 3.5 |
| | | XO [mass%] | 0.6 | 1.2 | 1.2 | 2.4 | 0.9 | 1.8 |
| | | Kind of XO | MgO | MgO | ZnO | ZnO | SiO2 | SiO2 |
| | Metal composition ratio [at%] | In [at %] | 78.8 | 92.8 | 78.8 | 92.8 | 78.8 | 92.8 |
| | | Sn [at %] | 19.2 | 3.2 | 19.2 | 32 | 19.2 | 3.2 |
| | | X [at %] | 2.0 | 4.0 | 2.0 | 4.0 | 2.0 | 4.0 |
| | | X element | Mg | Ma | Zn | Zn | Si | Si |
| TFT production conditions | Film formation of channel layer | Pressure at time of film formation [Pa] | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 |
| | | Magnetic flux density [G] | 600 | 600 | 600 | 600 | 600 | 600 |
| | | Thickness [nm] | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 |

(continued)

| | | | Example 155 | Example 156 | Example 157 | Example 158 | Example 159 | Example 160 |
|---|---|---|---|---|---|---|---|---|
| Evaluation of channel layer | Cross-sectional TEM image | Average grain boundary angle $\theta$ [°] | 712 | 79.5 | 97.7 | 83.8 | 94.3 | 94.4 |
| | | Average grain boundary angle $\theta$sub [°] | 71.2 | 79.5 | 97.7 | 83.8 | 94.3 | 94.4 |
| | | Average spacing D between crystal grain boundaries [$\mu$m] | 0.5 | 1.3 | 0.2 | 0.1 | 2 | 2 |
| | | Crystal state | Columnar crystal | Columnar crystal | Columnar crystal | Columnar crystal | Columnar crystal | Columnar crystal |
| | SSRM-Spread resistance value evaluation | Low-resistance region A $R_A$ [$\Omega$] | 1.3E+05 | 4.9E+04 | 3.1E+04 | 1.2E+05 | 1.3E+05 | 5.9E+04 |
| | | High-resistance region B $R_B$ [$\Omega$] | 4.2E+06 | 9.3E+05 | 8.3E+05 | 3.1E+06 | 2.7E+06 | 2.7E+06 |
| | | $R_B/R_A$ | 33 | 19 | 27 | 27 | 21 | 46 |
| | | Rs(L) | 4.2E+06 | 9.3E+05 | 8.3E+05 | 3.1E+06 | 2.7E+06 | 2.7E+06 |
| | | Rs($L_{off}$) | 1.9E+05 | 7.4E+04 | 4.7E+04 | 1.7E+05 | 2.0E+05 | 8.8E+04 |
| | | Rs(Ls) | 1.3E+05 | 4.9E+04 | 3.1E+04 | 1.2E+05 | 1.3E+05 | 5.9E+04 |
| | | Rs(L)/Rs($L_{off}$) | 22 | 13 | 18 | 18 | 14 | 31 |
| | | Rs(L)/Rs(Ls) | 33 | 19 | 27 | 27 | 21 | 46 |
| | | $\Delta L$ [$\mu$m] | -0.9 | 0.2 | -0.4 | -0.6 | 0.0 | -0.4 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite |

(continued)

| | | | Example 155 | Example 156 | Example 157 | Example 158 | Example 159 | Example 160 |
|---|---|---|---|---|---|---|---|---|
| Performance of TFT | Vd=0.1 V | ulin Max [cm2/(V·s)] | 33.6 | 32.5 | 39.3 | 38.2 | 34.7 | 40.3 |
| | | Δμlin [cm2/(V·s)] | 1.1 | 1.3 | 1.1 | 1.3 | 1.6 | 1.5 |
| | | S value [V/decade] | 0.4 | 0.4 | 0.4 | 0.5 | 0.5 | 0.4 |
| | | Vth [V]' | -0.6 | 1 | -0.9 | 1 | -0.7 | 1.3 |
| | | ΔVth | 0.4 | 0.6 | 0.1 | 0.3 | 0.2 | 0.3 |
| | Vd=20 V | usat Max [cm2/(V·s)] | 30.8 | 29.6 | 36.4 | 35.4 | 31.7 | 37.3 |
| | | Δμsat [cm2/(V·s)] | 1.7 | 1.2 | 0.5 | 1.7 | 1.3 | 1.4 |
| | | S value [V/decade] | 0.4 | 0.4 | 0.5 | 0.5 | 0.6 | 0.6 |
| | | Vth [V] | -0.6 | 1.1 | -0.9 | 1.1 | -0.7 | 1.4 |
| | | ΔVth | 0.3 | 0.6 | 0.3 | 0.1 | 0.3 | 0.6 |
| | | Presence or absence of DIBL phenomenon | Absent | Absent | Absent | Absent | Absent | Absent |

Table 48

| | | | Example 161 | Example 162 | Example 163 | Example 164 | Example 165 | Example 166 |
|---|---|---|---|---|---|---|---|---|
| Sputtering target | Loaded composition ratio [mass%] | In$_2$O$_3$ [mass %] | 77.9 | 93.5 | 782 | 94.1 | 72.4 | 94.1 |
| | | SnO2 [mass %] | 20.6 | 3.5 | 20.7 | 3.5 | 23.0 | 42 |
| | | XO [mass %] | 1.5 | 3.0 | 1.2 | 2.3 | 4.6 | 1.6 |
| | | Kind of XO | GeO2 | GeO2 | TiO2 | TiO2 | WO3 | WO3 |
| | Metal composition ratio [at%] | In [at %] | 78.8 | 92.8 | 78.8 | 92.8 | 78.5 | 95.8 |
| | | Sn [at %] | 192 | 3.2 | 192 | 3.2 | 18.5 | 3.2 |
| | | X [at %] | 2.0 | 4.0 | 2.0 | 4.0 | 3.0 | 1.0 |
| | | X element | Ge | Ge | Ti | Ti | W | W |
| TFT production conditions | Film formation of channel layer | Pressure at time of film formation [Pa] | 0.5 | 0.5 | 0.5 | 0.5 | 0.5 | 0.5 |
| | | Oxygen partial pressure attime of film formation [Pa] | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 |
| | | Magnetic flux density [G] | 600 | 600 | 600 | 600 | 600 | 600 |
| | | Thickness [nm] | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 |

| | | | Example 161 | Example 162 | Example 163 | Example 164 | Example 165 | Example 166 |
|---|---|---|---|---|---|---|---|---|
| Evaluation of channel layer | Cross-sectional TEM image | Average grain boundary angle $\theta$ [°] | 104.5 | 106.6 | 85.2 | 88.1 | 792 | 75.1 |
| | | Average grain boundary angle $\theta$sub [°] | 104.5 | 106.6 | 85.2 | 88.1 | 79.2 | 75.1 |
| | | Average spacing D between crystal grain boundaries [$\mu$m] | 0.1 | 1 | 1.8 | 1.2 | 1.2 | 1.6 |
| | | Crystal state | Columnar crystal | Columnar crystal | Columnar crystal | Columnar crystal | Columnar crystal | Columnar crystal |
| | SSRM- Spread resistance value evaluation | Low-resistance region A $R_A$ [$\Omega$] | 4.6E+04 | 1.2E+05 | 4.5 E+04 | 4.2E+04 | 5.6E+04 | 1.4E+05 |
| | | High-resistance region B $R_B$ [$\Omega$] | 1.0E+06 | 2.5E+06 | 1.4E+06 | 7.5E+05 | 2.4E+06 | 4.0E+06 |
| | | $R_B/R_A$ | 23 | 21 | 32 | 18 | 43 | 29 |
| | | Rs(L) | 1.0E+06 | 2.5E+06 | 1.4E+06 | 7.5E+05 | 2.4E+06 | 4.0E+06 |
| | | Rs($L_{off}$) | 6.9E+04 | 1.8E+05 | 6.7E+04 | 6.3E+04 | 8.4E+04 | 2.0E+05 |
| | | Rs(Ls) | 4.6E+04 | 1.2E+05 | 4.5 E+04 | 4.2E+04 | 5.6E+04 | 1.4E+05 |
| | | Rs(L)/Rs($L_{off}$) | 15 | 14 | 21 | 12 | 29 | 20 |
| | | Rs(L)/Rs(Ls) | 23 | 21 | 32 | 18 | 43 | 29 |
| | | $\Delta$L [$\mu$m] | -0.3 | -0.4 | 0.0 | -0.3 | -0.7 | -0.5 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite |

EP 4 418 330 A1

(continued)

| | | | Example 161 | Example 162 | Example 163 | Example 164 | Example 165 | Example 166 |
|---|---|---|---|---|---|---|---|---|
| Performance of TFT | Vd=0.1 V | ulin Max [cm2/(V·s)] | 34 | 35 | 39.2 | 39.1 | 38.1 | 33 |
| | | $\Delta\mu$lin [cm2/(V·s)] | 1.2 | 1.5 | 1.3 | 1.1 | 1.3 | 1.4 |
| | | S value [V/decade] | 0.5 | 0.4 | 0.4 | 0.5 | 0.5 | 0.5 |
| | | Vth [V] | 0.8 | 1.2 | 0.5 | 1 | 1.2 | 0.8 |
| | | $\Delta$Vth | 0.5 | 0.4 | 0.2 | 0.4 | 0.1 | 0.3 |
| | Vd=20 V | usat Max [cm2/(V·s)] | 31.1 | 32.2 | 36.4 | 36.2 | 35.3 | 30 |
| | | $\Delta\mu$sat [cm2/(V·s)] | 1.5 | 1.4 | 0.8 | 1.1 | 1.4 | 1 |
| | | S value [V/decade] | 0.4 | 0.6 | 0.4 | 0.6 | 0.6 | 0.5 |
| | | Vth [V] | 0.9 | 1.3 | 0.6 | 1.1 | 1.3 | 0.9 |
| | | $\Delta$Vth | 0.4 | 0.2 | 0.2 | 0.3 | 0.2 | 0.6 |
| | Presence or absence of DIBL phenomenon | | Absent | Absent | Absent | Absent | Absent | Absent |

Table 49

| | | | Example 167 | Example 168 | Example 169 | Example 170 | Example 171 | Example 172 |
|---|---|---|---|---|---|---|---|---|
| Sputtering target | Loaded composition ratio [mass%] | $In_2O_3$ [mass%] | 74.0 | 94.8 | 72.7 | 94.3 | 73.6 | 94.7 |
| | | SnO2 [mass%] | 23.5 | 4.3 | 23.1 | 4.3 | 23.4 | 4.3 |
| | | XO [mass%] | 2.5 | 0.9 | 42 | 1.5 | 2.9 | 1.0 |
| | | Kind of XO | ZrO2 | ZrO2 | HfO2 | HfO2 | MoO3 | MoO3 |
| | Metal composition ratio [at%] | In [at %] | 78.5 | 95.8 | 78.5 | 95.8 | 78.5 | 95.8 |
| | | Sn [at %] | 18.5 | 3.2 | 18.5 | 3.2 | 18.5 | 3.2 |
| | | X [at %] | 3.0 | 1.0 | 3.0 | 1.0 | 3.0 | 1.0 |
| | | X element | Zr | Zr | Hf | Hf | Mo | Mo |
| TFT production conditions | Film formation of channel layer | Pressure attime of film formation [Pa] | 0.5 | 0.5 | 0.5 | 0.5 | 0.5 | 0.5 |
| | | Oxygen partial pressure attime of film formation [Pa] | 0.05 | 0.00 | 0.05 | 0.00 | 0.05 | 0.00 |
| | | Water partial pressure attime of film formation [Pa] | 0.00 | 0.01 | 0.00 | 0.01 | 0.00 | 0.01 |
| | | Magnetic fluxdensitv [G] | 600 | 600 | 600 | 600 | 600 | 600 |
| | | Thickness [nm] | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 |

137

EP 4 418 330 A1

(continued)

| | | Example 167 | Example 168 | Example 169 | Example 170 | Example 171 | Example 172 |
|---|---|---|---|---|---|---|---|
| Evaluation of channel layer | Cross-sectional TEM image | Average grain boundary angle θ [°] | 81 | 101.6 | 103.6 | 94.8 | 74 | 101.4 |
| | | Average grain boundary angle θ sub [°] | 81 | 101.6 | 103.6 | 94.8 | 74 | 101.4 |
| | | Average spacing D between crystal grain boundaries [μm] | 1.9 | 1.6 | 1.5 | 1 | 1.8 | 1.3 |
| | | Crystal state | Columnar crystal | Columnar crystal | Columnar crystal | Columnar crystal | Columnar crystal | Columnar crystal |
| | SSRM Spread resistance value evaluation | Low-resistance region A $R_A$ [Ω] | 1.1E+05 | 1.7E+04 | 1.1E+05 | 9.3E+04 | 1.2E+05 | 3.0E+04 |
| | | High-resistance region B $R_B$ [Ω] | 3.3E+06 | 2.7E+05 | 3.2E+06 | 3.4E+06 | 5.7E+06 | 1.5E+06 |
| | | $R_B/R_A$ | 30 | 16 | 30 | 36 | 48 | 50 |
| | | Rs(L) | 3.3E+06 | 2.7E+05 | 3.2E+06 | 3.4E+06 | 5.7E+06 | 1.5E+06 |
| | | Rs($L_{off}$) | 1.7E+05 | 2.6E+04 | 1.6E+05 | 1.4E+05 | 1.8E+05 | 4.4E+04 |
| | | Rs(Ls) | 1.1E+05 | 1.7E+04 | 1.1E+05 | 9.3E+04 | 1.2E+05 | 3.0E+04 |
| | | Rs(L)/Rs($L_{off}$) | 20 | 10 | 20 | 24 | 32 | 33 |
| | | Rs(L)/Rs(Ls) | 30 | 16 | 30 | 36 | 48 | 50 |
| | | ΔL [μm] | 02 | -0.3 | -0.4 | 0.1 | -0.9 | -0.8 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite |

(continued)

| | | | Example 167 | Example 168 | Example 169 | Example 170 | Example 171 | Example 172 |
|---|---|---|---|---|---|---|---|---|
| Performance of TFT | Vd=0.1 V | ulin Max [cm2/(V·s)] | 39.1 | 36.8 | 35.5 | 33.3 | 37.6 | 39.3 |
| | | $\Delta\mu$lin [cm2/(V·s)] | 1.1 | 1.3 | 1.1 | 1.4 | 1.6 | 1.1 |
| | | S value [V/decade] | 0.4 | 0.4 | 0.4 | 0.5 | 0.5 | 0.5 |
| | | Vth [V] | -0.1 | 0.1 | 0.9 | 0.6 | -0.8 | 0.2 |
| | | $\Delta$Vth | 0.1 | 0.4 | 0.3 | 0.3 | 0.2 | 0.3 |
| | Vd=20 V | usat Max [cm2/(V·s)] | 36.2 | 33.8 | 32.6 | 30.4 | 34.8 | 36.5 |
| | | $\Delta\mu$sat [cm2/(V·s)] | 1.8 | 1.2 | 1.2 | 0.9 | 0.7 | 1.7 |
| | | S value [V/decade] | 0.6 | 0.6 | 0.5 | 0.4 | 0.4 | 0.5 |
| | | Vth [V] | -0.1 | 0.2 | 1.0 | 0.7 | -0.8 | 0.3 |
| | | $\Delta$Vth | 0.4 | 0.4 | 0.5 | 0.1 | 0.6 | 0.4 |
| | Presence or absence of DIBL phenomenon | | Absent | Absent | Absent | Absent | Absent | Absent |

Table 50

| | | | Example 173 | Example 174 | Example 175 | Example 176 | Example 177 | Example 178 | Example 179 | Example 180 |
|---|---|---|---|---|---|---|---|---|---|---|
| Sputtering target | Loaded compositic ratio [mass%] | $In_2O_3$ [mass%] | 89.5 | 95.8 | 88.8 | 95.5 | 89.6 | 95.9 | 89.6 | 95.8 |
| | | ZnO [mass%] | 4.4 | 1.8 | 4.3 | 1.8 | 4.4 | 1.8 | 4.4 | 1.8 |
| | | X2O3 [mass%] | 6.2 | 2.4 | 6.9 | 2.7 | 6.0 | 2.4 | 6.0 | 2.4 |
| | | Kind of X2O3 | Nd2O3 | Nd2O3 | Ho2O3 | Ho2O3 | Ln2O3 | Ln2O3 | Ce2O3 | Ce2O3 |
| | Metal composition ratio [at%] | In [at %] | 87.7 | 95.0 | 87.7 | 95.0 | 87.7 | 95.0 | 87.7 | 95.0 |
| | | Zn [at %] | 7.3 | 3.0 | 7.3 | 3.0 | 7.3 | 3.0 | 7.3 | 3.0 |
| | | X [at %] | 5.0 | 2.0 | 5.0 | 2.0 | 5.0 | 2.0 | 5.0 | 2.0 |
| | | X element | Nd | Nd | Ho | Ho | La | La | Ce | Ce |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time offilm formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| | | | Example 173 | Example 174 | Example 175 | Example 176 | Example 177 | Example 178 | Example 179 | Example 180 |
|---|---|---|---|---|---|---|---|---|---|---|
| Evaluation of channel layer | Cross-sectional TEM image | Average grain boundary angle θ [°] | 103.2 | 70.1 | 104.8 | 100.1 | 95.3 | 104.3 | 70.2 | 108 |
| | | Average grain boundary angle θ sub [°] | 103.2 | 70.1 | 104.8 | 100.1 | 95.3 | 104.3 | 70.2 | 108 |
| | | Average spacing D between crystal grain boundaries [μm] | 1.8 | 1 | 0.1 | 0.4 | 1.9 | 1.8 | 1.8 | 0.3 |
| | | Crystal state | Columnar crystal | Columnar crystal | Columnar crystal | Columnar crystal | Columnar crystal | Columnar crystal | Columnar crystal | Columnar crystal |
| | SSRM·Spread resistance value evaluation | Low-resistance region A $R_A$ [Ω] | 1.1E-05 | 7.2E+04 | 2.9E+04 | 4.8E+04 | 1.1E-05 | 4.9E+04 | 8.3E+04 | 3.7E+04 |
| | | High-resistance region B $R_B$ [Ω] | 3.0E+06 | 2.2E+06 | 6.2E+05 | 1.8E+06 | 2.1E+06 | 8.2E+05 | 4.0E+06 | 7.1E+05 |
| | | $R_B/R_A$ | 26 | 31 | 21 | 38 | 20 | 17 | 48 | 20 |
| | | Rs(L) | 3.0E+06 | 2.2E+06 | 6.2E+05 | 1.8E+06 | 2.1E+06 | 8.2E+05 | 4.0E+06 | 7.1E+05 |
| | | Rs($L_{off}$) | 1.7E+05 | 1.1E+05 | 4.4E+04 | 7.2E+04 | 1.6E+05 | 7.4E+04 | 1.2E+05 | 5.5E+04 |
| | | Rs(Ls) | 1.1E+05 | 7.2E+04 | 2.9E+04 | 4.8E+04 | 1.1E+05 | 4.9E+04 | 8.3E+04 | 3.7E+04 |
| | | Rs(L)/Rs($L_{off}$) | 17 | 21 | 14 | 25 | 14 | 11 | 32 | 13 |
| | | Rs(L)/Rs(Ls) | 26 | 31 | 21 | 38 | 20 | 17 | 48 | 20 |
| | | ΔL [μm] | 0.1 | -0.6 | -0.1 | -0.9 | -0.5 | -0.4 | -0.5 | -0.5 |
| | SCM·dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

| | | | Example 173 | Example 174 | Example 175 | Example 176 | Example 177 | Example 178 | Example 179 | Example 180 |
|---|---|---|---|---|---|---|---|---|---|---|
| Performance of TFT | Vd=0.1 V | ulin Max [cm2/(V·s)] | 36.5 | 32.8 | 34.1 | 36.2 | 34 | 35.9 | 35.2 | 38.8 |
| | | $\triangle\mu$lin [cm2/(V·s)] | 1.6 | 1.3 | 1.5 | 1.3 | 1.5 | 1.6 | 1.2 | 1.3 |
| | | S value [V/decade] | 0.4 | 0.5 | 0.5 | 0.5 | 0.4 | 0.4 | 0.5 | 0.4 |
| | | Vth [V] | -0.3 | 1.3 | 0.9 | 0.8 | -0.1 | -0.4 | -0.9 | -1 |
| | | $\triangle$Vth | 0.2 | 0.3 | 0.5 | 0.2 | 0.4 | 0.5 | 0.2 | 0.1 |
| | Vd=20 V | usat Max [cm2/(V·s)] | 33.6 | 30 | 31.3 | 33.3 | 31.2 | 32.9 | 32.4 | 35.9 |
| | | $\triangle\mu$sat [cm2/(V·s)] | 1 | 1.1 | 1.2 | 0.9 | 1.3 | 1.8 | 1.6 | 0.6 |
| | | S value [V/decade] | 0.6 | 0.6 | 0.4 | 0.5 | 0.5 | 0.6 | 0.6 | 0.5 |
| | | Vth [V] | -0.3 | 1.4 | 1.0 | 0.9 | -0.1 | -0.4 | -0.9 | -1.0 |
| | | $\triangle$Vth | 0.6 | 0.2 | 0.6 | 0.6 | 0.6 | 0.3 | 0.1 | 0.4 |
| | Presence or absence of DIBL phenomenon | | Absent | Absent | Absent | Absent | Absent | Absent | Absent | Absent |

Table 51

| | | | Example 181 | Example 182 | Example 183 | Example 184 | Example 185 | Example 188 | Example 187 | Example 188 |
|---|---|---|---|---|---|---|---|---|---|---|
| Sputtering target | Loaded composition ratio [mass%] | In$_2$O$_3$ [mass%] | 89.8 | 95.8 | 88.8 | 95.4 | 88.5 | 95.4 | 88.7 | 95.5 |
| | | ZnO [mass%] | 44 | 1.8 | 43 | 1.8 | 43 | 1.8 | 43 | 1.8 |
| | | X2O3 [mass%] | 6.1 | 2.4 | 7.0 | 2.8 | 7.2 | 2.9 | 7.0 | 2.8 |
| | | Kind of X2O3 | Pr2O3 | Pr2O3 | Tm2O3 | Tm2O3 | Yb2O3 | Yb2O3 | Er2O3 | Er2O3 |
| | Metal composition ratio [at%] | In [at %] | 87.7 | 95.0 | 87.7 | 95.0 | 87.7 | 95.0 | 87.7 | 95.0 |
| | | Zn [at %] | 7.3 | 30 | 7.3 | 3.0 | 7.3 | 30 | 7.3 | 30 |
| | | X [at %] | 5.0 | 2.0 | 5.0 | 2.0 | 5.0 | 2.0 | 5.0 | 2.0 |
| | | X element | Pr | Pr | Tm | Tm | Yb | Yb | Er | Er |
| TFT production conditions | Film formation of channel layer | Pressure at time of film formation [Pa1 | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

|  |  |  | Example 181 | Example 182 | Example 183 | Example 184 | Example 185 | Example 188 | Example 187 | Example 188 |
|---|---|---|---|---|---|---|---|---|---|---|
| Evaluation of channel layer | Cross-sectional TEM image | Average grain boundary angle θ [°] | 89.7 | 76.6 | 88.8 | 80.8 | 79.3 | 78.9 | 93.8 | 84.8 |
|  |  | Average grain boundary angle θ sub [°] | 89.7 | 76.6 | 88.8 | 80.8 | 79.3 | 78.9 | 93.6 | 84.8 |
|  |  | Average spacing D between crystal grain boundaries [μm] | 0.5 | 0.7 | 1.5 | 1.5 | 1 | 0.9 | 0.9 | 0.3 |
|  |  | Crystal state | Columnar crystal | Columnar crystal | Columnar crystal | Columnar crystal | Columnar crystal | Columnar crystal | Columnar crystal | Columnar crystal |
|  | SSRM· Spread resistance value evaluation | Low-resistance region A $R_A$ [Ω] | 1.4E+05 | 2.7E+04 | 4.4E+04 | 8.4E+04 | 3.9E+04 | 4.BE+04 | 2.5E+04 | 1.3E+05 |
|  |  | High-resistance region B $R_B$ [Ω] | 6.0E+06 | 7.3E+05 | 8.8E+05 | 3.2E+06 | 1.9E+06 | 1.9E+06 | 7.8E+05 | 1.9E+06 |
|  |  | $R_B/R_A$ | 44 | 27 | 20 | 38 | 49 | 39 | 31 | 15 |
|  |  | Rs(L) | 6.0E+06 | 7.3E+05 | 8.8E+05 | 3.2E+08 | 1.9E+06 | 1.9E+06 | 7.8E+05 | 1.9E+06 |
|  |  | Rs($L_{off}$) | 2.0E+05 | 4.1E+04 | 6.7E+04 | 1.3E+05 | 5.8E+04 | 7.3E+04 | 3.8E+04 | 1.9E+05 |
|  |  | Rs(Ls) | 1.4E+05 | 2.7E+04 | 4.4E+04 | 8.4E+04 | 3.9E+04 | 4.8E+04 | 2.5E+04 | 1.3E+05 |
|  |  | Rs(L)/Rs($L_{off}$) | 29 | 18 | 13 | 25 | 33 | 26 | 21 | 10 |
|  |  | Rs(L)Rs(Ls) | 44 | 27 | 20 | 38 | 49 | 39 | 31 | 15 |
|  |  | ΔL [μm] | -0.8 | -0.7 | -0.1 | -0.3 | 0.1 | -0.5 | -0.3 | -0.4 |
|  | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
|  | Electron beam diffraction | Crystal structure | Bixbyite | Bixbyite | Bixbyite | Bixbyite | Bixbyite | Bixbyite | Bixbyite | Bixbyite |

EP 4 418 330 A1

144

| | | | Example 181 | Example 182 | Example 183 | Example 184 | Example 185 | Example 188 | Example 187 | Example 188 |
|---|---|---|---|---|---|---|---|---|---|---|
| Performance of TFT | Vd=0.1 V | ulin Max [cm2/(V·s)] | 35.6 | 39.3 | 35.6 | 40.4 | 32.3 | 35.5 | 37.9 | 39.1 |
| | | $\Delta\mu$lin [cm2/(V·s)] | 1.6 | 1.3 | 1.5 | 1.3 | 1.3 | 14 | 14 | 1.2 |
| | | S value [V/decade] | 0.5 | 0.5 | 0.4 | 0.5 | 0.5 | 0.5 | 0.5 | 0.4 |
| | | Vth [V] | -0.4 | -0.8 | -0.7 | -0.9 | 0.1 | 1.1 | 0.5 | 1 |
| | | $\triangle$Vth | 0.5 | 0.1 | 0.6 | 0.6 | 0.1 | 0.4 | 0.6 | 0.3 |
| | Vd=20 V | usat Max [cm2/(V·s)] | 32.8 | 385 | 32.7 | 37.5 | 29.4 | 32.8 | 34.9 | 382 |
| | | $\Delta\mu$sat [cm2/(V·s)] | 1.7 | 1.6 | 0.8 | 0.6 | 0.7 | 0.7 | 1.4 | 1.7 |
| | | S value [V/decade] | 0.6 | 0.4 | 0.5 | 0.4 | 0.4 | 0.8 | 0.4 | 0.5 |
| | | Vth [V] | -0.4 | -0.8 | -0.7 | -0.9 | 0.2 | 1.2 | 0.6 | 1.1 |
| | | $\triangle$ Vth | 0.4 | 0.1 | 0.1 | 0.5 | 0.1 | 0.2 | 0.5 | 0.4 |
| | Presence or absence of DIBL phenomenon | | Absent | Absent | Absent | Absent | Absent | Absent | Absent | Absent |

Table 52

| | | | Example 189 | Example 190 | Example 191 | Example 192 | Example 193 | Example 194 |
|---|---|---|---|---|---|---|---|---|
| Sputtering target | Loaded composition ratio [mass%] | In$_2$O$_3$ [mass %] | 88.5 | 95.4 | 91.3 | 96.6 | 93.8 | 95.8 |
| | | ZnO [mass %] | 4.3 | 1.8 | 4.5 | 1.8 | 5.1 | 3.9 |
| | | X2O3 [mass %] | 7.2 | 2.9 | 42 | 1.7 | 1.1 | 0.3 |
| | | Kind of X2O3 | Lu2O3 | Lu2O3 | Y2O3 | Y2O3 | B2O3 | B2O3 |
| | Metal composition ratio [at%] | In [at %] | 87.7 | 95.0 | 87.7 | 95.0 | 87.7 | 92.5 |
| | | Zn [at %] | 7.3 | 3.0 | 7.3 | 3.0 | 8.1 | 6.5 |
| | | X [at %] | 5.0 | 2.0 | 5.0 | 2.0 | 4.1 | 1.0 |
| | | X element | Lu | Lu | Y | Y | B | B |
| TFT production conditions | Film formation of channel layer | Pressure attime offilm formation [Pa] | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 |
| | | Water partial pressure attime offilm formation [Pa] | 0.00 | 0.01 | 0.00 | 0.01 | 0.00 | 0.01 |
| | | Magnetic flux density [G] | 600 | 600 | 600 | 600 | 600 | 600 |
| | | Thickness [nm] | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 |

(continued)

| | | | Example 189 | Example 190 | Example 191 | Example 192 | Example 193 | Example 194 |
|---|---|---|---|---|---|---|---|---|
| Evaluation of channel layer | Cross-sectional TEM image | Average grain boundary angle θ [°] | 74.1 | 92.6 | 73.4 | 103.3 | 77.4 | 98.3 |
| | | Average grain boundary angle θ sub [°] | 74.1 | 92.6 | 73.4 | 103.3 | 77.4 | 98.3 |
| | | Average spacing D between crystal grain boundaries [μm] | 0.5 | 0.3 | 0.1 | 0.4 | 1.5 | 0.4 |
| | | Crystal state | Columnar crystal | Columnar crystal | Columnar crystal | Columnar crystal | Columnar crystal | Columnar crystal |
| | SSRM· Spread resistance value evaluation | Low-resistance region A $R_A$ [Ω] | 1.2E+05 | 3.0E+04 | 1.1E+05 | 7.6E+04 | 1.2E+05 | 9.8E+04 |
| | | High-resistance region B $R_B$ [Ω] | 5.1E+06 | 1.2E+06 | 1.8E+06 | 3.6E+06 | 1.8E+06 | 4.0E+06 |
| | | $R_B/R_A$ | 42 | 39 | 16 | 48 | 16 | 41 |
| | | Rs(L) | 5.1E+06 | 1.2E+06 | 1.8E+06 | 3.6E+06 | 1.8E+06 | 4.0E+06 |
| | | Rs($L_{off}$) | 1.8E+05 | 4.5E+04 | 1.7E+05 | 1.1E+05 | 1.7E+05 | 1.5E+05 |
| | | Rs(Ls) | 1.2E+05 | 3.0E+04 | 1.1E+05 | 7.6E+04 | 1.2E+05 | 9.8E+04 |
| | | Rs(L)/Rs($L_{off}$) | 28 | 26 | 10 | 32 | 10 | 27 |
| | | Rs(L)/Rs(Ls) | 42 | 39 | 16 | 48 | 16 | 41 |
| | | ΔL [μm] | -0.4 | 0.2 | -0.3 | 0.2 | -0.7 | 0.2 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite |

147

| | | | Example 189 | Example 190 | Example 191 | Example 192 | Example 193 | Example 194 |
|---|---|---|---|---|---|---|---|---|
| Performance of TFT | Vd=0.1 V | ulin Max [cm2/(V·s)] | 40.2 | 34.8 | 40.3 | 36.4 | 39.8 | 32.5 |
| | | $\triangle\mu$lin [cm2/(V·s)] | 1.5 | 1.4 | 1.4 | 1.2 | 1.4 | 1.2 |
| | | S value [V/decade] | 0.4 | 0.4 | 0.4 | 0.4 | 0.4 | 0.5 |
| | | Vth [V] | 0.6 | 1.4 | -0.9 | 0.4 | 1 | 0.2 |
| | | $\triangle$Vth | 0.4 | 0.2 | 0.6 | 0.2 | 0.4 | 0.3 |
| | Vd=20 V | usat Max [cm2/(V·s)] | 37.2 | 32 | 37.5 | 33.5 | 37 | 29.5 |
| | | $\triangle\mu$sat [cm2/(V·s)] | 1.1 | 0.5 | 1 | 1.4 | 1.7 | 1.7 |
| | | S value [V/decade] | 0.6 | 0.5 | 0.4 | 0.4 | 0.5 | 0.5 |
| | | Vth [V] | 0.7 | 1.5 | -0.9 | 0.5 | 1.1 | 0.3 |
| | | $\triangle$Vth | 0.4 | 0.4 | 0.6 | 0.5 | 0.4 | 0.6 |
| | Presence or absence of DIBL phenomenon | | Absent | Absent | Absent | Absent | Absent | Absent |

Table 53

| | | | Example 195 | Example 196 | E>ample 197 | Example 198 | Example 199 | Example 200 |
|---|---|---|---|---|---|---|---|---|
| Sputtering target | Loaded composition ratio [mass%] | In$_2$O$_3$ [mass%] | 92.8 | 95.5 | 93.3 | 95.7 | 89.3 | 95.7 |
| | | ZnO [mass%] | 5.0 | 3.9 | 5.1 | 3.9 | 4.4 | 1.8 |
| | | X2O3 [mass%] | 2.2 | 0.5 | 1.6 | 0.4 | 6.4 | 2.5 |
| | | Kind of X2O3 | Sc2O3 | Sc2O3 | Al2O3 | Al2O3 | Sm2O3 | Sm2O3 |
| | Metal composition ratio [at%] | In [at %] | 87.7 | 92.5 | 87.7 | 92.5 | 87.7 | 95.0 |
| | | Zn [at %] | 8.1 | 6.5 | 8.1 | 6.5 | 7.3 | 3.0 |
| | | X [at %] | 4.1 | 1.0 | 4.1 | 1.0 | 5.0 | 2.0 |
| | | X element | Sc | Sc | Al | Al | Sm | Sm |
| TFT production conditions | Film formation of channel layer | Pressure at time of film formation [Pa] | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 |
| | | Magnetic flux density [G] | 600 | 600 | 600 | 600 | 600 | 600 |
| | | Thickness [nm] | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 |

| | | | Example 195 | Example 196 | E>ample 197 | Example 198 | Example 199 | Example 200 |
|---|---|---|---|---|---|---|---|---|
| Evaluation of channel layer | Cross-sectional TEM image | Average grain boundary angle [θ [°] | 101.5 | 962 | 93.1 | 99.8 | 89.3 | 86 |
| | | Average grain boundary angle θsub [°] | 101.5 | 96.2 | 93.1 | 99.8 | 89.3 | 86 |
| | | Average spacing D between crystal grain boundaries [μm] | 1 | 1.9 | 0.3 | 17 | 1.7 | 1 |
| | | Crystal state | Columnar crystal | Columnar crystal | Columnar crystal | Columnar crystal | Columnar crystal | Columnar crystal |
| | SSRM· Spread resistance value evaluation | Low-resistance region A $R_A$ [Ω] | 1.4E+05 | 4.6E+04 | 5.8E+04 | 5.7E+04 | 1.9E+04 | 2.2E+04 |
| | | High-resistance region B $R_B$ [Ω] | 6.1E+06 | 1.4E+06 | 1.0E+06 | 1.1E+06 | 6.1E+05 | 6.1E+05 |
| | | $R_B/R_A$ | 44 | 30 | 17 | 20 | 33 | 28 |
| | | Rs(L) | 6.1E+06 | 1.4E+06 | 1.0E+06 | 1.1E+06 | 6.1E+05 | 6.1E+05 |
| | | Rs($L_{off}$) | 2.1E+05 | 6.9E+04 | 8.8E+04 | 8.6E+04 | 2.8E+04 | 3.3E+04 |
| | | Rs(Ls) | 1.4E+05 | 4.6E+04 | 5.8E+04 | 5.7E+04 | 1.9E+04 | 2.2E+04 |
| | | Rs(L)/Rs($L_{off}$) | 29 | 20 | 11 | 13 | 22 | 19 |
| | | Rs(L)Rs(Ls) | 44 | 30 | 17 | 20 | 33 | 28 |
| | | ΔL [μm] | -0.7 | -0.8 | -0.5 | 0.1 | 0.1 | -0.2 |
| | SCM dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite |

EP 4 418 330 A1

| | | | Example 195 | Example 196 | E>ample 197 | Example 198 | Example 199 | Example 200 |
|---|---|---|---|---|---|---|---|---|
| Performance ofTFT | Vd=0.1 V | ulin Max [cm2/(V·s)] | 32.5 | 37 | 37.5 | 3n.2 | 39.5 | 33 |
| | | $\Delta\mu$lin [cm2/(V·s)] | 1.2 | 1.1 | 1.2 | 1.5 | 1.4 | 1.3 |
| | | S value [V/decade] | 0.5 | 0.5 | 0.5 | 0.4 | 0.5 | 0.4 |
| | | Vth [V] | 0.8 | -0.3 | -0.9 | -0.7 | 1.2 | 1.5 |
| | | $\Delta$Vth | 0.3 | 0.4 | 0.6 | n.4 | 0.3 | 0.1 |
| | Vd=20 V | usat Max [cm2/(V·s)] | 29.5 | 34.2 | 34.6 | 35.4 | 36.5 | 30.1 |
| | | $\Delta\mu$sat [cm2/(V·s)] | 1 | 1.8 | 0.5 | 1.3 | 1.5 | 0.9 |
| | | value [V/decade] | 0.4 | 0.5 | 0.6 | 0.5 | 0.4 | 0.5 |
| | | S Vth [V] | 0.9 | -0.3 | -0.9 | -0.7 | 1.3 | 1.6 |
| | | $\Delta$Vth | 0.4 | 0.5 | 0.4 | 0.3 | 0.1 | 0.4 |
| | Presence or absence of DIBL phenomenon | | Absent | Absent | Absent | Absent | Absent | Absent |

Table 54

| | | | Example 201 | Example 202 | Example 203 | Example 204 | Example 205 | Example 208 | Example 207 | Example 208 |
|---|---|---|---|---|---|---|---|---|---|---|
| Sputtering target | Loaded composition ratio [mass%] | $In_2O_3$ [mass%] | 93.8 | 95.8 | 93.0 | 95.8 | 91.8 | 95.3 | 925 | 955 |
| | | ZnO [mass%] | 5.1 | 3.9 | 5.1 | 3.9 | 5.0 | 3.9 | 5.0 | 3.9 |
| | | XO [mass %] | 1.3 | 0.3 | 1.9 | 0.4 | 3.3 | 0.8 | 2.5 | 0.8 |
| | | Kind of XO | MoO | MoO | SiO2 | SiO2 | GeO2 | GeO2 | TiO2 | TiO2 |
| | Metal composition ratio [at%] | In [at %] | 87.7 | 92.5 | 87.7 | 92.5 | 87.7 | 92.5 | 87.7 | 92.5 |
| | | Zn [at %] | 8.1 | 8.5 | 8.1 | 8.5 | 8.1 | 8.5 | 8.1 | 6.5 |
| | | X fat %] | 41 | 10 | 4.1 | 10 | 41 | 10 | 4.1 | 1.0 |
| | | X element | Mn | Mn | Si | Si | Ge | Ge | Ti | Ti |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 800 | 800 | 800 | 800 | 800 | 800 | 800 | 800 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

| | | | Example 201 | Example 202 | Example 203 | Example 204 | Example 205 | Example 208 | Example 207 | Example 208 |
|---|---|---|---|---|---|---|---|---|---|---|
| Evaluation of channel layer | Cross-sectional TEM image | Average grain boundary angle θ [°] | 71.8 | 102.8 | 75.4 | 71.1 | 89 | 94.5 | 78.4 | 85.8 |
| | | Average grain boundary angle θ sub [°] | 71.8 | 102.8 | 75.4 | 71.1 | 89 | 94.5 | 78.4 | 85.8 |
| | | Average spacing D between crystal nrain boundaries [μm] | 1.1 | 0.9 | 1.5 | 0.8 | 0.2 | 0.1 | 0.5 | 0.8 |
| | | Crystal state | Columnar crystal | Columnar crystal | Columnar crystal | Columnar crystal | Columnar crystal | Columnar crystal | Columnar crystal | Columnar crystal |
| | SSRM· Spread resistance value evaluation | Low-resistance region A $R_A$ [Ω] | 3.7E+04 | 7.9E+04 | 7.6E+04 | 4.1E+04 | 4.8E+04 | 4.7E+04 | 1.1E+05 | 9.4E+04 |
| | | High-resistance region B $R_B$ [Ω] | 1.2E+06 | 3.3E+06 | 1.2E+06 | 1.9E+06 | 9.3E+05 | 1.6E+06 | 5.1E+08 | 2.1E+08 |
| | | $R_B/R_A$ | 32 | 41 | 18 | 48 | 20 | 34 | 45 | 23 |
| | | $R_S(L)$ | 1.2E+06 | 3.3E+08 | 1.2E+06 | 1.9E+06 | 9.3E+05 | 1.6E+06 | 5.1E+08 | 2.1E+08 |
| | | $R_S(L_{off})$ | 5.5E+04 | 1.2E+05 | 1.1E+05 | 6.2E+04 | 7.1E+04 | 7.0E+04 | 1.7E+05 | 1.4E+05 |
| | | $R_S(Ls)$ | 3.7E+04 | 7.9E+04 | 7.6E+04 | 4.1E+04 | 4.8E+04 | 4.7E+04 | 1.1E+05 | 9.4E+04 |
| | | $R_S(L)R_S(Lo_{ff})$ | 22 | 27 | 10 | 31 | 13 | 22 | 30 | 15 |
| | | $R_S(L)/R_S(Ls)$ | 32 | 41 | 18 | 48 | 20 | 34 | 45 | 23 |
| | | ΔL [μm] | 0.0 | -0.8 | -0.5 | -0.4 | 0.1 | -0.5 | -0.8 | 0.1 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

EP 4 418 330 A1

| | | | Example 201 | Example 202 | Example 203 | Example 204 | Example 205 | Example 208 | Example 207 | Example 208 |
|---|---|---|---|---|---|---|---|---|---|---|
| Performance of TFT | Vd=0.1 V | ulin Max[cm2/(V·s)] | 32.3 | 402 | 33.7 | 40 | 342 | 33.8 | 38.1 | 37.8 |
| | | $\Delta\mu$lin [cm2/(V·s)] | 1.8 | 1.5 | 1.4 | 1.3 | 1.1 | 1.1 | 1.2 | 1.3 |
| | | S value [V/decade] | 0.4 | 05 | 05 | 0.4 | 0.5 | 05 | 05 | 05 |
| | | Vth [V] | -0.8 | 1.5 | 0.8 | 0.9 | 1.4 | 1.5 | 1.1 | -0.7 |
| | | $\Delta$Vth | 0.8 | 0.1 | 0.5 | 0.5 | 0.2 | 0.4 | 0.4 | 0.2 |
| | Vd=20 V | Max [cm2/(V·s)] | 29.3 | 37.3 | 30.9 | 37.2 | 31 4 | 30.9 | 33.3 | 34.8 |
| | | $\mu$sat $\Delta\mu$set [cm2/(V·s)] | 0.7 | 1.5 | 1 | 0.8 | 0.9 | 1.5 | 0.7 | 1.2 |
| | | S value [V/decade] | 0.5 | 0.4 | 0.4 | 0.8 | 0.5 | 0.4 | 0.4 | 0.4 |
| | | Vth [V] | -0.8 | 1.8 | 0.9 | 1.0 | 15 | 1.8 | 1.2 | -0.7 |
| | | $\Delta$Vth | 0.8 | 0.8 | 0.5 | 0.8 | 0.2 | 0.3 | 0.4 | 0.8 |
| | Presence or absence ofDIBL phenomenon | | Absent | Absent | Absent | Absent | Absent | Absent | Absent | Absent |

Table 55

| | | | Example 209 | Example 210 | Example 211 | Example 212 | Example 213 | Example 214 | Example 215 | Example 216 |
|---|---|---|---|---|---|---|---|---|---|---|---|
| Sputtering target | Loaded composition ratio [mass%] | In$_2$O$_3$ [mass%] | 87.4 | 94.9 | 91.0 | 96.4 | 88.1 | 95.2 | 90.3 | 96.1 |
| | | ZnO [mass %] | 4.3 | 1.8 | 4.4 | 1.8 | 4.3 | 1.8 | 4.4 | 1.8 |
| | | XO [mass %] | 8.3 | 3.3 | 4.6 | 1.8 | 7.6 | 3.0 | 5.3 | 2.1 |
| | | Kind of XO | WO3 | WO3 | ZrO2 | ZrO2 | HfO2 | HfO2 | MoO3 | MoO3 |
| | Metal composition ratio [at%] | In [at %] | 87.7 | 95.0 | 87.7 | 95.0 | 87.7 | 95.0 | 87.7 | 95.0 |
| | | Zn [at %] | 7.3 | 3.0 | 7.3 | 3.0 | 7.3 | 3.0 | 7.3 | 3.0 |
| | | X [at %] | 5.0 | 2.0 | 5.0 | 2.0 | 5.0 | 2.0 | 5.0 | 2.0 |
| | | X element | W | W | Zr | Zr | Hf | Hf | Mo | Mo |
| TFT production conditions | Film formation of channel layer | Pressure at time of film formation [Pa] | 0.5 | 0.5 | 0.5 | 0.5 | 0.5 | 0.5 | 0.5 | 0.5 |
| | | Oxygen partial pressure at time of film formation [Pa] | 0.05 | 0.00 | 0.05 | 0.00 | 0.05 | 0.00 | 0.05 | 0.00 |
| | | Water partial pressure at time of film formation [Pa] | 0.00 | 0.01 | 0.00 | 0.01 | 0.00 | 0.01 | 0.00 | 0.01 |
| | | Magnetic flux density [G] | 600 | 600 | 600 | 600 | 600 | 600 | 600 | 600 |
| | | Thickness [nm] | 30 | 10 | 30 | 10 | 30 | 10 | 30 | 10 |
| | Other TFT production conditions | | Same as in Example 1 | Same as in Example 1 | Same as in Example 1 | Same as in Example 1 | Same as in Example 1 | Same as in Example 1 | Same as in Example 1 | Same as in Example 1 |

(continued)

| | | | Example 209 | Example 210 | Example 211 | Example 212 | Example 213 | Example 214 | Example 215 | Example 216 |
|---|---|---|---|---|---|---|---|---|---|---|
| Evaluation of channel layer | Cross-sectional TEM image | Average grain boundary angle θ [°] | 84 | 92.1 | 89.8 | 105.6 | 90.4 | 80 | 96.3 | 100.6 |
| | | Average grain boundary angle θ sub [°] | 84 | 92.1 | 89.8 | 105.6 | 90.4 | 80 | 96.3 | 100.6 |
| | | Average spacing D between crystal grain boundaries [μm] | 1.1 | 0.4 | 0.4 | 0.1 | 1.8 | 0.9 | 1.4 | 0.1 |
| | | Crystal state | Columnar crystal | Columnar crystal | Columnar crystal | Columnar crystal | Columnar crystal | Columnar crystal | Columnar crystal | Columnar crystal |
| | SSRM· Spread resistance value evaluation | Low-resistance region A $R_A$ [Ω] | 9.7E+04 | 8.9E-04 | 1.1E+05 | 8.2E+04 | 6.4E+04 | 7.6E+04 | 1.4E+05 | 5.9 E+04 |
| | | High-resistance region B $R_B$ [Ω] | 1.6E+06 | 3.9E+06 | 5.6E+06 | 4.0E+06 | 3.0E+06 | 2.8E+06 | 4.9E+06 | 1.1E+06 |
| | | $R_B/R_A$ | 17 | 43 | 50 | 48 | 46 | 37 | 36 | 18 |
| | | $R_S(L)$ | 1.6E+06 | 3.9 E+06 | 5.6E+06 | 4.0E+06 | 3.0E+06 | 2.8E+06 | 4.9E+06 | 1.1E+06 |
| | | $R_S(L_{off})$ | 1.4E+05 | 1.3E+05 | 1.7E+05 | 1.2E+05 | 9.6E+04 | 1.1E+05 | 2.0E+05 | 8.9 E+04 |
| | | $R_S(Ls)$ | 9.7E+04 | 8.9 E+04 | 1.1E+05 | 8.2E+04 | 6.4E+04 | 7.6E+04 | 1.4E+05 | 5.9 E+04 |
| | | $R_S(L)/R_S(L_{off})$ | 11 | 29 | 33 | 32 | 31 | 25 | 24 | 12 |
| | | $R_S(L)/R_S(L_S)$ | 17 | 43 | 50 | 48 | 46 | 37 | 36 | 18 |
| | | ΔL [μm] | 0.1 | -0.6 | -0.3 | 0.1 | -0.7 | -0.1 | -0.1 | 0.2 |
| | SCM· dC/dV evaluation | Magnitudes of boundary region (A-B) and region (B) | (A-B)>(B) | (A-B)>(B) | (A-B)>(B) | (A-B)>(B) | (A-B)>(B) | (A-B)>(B) | (A-B)>(B) | (A-B)>(B) |
| | Electron beam diffraction | Crystal structure | Bixbyite | Bixbyite | Bixbyite | Bixbyite | Bixbyite | Bixbyite | Bixbyite | Bixbyite |

(continued)

| | | | Example 209 | Example 210 | Example 211 | Example 212 | Example 213 | Example 214 | Example 215 | Example 216 |
|---|---|---|---|---|---|---|---|---|---|---|
| Performance of TFT | Vd=0.1 V | μlin Max [cm2/(V·s)] | 35.3 | 32.8 | 39.2 | 35 | 34 | 33.9 | 32.7 | 34.9 |
| | | Δμlin [cm2/(V·s)] | 1.3 | 1.4 | 1.4 | 1.6 | 1.4 | 1.3 | 1.4 | 1.2 |
| | | S value [V/decade] | 0.4 | 0.4 | 0.4 | 0.4 | 0.4 | 0.4 | 0.4 | 0.5 |
| | | Vth [V] | -0.8 | -0.7 | 1.4 | 0.2 | 0.4 | 0.3 | -0.1 | 1.4 |
| | | ΔVth | 0.2 | 0.1 | 0.2 | 0.3 | 0.6 | 0.2 | 0.5 | 0.2 |
| | Vd=20 V | μsat Max [cm2/(V·s)] | 32.4 | 30.0 | 36.2 | 32.0 | 31.2 | 30.9 | 29.9 | 32.0 |
| | | Δμsat [cm2/(V·s)] | 1.5 | 1.1 | 1 | 0.8 | 0.5 | 0.7 | 1.6 | 1.7 |
| | | S value [V/decade] | 0.4 | 0.6 | 0.5 | 0.6 | 0.4 | 0.4 | 0.6 | 0.6 |
| | | Vth [V] | -0.8 | -0.7 | 1.5 | 0.3 | 0.5 | 0.4 | -0.1 | 1.5 |
| | | ΔVth | 0.2 | 0.1 | 0.5 | 0.1 | 0.4 | 0.5 | 0.2 | 0.3 |
| Presence or absence of DIBL phenomenon | | | Absent | Absent | Absent | Absent | Absent | Absent | Absent | Absent |

Examples 217 and Comparative Example 20

(1) Formation of Oxide Thin Film

An oxide thin film having a thickness of 50 nm was formed on an alkali-free glass substrate (EAGLE r m XG manufactured by Corning Incorporated) having a diameter of 4 inches by sputtering through use of a sputtering target obtained from a raw material mixture having a loaded composition ratio shown in Table 56.
The metal composition ratio (unit: at%) of the sputtering target and sputtering conditions are shown in Table 56. X shown in Table 56 represents a metal element except In and Ga. Sputtering conditions that are not shown in Table 56 are as described below.

Substrate temperature: 25°C
Ultimate pressure: $1.0\times10^{-4}$ Pa
Atmospheric gas: $O_2$
Sputtering pressure (total pressure): 0.5 Pa
Input voltage: DC 400 W
Distance between substrate (S) and target (T): 70 mm

(2) Annealing of Oxide Thin Film

The substrate having the oxide thin film formed thereon was placed in a furnace. The temperature inside the furnace was increased to 350°C at 10°C/min in the atmosphere, and was then held for 1 hour. After the temperature inside the furnace was held at 350°C for 1 hour, the furnace was allowed to cool naturally. After the temperature inside the furnace returned to room temperature, the substrate was removed from the furnace.

(3) Electron Beam Diffraction Measurement

An arbitrary region of the oxide thin film was cut out into a size of 1 cm square to provide a cross-section. A target position of the cross-section was evaluated in the same manner as in the channel layer of the TFT. As a result, Example 217 was a bixbyite structure, and Comparative Example 41 was amorphous.

(4) Cathodoluminescence Spectroscopy (CL) Measurement

CL measurement was performed with the following measurement device under the following measurement conditions.

[Measurement Device]

·Device: Cathodoluminescence spectrometer
·Spectrometer: manufactured by Horiba, Ltd.
·SEM: Schottky Emission SEM JSM-7100F/TTLS manufactured by JEOL Ltd.
·Spectrometer: iHR-320, diffraction lattice (100 gr/mm, blaze wavelength: 450 nm)
·Detector: CCD: Jobin Yvon

[Measurement Conditions]

·Temperature: room temperature
·Slit: 500 $\mu$m
·Acceleration voltage: 1 kV
·Applied current: 0.7 nA (1 kV)
·W.D.: 10.3 mm
·Spectrum accumulation time: 60 s to 180 s

The intensity of each of the resultant spectra was converted to the number of counts per unit second. The results of the CL spectra of the oxide thin films obtained in Example 217 and Comparative Example 20 are each shown in Fig. 10.

Further, in each of the spectra, ratios I (640 nm)/I (380 nm) of an emission intensity I (640 nm) at 640 nm derived from crystal defects such as oxygen defects to an emission intensity I (380 nm) at a light emission of 380 nm caused by interband transition light emission were calculated and compared to each other. Thus, the amounts of defects in the oxide thin films were compared to each other.

The results are shown in Table 52.

Example 217 crystallized into a bixbyite structure had film quality with smaller light emission and fewer defects as compared to Comparative Example 20 that was amorphous.

Table 56

| | | | Example 217 | Comparative Example 20 |
|---|---|---|---|---|
| Composition ratio of film | Metal composition ratio [at%] | [In] / ([In]+[Ga]+[X]) | > 75 | 33.0 |
| Production conditions | Production of oxide thin film | Pressure at time of film formation [Pa] | 0.5 | 0.5 |
| | | Oxygen partial pressure at time of film formation [Pa] | 0.05 | 0.05 |
| | | Water partial pressure at time of film formation [Pa] | 0.00 | 0.00 |
| | | Magnetic flux density [G] | 1,000 | 1,000 |
| | | Thickness [nm] | 50 | 50 |
| | Annealing | Temperature increase pattern [°C/min] | 10 | 10 |
| | | Highest temperature [°C] | 350 | 350 |
| | | Retention time [h] | 1 | 1 |
| | | Atmosphere | Atmospheric | Atmospheric |
| Evaluation results | Crystal phase analysis by electron beam diffraction | | Bixbyite | Amorphous |
| | CL evaluation results | CL spectrum | Fig. 10 | |
| | | I (640 nm) / I (380 nm) | 7.5 | 22.9 |

Industrial Applicability

The crystalline oxide thin film of the present invention can be suitably used as a constituent member of a thin film transistor, for example, a channel layer. In addition, the thin film transistor of the present invention can be used in an electric circuit to be used in an electric device, an electronic device, a vehicle, or a power engine.

Although only some exemplary embodiments and/or examples of this invention have been described in detail above, those skilled in the art will readily appreciate that many modifications are possible in the exemplary embodiments and/or examples without materially departing from the novel teachings and advantages of this invention. Accordingly, all such modifications are intended to be included within the scope of this invention.

The documents described in the specification and the specification of Japanese application(s) on the basis of which the present application claims Paris convention priority are incorporated herein by reference in its entirety.

**Claims**

1. A crystalline oxide thin film, comprising In as a main component,

   wherein the crystalline oxide thin film comprises a low-resistance region A and a high-resistance region B that have different spread resistance values measured with a scanning spread resistance microscope (SSRM) in a plane direction thereof, and
   the spread resistance value of the high-resistance region B is 8 times or more as large as the spread resistance value of the low-resistance region A.

2. The crystalline oxide thin film according to claim 1, wherein the spread resistance value of the high-resistance region B is 10 times or more as large as the spread resistance value of the low-resistance region A.

3. The crystalline oxide thin film according to claim 1, wherein the spread resistance value of the high-resistance region B is 15 times or more as large as the spread resistance value of the low-resistance region A.

4. The crystalline oxide thin film according to any one of claims 1 to 3, wherein the crystalline oxide thin film has a thickness of 80 nm or less.

5. The crystalline oxide thin film according to any one of claims 1 to 4, wherein in a dC/dV value measured with a scanning capacitance microscope (SCM), a dC/dV value at a boundary between the low-resistance region A and the high-resistance region B is larger than a dC/dV value in the high-resistance region B.

6. The crystalline oxide thin film according to any one of claims 1 to 5, wherein the crystalline oxide thin film has an average grain boundary angle $\theta$ formed by a lower surface of the thin film and a crystal grain boundary in the thin film of 70° or more and 110° or less, and
an average spacing D between the crystal grain boundaries is 0.01 $\mu$m or more and 2.0 $\mu$m or less.

7. The crystalline oxide thin film according to any one of claims 1 to 6, wherein the crystalline oxide thin film comprises a crystal grain having a bixbyite structure in electron beam diffraction thereof.

8. The crystalline oxide thin film according to any one of claims 1 to 7, wherein the crystalline oxide thin film further comprises one or more elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb and Bi.

9. A laminate, comprising the crystalline oxide thin film according to any one of claims 1 to 8.

10. The laminate according to claim 9, wherein an average grain boundary angle $\theta_{sub}$ formed by a plane on which the crystalline oxide thin film and a lower layer are in contact with each other, and a crystal grain boundary in the crystalline oxide thin film is 70° or more and 110° or less.

11. The laminate according to claim 9 or 10, wherein the lower layer is a substrate of a thin film transistor or a constituent layer of the thin film transistor.

12. A thin film transistor, comprising the crystalline oxide thin film according to any one of claims 1 to 8 or the laminate according to any one of claims 9 to 11.

13. The thin film transistor according to claim 12, wherein the thin film transistor comprises

a channel layer,
a source electrode and a drain electrode that are each connected to both end sides of the channel layer, and
a gate electrode laminated on the channel layer via a gate insulating film,
wherein the channel layer is the crystalline oxide thin film, the gate insulating film is formed on the high-resistance region B, and the source electrode and the drain electrode are formed on the low-resistance region A,
a distance $L_{off}$ from an end portion of the source electrode and an end portion of the drain electrode to an intersection between a perpendicular line drawn from an end portion of the gate electrode in a thickness direction and the crystalline oxide thin film is 4 $\mu$m or more and 20 $\mu$m or less, and
an average spacing D between crystal grain boundaries of the crystalline oxide thin film and the distance $L_{off}$ satisfy the following formula (1).

$$2 \leq L_{off}/D \leq 100 \cdots (1)$$

14. The thin film transistor according to claim 12 or 13, wherein a contact region length Ls of the channel layer with respect to the source electrode and the drain electrode is 4 $\mu$m or more and 20 $\mu$m or less, and
an average spacing D between crystal grain boundaries of the crystalline oxide thin film and the contact region length Ls satisfy the following formula (2).

$$1 \leq Ls/D \leq 100 \cdots (2)$$

15. The thin film transistor according to any one of claims 12 to 14, wherein a gap $\Delta L$ in a horizontal direction between the low-resistance region A and the gate electrode is less than 1 $\mu$m.

16. A crystalline oxide thin film, comprising In as a main component,

wherein the crystalline oxide thin film has a thickness of 80 nm or less,
the crystalline oxide thin film comprises a high-carrier concentration region A and a low-carrier concentration region B that have different carrier concentrations in a plane direction thereof,
the carrier concentration of the high-carrier concentration region A is $10^{19}$ cm$^{-3}$ or more and $10^{22}$ cm$^{-3}$ or less, and
the carrier concentration of the high-carrier concentration region A is 8 times or more as high as the carrier concentration of the low-carrier concentration region B.

17. The crystalline oxide thin film according to claim 16, wherein the carrier concentration of the high-carrier concentration region A is 10 times or more as high as the carrier concentration of the low-carrier concentration region B.

18. The crystalline oxide thin film according to claim 16, wherein the carrier concentration of the high-carrier concentration region A is 15 times or more as high as the carrier concentration of the low-carrier concentration region B.

19. The crystalline oxide thin film according to any one of claims 16 to 18, wherein the carrier concentration of the low-carrier concentration region B is $10^{15}$ cm$^{-3}$ or more and less than $10^{19}$ cm$^{-3}$.

20. The crystalline oxide thin film according to any one of claims 16 to 19, wherein the crystalline oxide thin film has an average grain boundary angle $\theta$ formed by a lower surface of the thin film and a crystal grain boundary in the thin film of 70° or more and 110° or less, and
an average spacing D between the crystal grain boundaries is 0.01 $\mu$m or more and 2.0 $\mu$m or less.

21. The crystalline oxide thin film according to any one of claims 16 to 20, wherein the crystalline oxide thin film comprises a crystal grain having a bixbyite structure in electron beam diffraction thereof.

22. The crystalline oxide thin film according to any one of claims 16 to 21, wherein the crystalline oxide thin film further comprises one or more elements selected from the group consisting of H, B, C, N, O, F, Mg, Al, Si, O, S, Cl, Ar, Ca, Sc, Ti, V, Cr, Mn, Fe, Co, Ni, Cu, Zn, Ga, Ge, Y, Zr, Nb, Mo, Tc, Ru, Rh, Pd, Ag, Cd, Sn, Sb, Cs, Ba, Ln, Hf, Ta, W, Re, Os, Ir, Pt, Au, Pb and Bi.

23. A laminate, comprising the crystalline oxide thin film according to any one of claims 16 to 22.

24. The laminate according to claim 23, wherein an average grain boundary angle $\theta_{sub}$ formed by a plane on which the crystalline oxide thin film and a lower layer are in contact with each other, and the crystal grain boundary in the crystalline oxide thin film is 70° or more and 110° or less.

25. The laminate according to claim 23 or 24, wherein the lower layer is a substrate of a thin film transistor or a constituent layer of the thin film transistor.

26. A thin film transistor, comprising the crystalline oxide thin film according to any one of claims 16 to 22 or the laminate according to claims 23 to 25.

27. The thin film transistor according to claim 26, wherein the thin film transistor comprises

a channel layer,
a source electrode and a drain electrode that are each connected to both end sides of the channel layer, and
a gate electrode laminated on the channel layer via a gate insulating film,
the channel layer is the crystalline oxide thin film, the gate insulating film is formed on the low-carrier concentration region B, and the source electrode and the drain electrode are formed on the high-carrier concentration region A,
a distance $L_{off}$ from an end portion of the source electrode and an end portion of the drain electrode to an intersection between a perpendicular line drawn from an end portion of the gate electrode in a thickness direction and the crystalline oxide thin film is 4 $\mu$m or more and 20 $\mu$m or less, and
an average spacing D between crystal grain boundaries of the crystalline oxide thin film and the distance $L_{off}$ satisfy the following formula (1).

$$2 \leq L_{off}/D \leq 100 \cdots (1)$$

28. The thin film transistor according to claim 26 or 27, wherein a contact region length Ls of the channel layer with respect to the source electrode and the drain electrode is 4 $\mu$m or more and 20 $\mu$m or less, and
an average spacing D between crystal grain boundaries of the crystalline oxide thin film and the contact region length Ls satisfy the following formula (2).

$$1 \leq Ls/D \leq 100 \cdots (2)$$

29. The thin film transistor according to any one of claims 26 to 28, wherein a gap $\Delta L$ in a horizontal direction between the high-carrier concentration region A and the gate electrode is less than 1 $\mu$m.

30. A crystalline oxide thin film, comprising In as a main component,

    wherein the crystalline oxide thin film has a thickness of 80 nm or less,
    an average spacing D between crystal grain boundaries of the crystalline oxide thin film is 2 $\mu$m or less, and
    the crystalline oxide thin film has a carrier concentration of $10^{19}$ cm$^{-3}$ or more and $10^{22}$ cm$^{-3}$ or less.

31. A thin film transistor, comprising the crystalline oxide thin film according to claim 30.

32. An electronic circuit, comprising the thin film transistor according to any one of claims 12 to 15, 26 to 29 and 31.

33. An electric device, an electronic device, a vehicle, or a power engine, comprising the electronic circuit according to claim 32.

Fig. 1

Fig. 2

Fig. 3A

Fig. 3B

Fig. 4

51

Fig. 5

Fig. 6

Fig. 7

Fig. 8A

Fig. 8B

Fig. 8C

Fig. 9

Fig. 10

## INTERNATIONAL SEARCH REPORT

| International application No. |
| --- |
| **PCT/JP2022/038036** |

**A. CLASSIFICATION OF SUBJECT MATTER**

*H01L 29/786*(2006.01)i; *G02F 1/1368*(2006.01)i; *H01L 21/28*(2006.01)i; *H01L 21/336*(2006.01)i; *H01L 21/363*(2006.01)i; *H01L 21/66*(2006.01)i; *H01L 29/417*(2006.01)i

FI: H01L29/78 618B; H01L21/28 301B; H01L29/50 M; H01L21/66 L; H01L29/78 618Z; H01L29/78 618F; G02F1/1368; H01L29/78 616J; H01L21/363

According to International Patent Classification (IPC) or to both national classification and IPC

**B. FIELDS SEARCHED**

Minimum documentation searched (classification system followed by classification symbols)

H01L29/786; G02F1/1368; H01L21/28; H01L21/336; H01L21/363; H01L21/66; H01L29/417

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | WO 2020/196716 A1 (IDEMITSU KOSAN CO., LTD.) 01 October 2020 (2020-10-01) paragraphs [0072]-[0073], [0083]-[0086], [0133], [0161], fig. 1, 3, 4 | 1-33 |
| Y | JP 2015-188063 A (SEMICONDUCTOR ENERGY LABORATORY CO., LTD.) 29 October 2015 (2015-10-29) paragraphs [0033], [0063], [0083], [0183]-[0190], fig. 2, 5(B) | 1-33 |
| Y | JP 2011-146694 A (SEMICONDUCTOR ENERGY LABORATORY CO., LTD.) 28 July 2011 (2011-07-28) paragraph [0044] | 8-15, 22-29 |
| Y | JP 2013-179141 A (SONY CORP) 09 September 2013 (2013-09-09) paragraphs [0047]-[0048] | 8-15, 22-29 |
| A | WO 2017/017966 A1 (IDEMITSU KOSAN CO., LTD.) 02 February 2017 (2017-02-02) | 1-33 |

☐ Further documents are listed in the continuation of Box C.　　☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **23 December 2022** | **10 January 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/038036**

| Patent document cited in search report | | | Publication date (day/month/year) | Patent family member(s) | | | Publication date (day/month/year) |
|---|---|---|---|---|---|---|---|
| WO | 2020/196716 | A1 | 01 October 2020 | US | 2022/0199784 | A1 | |
| | | | | paragraphs [0152]-[0159], [0175]-[0182], [0255], [0313], fig. 1, 3, 4 | | | |
| | | | | CN | 113614276 | A | |
| | | | | KR | 10-2021-0144707 | A | |
| | | | | TW | 202044539 | A | |
| JP | 2015-188063 | A | 29 October 2015 | US | 2015/0228803 | A1 | |
| | | | | paragraphs [0086], [0116], [0136], [0236]-[0243], fig. 2A, 2B, 5B | | | |
| | | | | KR | 10-2015-0093616 | A | |
| | | | | TW | 201533912 | A | |
| JP | 2011-146694 | A | 28 July 2011 | US | 2011/0147738 | A1 | |
| | | | | paragraph [0056] | | | |
| | | | | WO | 2011/074407 | A1 | |
| | | | | TW | 201138114 | A | |
| JP | 2013-179141 | A | 09 September 2013 | US | 2013/0221358 | A1 | |
| | | | | paragraphs [0107]-[0108] | | | |
| | | | | KR | 2013/0221358 | A | |
| | | | | CN | 103295909 | A | |
| | | | | TW | 201338173 | A | |
| WO | 2017/017966 | A1 | 02 February 2017 | US | 2018/0219098 | A1 | |
| | | | | CN | 107924822 | A | |
| | | | | KR | 2018/0219098 | A | |
| | | | | TW | 201714854 | A | |

Form PCT/ISA/210 (patent family annex) (January 2015)

**REFERENCES CITED IN THE DESCRIPTION**

**Patent documents cited in the description**

- JP 5373212 B
- JP 2018107316 A
- JP 6097458 B
- JP 6334598 B
- JP 6289693 B
- WO 2018043323 A1
- WO 2020196716 A1